(19) Europäisches Patentamt / European Patent Office / Office européen des brevets

(11) EP 4 783 807 A2

(12) **EUROPEAN PATENT APPLICATION**

(43) Date of publication:
**29.07.2026 Bulletin 2026/31**

(21) Application number: **26153764.1**

(22) Date of filing: **23.01.2026**

(51) International Patent Classification (IPC):
***H10K 71/70*** (2023.01) ***H10K 71/00*** (2023.01)
***H10K 50/16*** (2023.01) ***C09K 11/02*** (2006.01)
***H10K 50/18*** (2023.01) ***H10K 85/60*** (2023.01)
*H10K 50/115* (2023.01) *H10K 50/15* (2023.01)
*H10K 50/17* (2023.01)

(52) Cooperative Patent Classification (CPC):
**H10K 50/16; C09K 11/025; H10K 50/18; H10K 71/70; H10K 71/831; H10K 85/6572;**
H10K 50/115; H10K 50/156; H10K 50/17; H10K 2102/331

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **24.01.2025 KR 20250011951**

(71) Applicants:
- **Samsung Electronics Co., Ltd.**
  **Suwon-si, Gyeonggi-do 16677 (KR)**
- **Samsung Display Co., Ltd.**
  **Yongin-si, Gyeonggi-do 17113 (KR)**

(72) Inventors:
- **SEO, Hong Kyu**
  **16678 Suwon-si (KR)**
- **KIM, Enjung**
  **16678 Suwon-si (KR)**
- **KWON, Ha Il**
  **16678 Suwon-si (KR)**
- **MIN, Ji Hyun**
  **16678 Suwon-si (KR)**

(74) Representative: **Elkington and Fife LLP**
**Prospect House**
**8 Pembroke Road**
**Sevenoaks, Kent TN13 1XR (GB)**

(54) **ELECTROLUMINESCENT DEVICE, METHOD OF PRODUCING THE SAME, AND DISPLAY DEVICE INCLUDING THE SAME**

(57) An electroluminescent device, a method for manufacturing the device, and a display device. The electroluminescent device includes a first electrode and a second electrode, an emission layer that includes semiconductor nanoparticles disposed between the first electrode and the second electrode, and a hole auxiliary layer between the emission layer and the first electrode. The hole auxiliary layer includes a hole injection/transport material and a base quencher, and the base quencher includes an alkali metal hydroxide, an ammonium hydroxide compound, an amine compound, or a combination thereof.

FIG. 1A

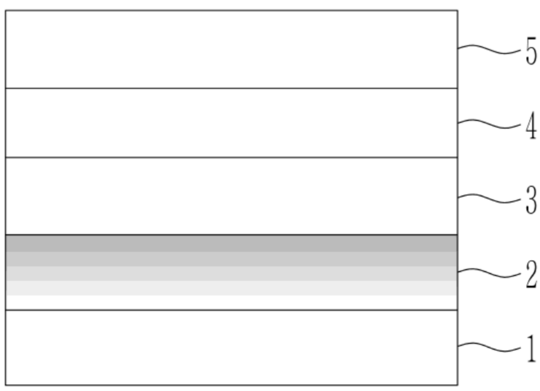


EP 4 783 807 A2

## Description

FIELD OF THE INVENTION

The present disclosure relates to a light emitting (e.g., electroluminescent) device and a display device including the electroluminescent) device.

BACKGROUND OF THE INVENTION

A semiconductor nanoparticle (e.g., a semiconductor nanocrystal particle) having a nanometer size may exhibit luminescence properties. For example, a quantum dot including a semiconductor nanocrystal may exhibit a quantum confinement effect. The light emission from the semiconductor nanoparticle may occur when an electron in an excited state resulting from light excitation or an applied voltage transitions from a conduction band to a valence band. The semiconductor nanoparticle may be configured to emit light of a desired wavelength region by adjusting a size of the semiconductor nanoparticle, a composition of the semiconductor nanoparticle, or a combination thereof.

A semiconductor nanoparticle may be used, for example, in a light emitting device (e.g., an electroluminescent device) or a display device including the electroluminescent device.

SUMMARY OF THE INVENTION

An embodiment provides a method of producing a light emitting device that emits light, for example, by applying a voltage to a nanostructure (e.g., a semiconductor nanoparticle such as a quantum dot), that is, a device with or without an irradiation light source component.

An embodiment provides a light emitting device.

An embodiment provides a display device (e.g., a quantum dot-light emitting diode (QD-LED) display device) that includes a plurality of semiconductor nanoparticles such as quantum dots as a component of a light emitting layer in a pixel configuration (e.g., in a configuration of a blue pixel, a red pixel, a green pixel, or a combination thereof).

In an embodiment, an electroluminescent device includes:

a first electrode (e.g., a hole-injecting conductor or an anode) and a second electrode;
an emission layer (also at times referred to as a light emitting layer) disposed between the first electrode and the second electrode, wherein the emission layer includes a semiconductor nanoparticle, and the emission layer is configured to emit a first light;
an electron transport layer disposed between the emission layer and the second electrode; and
a hole auxiliary layer disposed between the emission layer and the first electrode;
wherein the electron transport layer includes a metal oxide nanoparticle, and the metal oxide nanoparticle having a particle size of greater than or equal to about 1 nanometer (nm) and less than or equal to about 30 nm, and
the metal oxide nanoparticle includes zinc; and optionally a Group IIA metal (i.e., an alkaline earth metal), Zr, W, Li, Ti, Y, Al, Ga, In, Sn, Co, V, or a combination thereof, and
wherein the hole auxiliary layer includes a hole injection/transport material and a base quencher, wherein the base quencher includes an alkali metal hydroxide, an ammonium hydroxide compound, an amine compound, or a combination thereof (e.g., a mixture of two or more compound). The hole injection/transport material may be configured to inject or transport holes.

The semiconductor nanoparticles or the emission layer may not include cadmium, lead, mercury, or a combination thereof.

The hole auxiliary layer has a first surface facing the emission layer, and the base quencher may be present on at least a portion of the first surface.

In the hole auxiliary layer, a concentration of the base quencher may increase toward the first surface (i.e., the concentration of the base quencher in the first surface may be greater than in an opposite surface to the first surface). In the hole auxiliary layer, the concentration of the quencher may increase through the hole auxiliary layer and toward the first surface. The hole auxiliary layer may include a hole transport layer and a hole injection layer. The hole auxiliary layer may include a protective layer including the base quencher.

The hole transport layer may be disposed between the base quencher and the hole injection layer or disposed between the protective layer and the hole injection layer. The base quencher, or the protective layer, may be disposed between the hole transport layer and the hole injection layer. The base quencher or the protective layer may be disposed between the emission layer and the hole transport layer.

The alkali metal hydroxide may include lithium hydroxide, sodium hydroxide, potassium hydroxide, cesium

hydroxide, rubidium hydroxide, or a combination thereof (e.g., a mixture of two or more compounds).

The ammonium hydroxide compound may include a tetraalkylammonium hydroxide.

The amine compound may include a substituted or unsubstituted aliphatic primary amine compound, a substituted or unsubstituted aliphatic secondary amine compound, a substituted or unsubstituted aliphatic tertiary amine compound, a substituted or unsubstituted cyclic amine compound, or a combination thereof.

The aliphatic amine compound may include a substituted or unsubstituted aliphatic primary amine, a substituted or unsubstituted aliphatic secondary amine, a substituted or unsubstituted aliphatic tertiary amine, or a combination thereof.

The cyclic amine compound may include a piperidine compound, a pyrrolidone compound, a diazacycloalkene compound, or a combination thereof.

The hole injection/transport material may be a material that exhibits a current density of less than or equal to about 80% of a current density prior to a heat treatment in a test stacked cell structure, wherein the test stacked cell structure has a layer of the hole injection/transport material with a thickness of greater than or equal to about 120 nanometers and less than or equal to about 150 nanometers between a Ag-containing anode and a Ag-containing cathode, and wherein the heat treatment is conducted under the following conditions:
maintaining the test stacked cell structure in the presence of an aqueous solution of a polyacrylic acid having a weight average molecular weight of greater than or equal to about 100,000 g/mole and less than or equal to about 500,000 g/mole in a sealed space at 70 °C for 24 hours.

The current density may be less than or equal to about 50% of the current density prior to the heat treatment.

The hole injection/transport material may include a compound represented by Chemical formula 1, a polymer including a repeating unit represented by Chemical formula 2 in a main chain, a polymer including a repeating unit represented by Chemical formula 2a in a main chain, a polymer including a repeating unit represented by Chemical formula 3 in a main chain, a polyvinylcarbazole, or a combination thereof.

Chemical formula 1

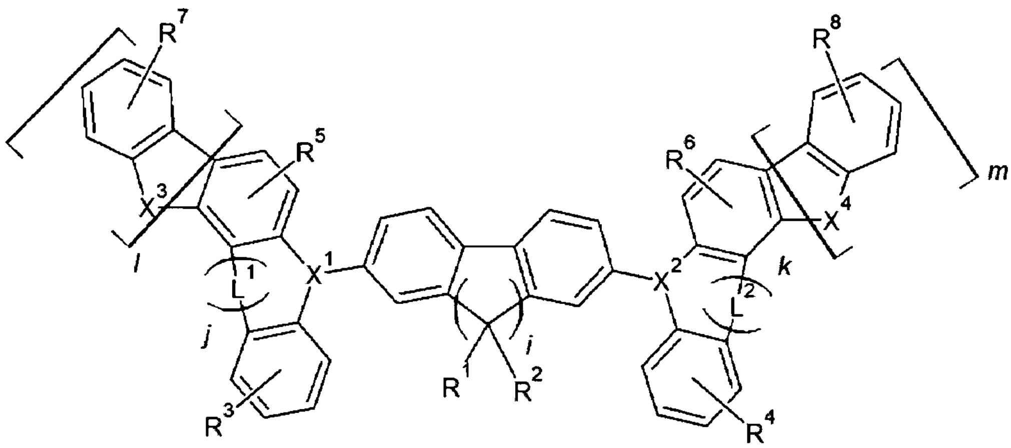

In Chemical formula 1, each $R^1$ to $R^8$ are independently hydrogen, a substituted or unsubstituted C1 to C40 alkyl group, a substituted or unsubstituted C2 to C40 alkenyl group, a substituted or unsubstituted C2 to C40 alkynyl group, a substituted or unsubstituted C3 to C20 cycloalkyl group, a substituted or unsubstituted C6 to C20 aryl group, a substituted or unsubstituted C3 to C20 heteroaryl group, a substituted or unsubstituted alkylamine group, a substituted or unsubstituted arylamine group, a substituted or unsubstituted carbazolyl group, or a combination thereof,

$X^1$ and $X^2$ are each independently N or C($-R^a$),
$X^3$ and $X^4$ are each independently S, N- $R^b$, or C($-R^c$)($-R^d$),
wherein $R^a$, $R^b$, $R^c$, and $R^d$ are each independently hydrogen, a substituted or unsubstituted C1 to C20 alkyl group, a substituted or unsubstituted C3 to C20 cycloalkyl group, a substituted or unsubstituted C6 to C20 aryl group, a substituted or unsubstituted C3 to C20 heteroaryl group, or a combination thereof,
$L^1$, and $L^2$ are each independently a single bond, a substituted or unsubstituted C1 to C4 alkylene group, a substituted or unsubstituted C1 to C4 alkenylene group, or a combination thereof, and
i, j, k, l, and m are each independently 0 or 1.

Chemical formula 2

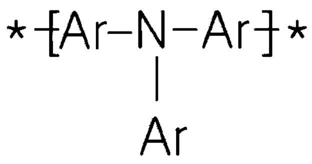

Chemical formula 2a

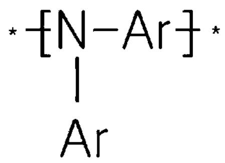

In Chemical formula 2 and Chemical formula 2a, each Ar is the same or different, and is each independently a substituted or unsubstituted C6 to C24 aromatic hydrocarbon group, and * is a portion connected to an adjacent atom or an adjacent repeating unit;

Chemical Formula 3

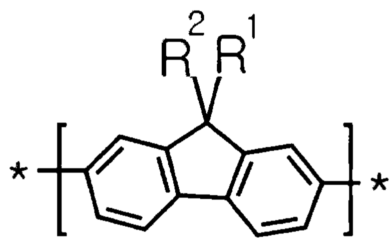

In Chemical formula 3, $R^1$ and $R^2$ are each independently hydrogen, a substituted or unsubstituted C1 to C40 alkyl group, a substituted or unsubstituted C2 to C40 alkenyl group, a substituted or unsubstituted C2 to C40 alkynyl group, a substituted or unsubstituted C3 to C20 cycloalkyl group, a substituted or unsubstituted C6 to C20 aryl group, a substituted or unsubstituted C3 to C20 heteroaryl group, a substituted or unsubstituted alkylamine group, a substituted or unsubstituted arylamine group, a substituted or unsubstituted carbazolyl group, or a combination thereof, and

* is a portion linked to an adjacent atom or an adjacent repeating unit.

The hole transport material may include a compound represented by Chemical formula 1-1, a compound represented by Chemical formula 1-2, a compound represented by Chemical formula 1-3, a polymer including a repeating unit represented by Chemical formula 2-1, a polyvinylcarbazole, or a combination thereof.

Chemical Formula 1-1

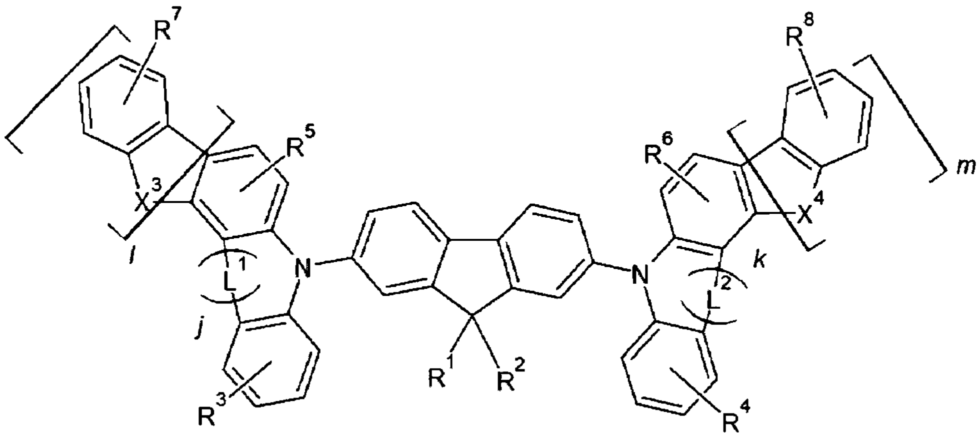

$R^1$ to $R^8$, $X^3$, $X^4$, $L^1$, $L^2$, j, k, l, and m are the same as those defined in Chemical formula 1.

Chemical Formula 1-2

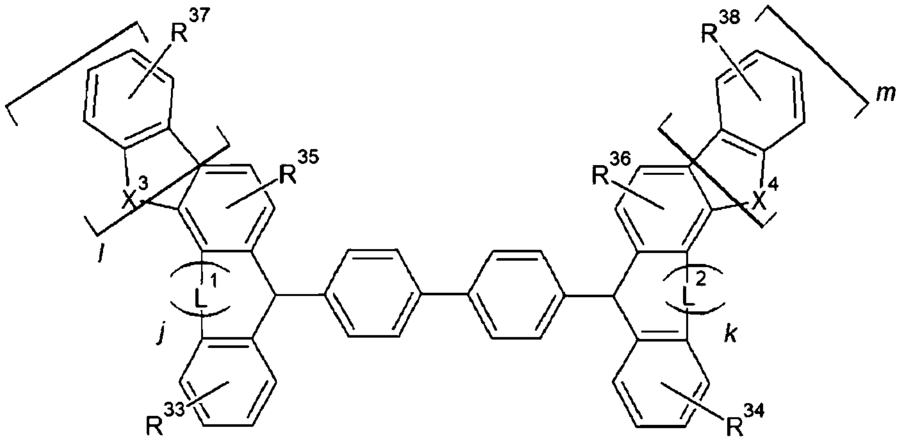

Chemical Formula 1-3

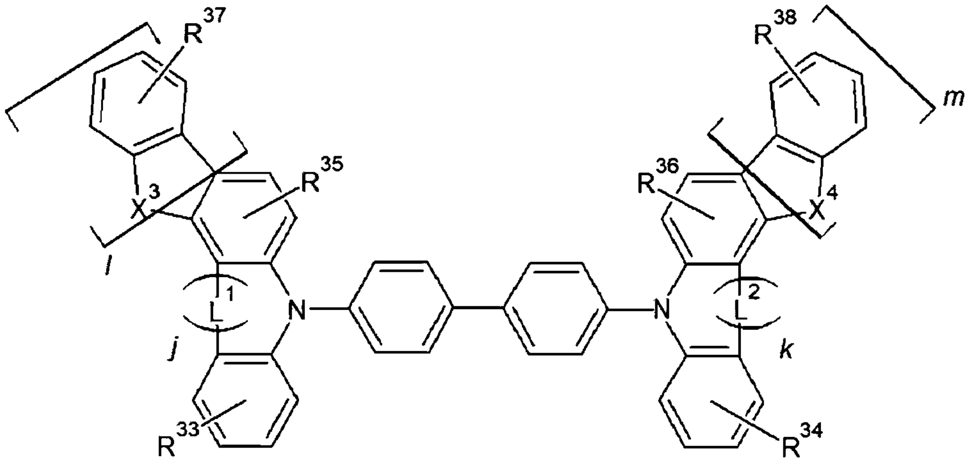

$X^3$, $X^4$, $L^1$, $L^2$, j, k, l, and m are the same as those defined in Chemical formula 1.

$R^{33}$, $R^{34}$, $R^{35}$, $R^{36}$, $R^{37}$, and $R^{38}$ are each independently hydrogen, a substituted or unsubstituted C1 to C40 alkyl group, a substituted or unsubstituted C2 to C40 alkenyl group, a substituted or unsubstituted C2 to C40 alkynyl group, a substituted or unsubstituted C3 to C20 cycloalkyl group, a substituted or unsubstituted C6 to C20 aryl group, a substituted or unsubstituted C3 to C20 heteroaryl group, a substituted or unsubstituted alkylamine group, a substituted or unsubstituted arylamine group, a substituted or unsubstituted carbazolyl group, or a combination thereof.

Chemical Formula 2-1

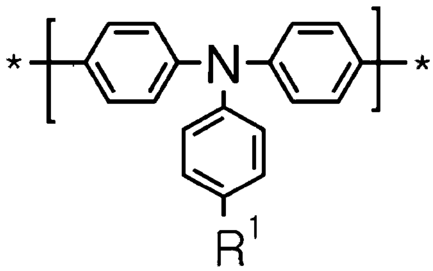

$R^1$ is independently hydrogen, a substituted or unsubstituted C1 to C40 alkyl group, a substituted or unsubstituted C2 to C40 alkenyl group, a substituted or unsubstituted C2 to C40 alkynyl group, a substituted or unsubstituted C3 to C20 cycloalkyl group, a substituted or unsubstituted C6 to C20 aryl group, a substituted or unsubstituted C3 to C20 heteroaryl group, a substituted or unsubstituted alkylamine group, a substituted or unsubstituted arylamine group, a substituted or unsubstituted carbazolyl group, or a combination thereof, and

* is a portion linked to an adjacent atom or an adjacent repeating unit.

The hole transport material may further include a p-dopant.

The hole injection/transport material or the p-dopant may include a quinone derivative, a cyano group-containing compound, a boron-containing compound, or a combination thereof. The hole injection/transport material or the p-dopant may include a borate salt compound. The borate salt compound may include a borate anion having a pentafluorophenyl group.

In an embodiment, the hole auxiliary layer or the base quencher may further include an alkali metal, and the alkali metal may further include cesium, rubidium, or a combination thereof.

The light emitting device may further include an organic layer, and the organic layer may include an acid material, e.g., the material may include a polymeric acid compound, a non-polymeric carboxylic acid compound, or a combination thereof.

The polymeric acid compound may include a polyacrylic acid, a polymethacrylic acid, a polyacrylic acid-methacrylic acid, a polyacrylic acid alkali metal (e.g., sodium) salt (for example, a partial salt), a copolymer including a (meth)acrylic acid repeating unit, polyvinylphosphonic acid, a poly(aromatic sulfonic acid) compound (e.g., poly(styrenesulfonic acid), poly(styrenesulfonic acid-co-maleic acid), etc.), a (partial or entire) alkali metal salt of poly(aromatic sulfonic acid), poly(vinyl sulfonic acid), a (partial or entire) alkali metal salt of poly(vinyl sulfonic acid), polymaleic acid, alginic acid, or a combination thereof (for example, a copolymer of at least two of the foregoing polymers or a mixture of at least two of the foregoing polymers).

The non-polymeric carboxylic acid compound may include a C2-C50 carboxylic acid compound represented by $R(COOH)_n$. In the formula, R is a substituted or unsubstituted aliphatic or aromatic hydrocarbon group of C1 to C50, C3-C25, or C5-C8, and n is 1 to 10, 2 to 8, 3 to 6, or 4 to 5.

The acid material or the non-polymeric carboxylic acid compound may be a compound having 2 to 10 carboxyl groups (for example, a polyvalent carboxylic acid compound).

The non-polymeric (polyvalent) carboxylic acid compound may include a substituted or unsubstituted C1- C50, C2- C50, C6-C15, or C8-C10 aliphatic hydrocarbon group, or a substituted or unsubstituted C6-C15 aromatic hydrocarbon group, in a number of one to ten, or two to five, or three to four.

The non-polymeric carboxylic acid compound or the polyvalent carboxylic acid compound may further include a hydroxyl group.

The acid material or the non-polymeric carboxylic acid compound may include benzoic acid, succinic acid, maleic acid, fumaric acid, malic acid, glutaric acid, adipic acid, pimelic acid, citric acid, oxalic acid, malonic acid, phthalic acid, isophthalic acid, terephthalic acid, trimellitic acid, hemimellitic acid, azelaic acid, suberic acid, tartaric acid, itaconic acid, dodecanedioic acid, acetic acid, (meth)acrylic acid, or a combination thereof.

The acid material may include the polymeric acid compound and the non-polymeric carboxylic acid compound.

An amount of a crosslinked polymer in the acid material may be less than about 1 weight %, or less than or equal to about 0.9 weight %, based on a total weight of the acid material.

The acid material may not include a crosslinked polymer.

A thickness of the organic layer may be greater than or equal to about 10 nanometers (nm), or greater than or

equal to about 100 nm. A thickness of the acid material film may be less than or equal to about 100 micrometers (μm), or less than or equal to about 10 μm.

The organic layer may be disposed to be spaced apart from the electron transport layer and the second electrode. The organic layer may be disposed to face the electron transport layer and the second electrode. The second electrode may be disposed between the organic layer and the electron transport layer.

The second electrode has a first surface facing a surface of the electron auxiliary layer and a second surface opposite the first surface. The organic layer may be disposed to be spaced apart from the electron transport layer and the second electrode, and to face at least a portion (e.g., including all) of the surface of the electron transport layer and/or at least a portion (e.g., including all) of the second surface of the second electrode.

The electroluminescent device may further include a container configured to accommodate at least the second electrode and the electron transport layer. The container may include a light transmitting member (e.g., a light transmitting material or component). The container may include an additional member (e.g., a sealing member) (for example, connected to the light transmitting member). The container may be an encapsulation element for a stacked structure (for example, that includes the first electrode, the hole auxiliary layer, the light emitting layer, the electron transport layer, and the second electrode). The container or the light transmitting member may include an organic material such as a polymer, an inorganic material such as glass, an organic-inorganic hybrid material, or a combination thereof. The container may be an integrated element made of a single member or material. The container may be an element configured by combining a plurality of members or materials.

The organic layer may be disposed on a surface of the container (or the light transmitting member) (for example, one surface facing the second electrode). The organic layer may be applied or coated on a surface of the container or the light transmitting member.

The second electrode may have a thickness of greater than or equal to about 11 nanometers (nm), or greater than or equal to about 12 nm and less than or equal to about 50 nm, or less than or equal to about 40 nm. The second electrode may exhibit a light transmittance of greater than or equal to about 50% and less than or equal to about 100% with respect to the first light. The first electrode may be configured to reflect at least a portion of the first light.

The second electrode may have a thickness of greater than or equal to about 12 nm and less than or equal to about 40 nm.

The light emitting device may be configured to emit green light when a voltage is applied. The light emitting device may be configured to emit blue light when a voltage is applied. The light emitting device may be configured to emit red light when a voltage is applied.

In an embodiment, a method of manufacturing an electroluminescent device includes:

forming a hole auxiliary layer on a first electrode;
forming an emission layer on the hole auxiliary layer;
forming an electron transport layer including metal oxide nanoparticles on the emission layer;
forming a second electrode (or a conductive thin film) on the electron transport layer to obtain a stacked structure; and
post-treating the stacked structure together with an acid material,
wherein forming the hole auxiliary layer includes forming a layer of a hole injection/transport material; applying a base quencher-containing composition on the layer of the hole injection/transport material (or optionally, on an additional hole transport layer formed on the layer of the hole injection/transport material), and optionally removing a solvent, and
wherein the post-treating includes placing the stacked structure and the acid material in a first space; and
maintaining the first space at a post-treatment temperature of greater than or equal to about 40 °C.

The post-treatment temperature may be less than or equal to about 200 °C, for example, less than or equal to about 180 °C, or less than or equal to about 150 °C.

In an embodiment, forming the hole auxiliary layer may include;

forming a layer of the hole injection/transport material,
applying a base quencher-containing composition on the layer of the hole injection/transport material, and optionally, removing a solvent to form a base quencher-containing layer; and
forming a hole transport layer on the base quencher-containing layer.

The layer of the hole injection/transport material may be a hole injection layer.

The acid material may be an organic layer or a composition for forming an organic layer.

The method may further include providing a container to the stacked structure, and the container may be configured to define at least a portion of the first space. Details regarding the container are as described herein. In an embodiment, the container may be an oven or a chamber. In an embodiment, the container may be an encap glass. The container may include a hollow chamber and an element configured to heat the chamber in a controlled manner.

The method may include preparing a composition including the acid material and a liquid vehicle (e.g., a solvent) (e.g., a composition for forming an organic layer).

The method may include applying the composition on the electron transport layer (and optionally on the second electrode).

The method may include applying the composition on one surface of the container so as to face the electron transport layer or the second electrode.

The method may include removing at least a portion of the liquid vehicle (solvent) from the applied composition for forming the organic layer.

The liquid vehicle may include water, a C1-10 alcohol, a sulfoxide solvent such as dimethyl sulfoxide, a nitrile solvent, an ester solvent, or a combination thereof. The liquid vehicle may include water, ethanol, methanol, propanol, acetonitrile, ethyl acetate, dimethyl sulfoxide, or a combination thereof.

The liquid vehicle may include a mixture of water and a C1-C10 alcohol.

In the method, the liquid vehicle includes a mixture of water and a C1-C10 alcohol, and the composition may be configured to exhibit a pH of greater than or equal to about 2 and less than or equal to about 7.

The composition or the acid material may exhibit, for example, in a solution state, a pH of greater than or equal to about 2, greater than or equal to about 3.5, greater than or equal to about 4, or greater than or equal to about 4.5 and less than or equal to about 7, less than or equal to about 6, less than or equal to about 5.5, or less than or equal to about 5.

The first space may be a closed space, for example, a sealed or hermetic (airtight) space. The post-treatment temperature may be greater than or equal to about 45 °C, greater than or equal to about 50 °C, greater than or equal to about 70 °C, and less than or equal to about 180 °C, less than or equal to about 150 °C, or less than or equal to about 100 °C. The post-treatment may be performed for a predetermined time.

The predetermined time may be greater than or equal to about 10 minutes, greater than or equal to about 30 minutes, greater than or equal to about 1 hour, or greater than or equal to about 2 hours, greater than or equal to about 5 hours and less than or equal to about 10 days, less than or equal to about 10 hours, or less than or equal to about 3 hours.

The manufacturing method may include, after the post-treatment, removing the container. The manufacturing method may further include, after removing the container, providing a new container including or not including a polymer layer.

The manufacturing method may further include, after the post-treatment, further providing a conductive layer on the conductive thin film to form a conductive thin film (or the second electrode) having an increased thickness.

In an embodiment, a display device includes the light emitting device (e.g., an electroluminescent device).

An embodiment provides an electronic device including the foregoing light emitting device.

The display device may be, or may include, an AR/VR device, a mobile terminal device, a monitor, a laptop computer, a television, a signboard, a camera, or an automotive electronic component (for example, for an electric vehicle).

According to an embodiment, a light emitting device exhibiting improved emission properties and lifetime characteristics may be provided. According to an embodiment, degradation of electroluminescent properties of the light emitting device during the post-treatment process may be effectively suppressed or prevented, and thus a sufficient positive aging effect may be provided without shortening the post-treatment process or the temperature/time thereof, thereby further improving properties of the light emitting device. The method may, for example, enable mass production of a front-emission type light emitting device.

## BRIEF DESCRIPTION OF THE DRAWINGS

The above and other advantages and features of this disclosure will become more apparent by describing in further detail exemplary embodiments thereof with reference to the accompanying drawings, in which:

FIG. 1A to FIG 1F represent schematic cross-sectional views of a light emitting device according to an embodiment; to an embodiment;
FIG. 2A to 2C represent schematic cross-sectional views of an electroluminescent device according to an embodiment;
FIGS. 3A and 3B represent schematic cross-sectional views of an electroluminescent device according to an embodiment;
FIGS. 4A, 4B, and 4C represent schematic cross-sectional views of an electroluminescent device according to an embodiment;
FIGS. 5A, 5B, and 5C represent schematic cross-sectional views of an electroluminescent device according to an embodiment;
FIG. 6 is a schematic cross-sectional view of an electroluminescent device according to an embodiment;
FIG. 7A is a schematic cross-sectional view of an electroluminescent device according to an embodiment;

FIG. 7B is a front view of a stacked structure included in the electroluminescent device of FIG. 7A;
FIG. 7C is a schematic cross-sectional view of an electroluminescent device according to an embodiment;
FIG. 8A is a schematic cross-sectional view of a stacked structure for post-treatment in a manufacturing process of a light emitting device according to an embodiment;
FIG. 8B is a schematic cross-sectional view of a stacked structure in which, after post-treatment in the manufacturing process of the light emitting device according to FIG. 6A, the stacked structure is removed from a container, a second electrode is then formed, and a new container is provided;
FIG. 9 is a diagram schematically illustrating an example of post-treatment (using an oven or a chamber as a container) during a manufacturing process of a light emitting device according to an embodiment;
FIG. 10 is a schematic cross-sectional view of a light emitting device (RGB pixels) according to an embodiment;
FIG. 11 is a schematic front view of a display panel according to an embodiment;
FIG. 12 is a schematic cross-sectional view taken along line IV-IV of the display panel of FIG. 11;
FIG. 13 illustrates electroluminescent properties of electroluminescent devices of Example 1 and Comparative Example 1;
FIG. 14 illustrates electroluminescent properties of electroluminescent devices of Example 1 and Comparative Example 1;
FIG. 15 illustrates electroluminescent properties of electroluminescent devices of Example 1 and Comparative Example 1; and
FIG. 16 illustrates electroluminescent properties of electroluminescent devices of Example 1 and Comparative Example 1.

DETAILED DESCRIPTION OF THE EMBODIMENTS

Advantages and characteristics of this disclosure, and a method for achieving the same, will become evident referring to the following example embodiments together with the drawings attached hereto. However, the embodiments should not be construed as being limited to the embodiments set forth herein. Rather, these embodiments are provided so that this disclosure will be thorough and complete, and will fully convey the scope of the invention to those skilled in the art.

In order to clearly explain the present disclosure, parts irrelevant to the description are omitted, and the same reference numerals are assigned to the same or similar elements throughout the specification. In the drawings, the thickness of layers, films, panels, regions, etc., are exaggerated for clarity. In the drawings, for convenience of description, the thickness of some layers and regions are exaggerated. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

In addition, it will be understood that when an element such as a layer, film, region, or substrate is referred to as being "on" another element, it can be directly on the other element or intervening elements may also be present. In contrast, when an element is referred to as being "directly on" another element, there are no intervening elements present. Also, to be disposed "on" the reference portion means to be disposed above or below the reference portion and does not necessarily mean "above". Moreover, element A disposed on element B includes positional arrangements in which one or more intervening elements may exist between the A and B elements.

It will be understood that, although the terms "first," "second," "third," etc., may be used herein to describe various elements, components, regions, layers and/or sections, these elements, components, regions, layers and/or sections should not be limited by these terms. These terms are only used to distinguish one element, component, region, layer or section from another element, component, region, layer, or section. Thus, "a first element," "component," "region," "layer," or "section" discussed below could be termed a second element, component, region, layer, or section without departing from the teachings herein.

The terminology used herein is for the purpose of describing particular embodiments only and is not intended to be limiting. As used herein, the singular forms "a," "an," and "the" are intended to include the plural forms, including "at least one," unless the content clearly indicates otherwise. "At least one" is not to be construed as being limited to "a" or "an." "Or" means "and/or."

As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

As used herein, the term "plan view" refers to a view of a target portion as viewed from above, and the term "cross-sectional view" refers to a view of a cross section of the target portion taken in a vertical direction and viewed laterally.

Unless otherwise defined, all terms (including technical and scientific terms) used herein have the same meaning as commonly understood by one of ordinary skill in the art to which this disclosure belongs. It will be further understood that terms, such as those defined in commonly used, e.g., non-technical, dictionaries, should be interpreted as having a meaning that is consistent with their meaning in the context of the relevant art and the present disclosure, and will not be interpreted in an idealized or overly formal sense unless expressly so defined herein.

Hereinafter, values of a work function, a conduction band, or a lowest unoccupied molecular orbital ("LUMO") (or valence band or highest occupied molecular orbital ("HOMO")) energy level is expressed as an absolute value from a vacuum level. In addition, when the work function or the energy level is referred to be "deep," "high" or "large," the work function or the energy level has a large absolute value based on "0 electron volts (eV)" of the vacuum level, while when the work function or the energy level is referred to be "shallow," "low," or "small," the work function or energy level has a small absolute value based on "0 eV" of the vacuum level.

As used herein, the average (value) may be mean or median. In an embodiment, the average (value) may be a mean average.

As used herein, the term "peak emission wavelength" is the wavelength at which a given emission spectrum of the light reaches its maximum.

As used herein, the term "Group" may refer to a group of Periodic Table.

As used herein, "Group I" refers to Group IA and Group IB, and examples may include Li, Na, K, Rb, and Cs, but are not limited thereto.

As used herein, "Group II" refers to Group IIA and Group IIB, and examples of Group II metal may be Cd, Zn, Hg, and Mg, but are not limited thereto.

As used herein, "Group III" refers to Group IIIA and Group IIIB, and examples of Group IIIA metal may be Al, In, Ga, and Tl, and examples of Group IIIB may be scandium, yttrium, or the like, but are not limited thereto.

As used herein, "Group IV" refers to Group IVA and Group IVB, and examples of a Group IVA metal may be Si, Ge, and Sn, and examples of Group IVB metal may be titanium, zirconium, hafnium, or the like, but are not limited thereto.

As used herein, "Group V" includes Group VA and includes nitrogen, phosphorus, arsenic, antimony, and bismuth, but is not limited thereto.

As used herein, "Group VI" includes Group VIA and includes sulfur, selenium, and tellurium, but is not limited thereto.

As used herein, "metal" includes a semi-metal such as Si.

As used herein, a number of carbon atoms in a group or a molecule may be referred to as a subscript (e.g., $C_{6-50}$) or as C6 to C50.

As used herein, when a definition is not otherwise provided, "substituted" refers to replacement of at least one hydrogen of a compound or a group for a corresponding group moiety including a C1 to C30 alkyl group, a C2 to C30 alkenyl group, a C2 to C30 alkynyl group, a C6 to C30 aryl group, a C7 to C30 alkylaryl group, a C1 to C30 alkoxy group, a C1 to C30 heteroalkyl group, a C3 to C30 heteroalkylaryl group, a C3 to C30 cycloalkyl group, a C3 to C15 cycloalkenyl group, a C6 to C30 cycloalkynyl group, a C2 to C30 heterocycloalkyl group, a halogen (-F, -Cl, -Br, or -I), a hydroxy group (-OH), a nitro group ($-NO_2$), a cyano group (-CN), an amino group (-NRR' wherein R and R' are each independently hydrogen or a C1 to C6 alkyl group), an azido group ($-N_3$), an amidino group ($-C(=NH)NH_2$), a hydrazino group ($-NHNH_2$), a hydrazono group ($=N(NH_2)$), an aldehyde group (-C(=O)H), a carbamoyl group ($-C(O)NH_2$), a thiol group (-SH), an ester group (-C(=O)OR, wherein R is a C1 to C6 alkyl group or a C6 to C12 aryl group), a carboxyl group (-COOH) or a salt thereof (-C(=O)OM, wherein M is an organic or inorganic cation), a sulfonic acid group ($-SO_3H$) or a salt thereof ($-SO_3M$, wherein M is an organic or inorganic cation), a phosphoric acid group ($-PO_3H_2$) or a salt thereof ($-PO_3MH$ or $-PO_3M_2$, wherein M is an organic or inorganic cation), or a combination thereof.

As used herein, when a definition is not otherwise provided, "hydrocarbon" or "hydrocarbon group" refers to a compound or a group including carbon and hydrogen (e.g., alkyl, alkenyl, alkynyl, or aryl group). The hydrocarbon group may be a monovalent group or a group having a valence of greater than one formed by removal of a, e.g., one or more, hydrogen atoms from alkane, alkene, alkyne, or arene. In the hydrocarbon or hydrocarbon group, a, e.g., at least one, methylene may be replaced by an oxide moiety, a carbonyl moiety, an ester moiety, -NH-, or a combination thereof. Unless otherwise stated to the contrary, the hydrocarbon compound or hydrocarbon group (alkyl, alkenyl, alkynyl, or aryl) may have 1 to 60, 2 to 32, 3 to 24, or 4 to 12 carbon atoms.

As used herein, when a definition is not otherwise provided, "alkyl" refers to a linear or branched saturated monovalent hydrocarbon group (methyl, ethyl hexyl, etc.). In an embodiment, an alkyl group may have from 1 to 50 carbon atoms, or 1 to 18 carbon atoms, or 1 to 12 carbon atoms.

As used herein, when a definition is not otherwise provided, "alkenyl" refers to a linear or branched monovalent hydrocarbon group having a carbon-carbon double bond. In an embodiment, an alkenyl group may have from 2 to 50 carbon atoms, or 2 to 18 carbon atoms, or 2 to 12 carbon atoms.

As used herein, when a definition is not otherwise provided, "alkynyl" refers to a linear or branched monovalent

hydrocarbon group having a carbon-carbon triple bond. In an embodiment, an alkynyl group may have from 2 to 50 carbon atoms, or 2 to 18 carbon atoms, or 2 to 12 carbon atoms.

As used herein, when a definition is not otherwise provided, "aryl" refers to a group formed by removal of a, e.g., at least one, hydrogen from an arene (e.g., a phenyl or naphthyl group). In an embodiment, an aryl group may have 6 to 50 carbon atoms, 6 to 18 carbon atoms, or 6 to 12 carbon atoms.

As used herein, when a definition is not otherwise provided, "hetero" refers to inclusion of 1 to 3 heteroatoms, e.g., N, O, S, Si, P, or a combination thereof.

As used herein, when a definition is not otherwise provided, "alkoxy" refers to an alkyl group linked to oxygen (e.g., alkyl-O-) for example, a methoxy group, an ethoxy group, or a sec-butyloxy group.

As used herein, when a definition is not otherwise provided, "amine" is a compound represented by $NR_3$, wherein each R is independently hydrogen, a C1-C12 alkyl group, a C7-C20 alkylaryl group, a C7-C20 arylalkyl group, or a C6-C18 aryl group.

As used herein, "poly(meth)acrylate" refers to a polyacrylate, a polymethacrylate, or a combination thereof.

As used herein, the expression "not including cadmium (or other harmful heavy metal)" may refer to the case in which a concentration of cadmium (or another heavy metal deemed harmful) may be less than or equal to about 100 parts per million by weight (ppmw), less than or equal to about 50 ppmw, less than or equal to about 10 ppmw, less than or equal to about 1 ppmw, less than or equal to about 0.1 ppmw, less than or equal to about 0.01 ppmw, or about zero. In an embodiment, substantially no amount of cadmium (or other toxic heavy toxic metal) may be present or, if present, an amount of cadmium (or other heavy metal) may be less than or equal to a detection limit or as an impurity level of a given analysis tool (e.g., an inductively coupled plasma atomic emission spectroscopy instrument).

Unless mentioned to the contrary, a numerical range recited herein is inclusive. Unless mentioned to the contrary, a numerical range recited herein includes any real number within the endpoints of the stated range and includes the endpoints thereof. As used herein, the upper and lower endpoints set forth for various numerical values may be independently combined to provide a range.

"About" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 10%, 5%, 3%, or 1% of the stated value.

As used herein, a nanoparticle is a structure having a, e.g., at least one, region or characteristic dimension with a nanoscale dimension. In an embodiment, a dimension (or an average dimension, average size, or average length) of the nanostructure is less than or equal to about 500 nm, less than or equal to about 300 nm, less than or equal to about 250 nm, less than or equal to about 150 nm, less than or equal to about 100 nm, less than or equal to about 50 nm, or less than or equal to about 30 nm. In an embodiment, the nanoparticle may have any suitable shape. The nanoparticle (e.g., a semiconductor nanoparticle or a metal oxide nanoparticle) may include a nanowire, a nanorod, a nanotube, a branched nanostructure, a nano tetrapod, a nanotripod, a nanobipod, a nanocrystal, a nanodot, a multi-pod type shape such as at least two pods, or the like and is not limited thereto. The nanoparticle can be, e.g., substantially crystalline, substantially monocrystalline, polycrystalline, (for example, at least partially) amorphous, or a combination thereof.

In an embodiment, a semiconductor nanoparticle such as a quantum dot may exhibit quantum confinement or exciton confinement. As used herein, the term "quantum dot" or "semiconductor nanostructure" is not limited in a shape thereof unless otherwise defined. A semiconductor nanoparticle or a quantum dot may have a size smaller than a Bohr excitation diameter for a bulk crystal material having an identical composition and may exhibit a quantum confinement effect. The semiconductor nanoparticle or the quantum dot may emit light corresponding to a bandgap energy thereof by controlling a size of a nanocrystal acting as an emission center.

As used herein, the term "T50" refers to a time (in hours, h) for the brightness (e.g., luminance) of a given device to decrease to 50% of the initial brightness (100%) as, e.g., measured from the time the given device is first driven, e.g., operated, at a predetermined initial brightness (e.g., 650 nit or 146 nit).

As used herein, the term "T90" refers to a time (h) for the brightness (e.g., luminance) of a given device to decrease to 90% of the initial brightness (100%) as measured from the time the given device is first driven at a predetermined initial brightness (e.g., 650 nit or 146 nit).

As used herein, the phrase "external quantum efficiency (EQE)" is a ratio of the number of photons emitted from a light emitting diode (LED) to the number of electrons passing through the device and can be a measurement as to how efficiently a given device converts electrons to photons and allows the photons to escape. The EQE can be determined by the following equation:

EQE = an efficiency of injection x a (solid-state) quantum yield x an efficiency of extraction.

wherein the efficiency of injection is a proportion of electrons passing through the device that are injected into the active region, the quantum yield is a proportion of all electron-hole recombination in the active region that are radiative and

produce photons, the efficiency of extraction is a proportion of photons generated in the active region that escape from the given device.

As used herein, a maximum EQE is a greatest value of the EQE.

As used herein, a maximum luminance is the highest value of luminance for a given device.

As used herein, the term, quantum efficiency, may be used interchangeably with the term, quantum yield. In an embodiment, the quantum efficiency may be a relative quantum yield or an absolute quantum yield, for example, which can be readily measured by any suitable, e.g., commercially available, equipment. The quantum efficiency (or quantum yield) may be measured in a solution state or a solid state (in a composite). In an embodiment, "quantum yield (or quantum efficiency)" may be a ratio of photons emitted to photons absorbed, e.g., by a nanostructure or population of nanostructures. In an embodiment, the quantum efficiency may be determined by any suitable method. For example, there may be two methods for measuring the fluorescence quantum yield or efficiency: the absolute method and the relative method.

The absolute method directly obtains the quantum yield by detecting all sample fluorescence through the use of an integrating sphere. In the relative method, the fluorescence intensity of a standard sample (e.g., a standard dye) may be compared with the fluorescence intensity of an unknown sample to calculate the quantum yield of the unknown sample. Coumarin 153, Coumarin 545, Rhodamine 101 inner salt, Anthracene, and Rhodamine 6G may be used as standard dye, depending on the photoluminescence (PL) wavelengths thereof, but are not limited thereto.

A bandgap energy of a semiconductor nanoparticle may vary with a size and a composition of a nanocrystal. For example, as a size of the semiconductor nanoparticle increases, the bandgap energy of the semiconductor nanoparticle may become smaller, e.g., narrower, and the semiconductor nanoparticle may emit light of, e.g., having an increased emission wavelength. A semiconductor nanocrystal may be used as a light emitting material in various fields of, e.g., such as in, a display device, an energy device, or a bio light emitting device.

A semiconductor nanoparticle-based light emitting device that emits light by application of a voltage (for example, a quantum dot light emitting device, also referred to as a QD-LED) includes a semiconductor nanoparticle (e.g., a quantum dot) as a light emitting material. Compared to an Organic Light Emitting Diode (OLED) in which an organic material serves as a light emission center, a QD-LED can realize purer colors (Red, Green, and Blue) and improved color reproducibility, and thus has attracted attention as a next-generation display device. A QD-LED may include a solution process, and thus may be manufactured at reduced manufacturing cost, and since it is based on an inorganic material, is expected to exhibit improved stability; however, development of a technology capable of improving device properties and lifetime characteristics is desirable.

A quantum dot having electroluminescent properties at a level applicable to practical use may include a harmful heavy metal such as cadmium (Cd), lead, mercury, or a combination thereof. Therefore, provision of a light emitting device or a display device having an emission layer that does not substantially include the harmful heavy metals is desirable.

A light emitting device according to an embodiment (for example, a electroluminescent device) is a device configured to emit desired light by application of a voltage, without a separate light source or together with a separate light source.

In a QD-LED according to an embodiment, holes and electrons supplied from two electrodes (e.g., an anode and a cathode) may meet in an emission layer (EML, emitting layer, QD emission layer) through a plurality of common layers to form excitons and undergo recombination and light emission. In the QD-LED of an embodiment, common layers for smooth injection of holes and electrons upon application of a voltage may be provided between the emission layer and the electrodes, and the design of such common layers may affect properties of the device. For example, an electron transport layer is required to have sufficient electron mobility capable of balancing holes and electrons in the emission layer, and in this case, electrons may be efficiently delivered from the electrode to the quantum dot emission layer. In addition, the electron transport layer may be required to have an appropriately deep HOMO energy level to sufficiently block holes overflowing from the quantum dot emission layer.

In an electroluminescent device of an embodiment, a metal oxide nanoparticle included in an electron transport layer may provide higher electron mobility than an organic semiconductor material, and the emission layer may exhibit desired electroluminescent properties, for example, in combination with a metal oxide nanoparticle-based electron transport layer as described below. In addition, a semiconductor nanoparticle-based emission layer may be formed by a solution process, and a metal oxide nanoparticle-based electron transport layer may be formed on the emission layer by a solution process, which may be advantageous in terms of processing.

However, the present inventors have found that a combination of a metal oxide nanoparticle-based electron auxiliary layer and a semiconductor nanoparticle-based emission layer may not provide a desired level of improvement in electroluminescent properties and lifetime characteristics. For example, a metal oxide nanoparticle (e.g., a zinc magnesium oxide nanoparticle) may be grown through a sol-gel reaction involving a precursor (e.g., $Zn(CH_3COO)_2$, $Mg(CH_3COO)_2$) in the presence of a base. Without wishing to be bound by any theory, it is considered that various surface chemical species such as metal ions ($Zn^{2+}$, $Mg^{2+}$) $O^{2-}$, -OH, $CH_3COO^-$, and the like may be present on surfaces of the metal oxide nanoparticles in such a synthesized state, and such surface chemical species may serve as surface defects of the nanoparticles and may act as defect levels in a device. Without wishing to be bound by any theory, trap sites

generated in metal oxide particles (e.g., ZnMgO) may have energy levels near a HOMO level of a QD and may serve as trap sites for holes, and thus may be considered to contribute to an increase in leakage current.

The metal oxide nanoparticle in the electron auxiliary layer or the electron transport layer may include various defects generated during a manufacturing process thereof and/or a film formation process thereof, and such defects may provide various energy levels in the nanoparticle to be utilized as pathways for hole transport. Accordingly, it is believed that the metal oxide nanoparticle-based electron transport layer may exhibit a reduced level of hole blocking performance or a relatively high level of hole leakage current, which is considered to adversely affect electroluminescent properties (e.g., luminous efficiency) of the device.

In addition, without wishing to be bound by any theory, surface defects that may be present in the metal oxide nanoparticles are considered to cause accumulation of a large amount of charges at an interface between the electron transport layer and the emission layer or inside the electron transport layer, and such charge accumulation may lead to undesired charging (e.g., within the electron transport layer or at the interface between the emission layer and the electron transport layer), thereby causing luminance reduction or lifetime reduction of a QD-LED device.

In an electroluminescent device according to an embodiment, an electron transport layer may be modified to address such problems, for example, by acid and/or moisture treatment (hereinafter referred to as post-treatment or an aging process). During the aging process, acid/moisture components are diffused into the electron transport layer, for example, in a predetermined (relatively elevated temperature) environment. Surprisingly, however, according to findings of the present inventors, such aging may significantly reduce electroluminescent properties in some devices, and the present inventors have found that a cause of such degradation in device properties can be related to a material of a hole auxiliary layer. For broader application of QD-LEDs, an inkjet printing method may be required, and according to findings of the present inventors, hole auxiliary materials applicable to an inkjet printing method may be particularly vulnerable to aging treatment.

The present inventors have also found that, when certain materials for a hole injection layer and a hole transport layer or thin films including the same are exposed to an acid, device resistance is significantly increased due to loss of conductivity. Without wishing to be bound by any theory, post-treatment of a device (e.g., using an acid component) may cause dopant desorption or loss of a doping effect in the hole auxiliary layer and/or damage polymer bonds in the hole auxiliary layer, which is considered to manifest as degradation of hole transport properties. Limiting an amount of acid/moisture and/or reducing an aging treatment time in consideration of such damage during the aging process may make it difficult to obtain desired effects of aging, and accordingly may cause overall device performance degradation. The present inventors have surprisingly found that such technical problems may be solved by the hole auxiliary layer described herein or a device including the same.

In an embodiment, for example, as shown in FIG. 1A, an electroluminescent device (or a stacked structure) includes a first electrode 1 (e.g., a hole injection conductor or an anode) and a second electrode 5 (e.g., an electron injection conductor or a cathode) that are spaced apart (e.g., facing each other); an emission layer 3 disposed between the first electrode and the conductive thin film and including semiconductor nanoparticles; a hole auxiliary layer 2 between the emission layer and the first electrode; and an electron transport layer or an electron auxiliary layer 4 including the same between the emission layer 3 and the second electrode 5, wherein the electron transport layer includes a metal oxide nanoparticle, and the hole auxiliary layer 2 includes a hole injection/transport material and a base quencher. The hole auxiliary layer 2 may be in contact (e.g., direct contact) with the emission layer. In an embodiment, The hole auxiliary layer 2 may be between the emission layer and the first electrode and in contact with the emission layer. The base quencher includes an alkali metal hydroxide, an ammonium hydroxide compound, an amine compound, or a combination thereof (see FIG. 1A to FIG. 1F and FIG. 2A to FIG. 2C). The emission layer or the semiconductor nanoparticle may be configured to emit first light by application of a voltage (for example, between the first electrode and the second electrode).

In an electroluminescent device of an embodiment, a first electrode or a second electrode may include an anode or a cathode. In an embodiment, the first electrode may include a cathode (or an anode), and the second electrode may include an anode (or a cathode). In an embodiment, the second electrode includes an electron injection conductor, for example, a cathode, and the first electrode includes a hole injection conductor, for example, an anode.

In a display device including the electroluminescent device of an embodiment, the first electrode may be disposed on a (transparent) substrate 100 or on a substrate and a driving circuit. In an embodiment, first light emitted from the emission layer may be extracted through the second electrode and a first surface of the container (for example, in a Z direction). In an embodiment, the first light may be extracted through the (transparent) first electrode and, optionally, through the substrate 100. The emission layer may be disposed in a pixel (or a subpixel) in a display device (display panel) to be described later.

In the electroluminescent device of an embodiment, an emission layer 3, 30 may be disposed between a first electrode (for example, an anode) 1, 10 and a second electrode (for example, a cathode) 5, 50. The conductive thin film may be the second electrode, or the second electrode may include the conductive thin film. The second electrode or the cathode 5, 50 may include an electron injection conductor. The first electrode or the anode 1, 10 may include a hole injection conductor. Work functions of the electron/hole injection conductors included in the second electrode and the first

electrode may be appropriately controlled and are not particularly limited. For example, the second electrode may have a small work function, and the first electrode may have a relatively large work function, or vice versa.

The electron/hole injection conductors may include a metal-based material (e.g., a metal, a metal compound, an alloy, or a combination thereof) such as aluminum, magnesium, tungsten, nickel, cobalt, platinum, palladium, calcium, LiF, etc.; a metal oxide such as gallium indium oxide or indium tin oxide (ITO); or a conductive polymer (e.g., having a relatively high work function) such as polyethylene dioxythiophene, but are not limited thereto.

The first electrode, the second electrode, or a combination thereof may be a light-transmitting electrode or a transparent electrode. In an embodiment, both the first electrode and the second electrode may be a light-transmitting electrode. The first electrode, the second electrode, or a combination thereof may be patterned electrodes.

The first electrode, the second electrode, or a combination thereof may be disposed on a (e.g., insulating) substrate 100. The substrate 100 may be a substrate including an insulating material. The substrate may include glass; various polymers such as a polyester of polyethylene terephthalate (PET), polyethylene naphthalate (PEN), polycarbonate, polyacrylate, and the like; a polysiloxane (e.g., polydimethylsiloxane (PDMS)); an inorganic material such as $Al_2O_3$ or ZnO; or a combination thereof but is not limited thereto. A thickness of the substrate may be appropriately selected taking into consideration a substrate material but is not particularly limited. The substrate may be a flexible substrate. The substrate may further include an area for a blue pixel, an area for a red pixel, an area for a green pixel, or a combination thereof.

The substrate 100 or the container (or the light transmitting member included in the container) may be optically transparent. The substrate 100 or the container (or the light transmitting member) may have a light transmittance of greater than or equal to about 50%, greater than or equal to about 60%, greater than or equal to about 70%, greater than or equal to about 80%, greater than or equal to about 85%, or greater than or equal to about 90% and less than or equal to about 100%, for example, less than or equal to about 99%, or less than or equal to about 95%. The substrate or the container (or the light transmitting member included in the container) may have a transmittance of greater than or equal to about 50%, greater than or equal to about 60%, greater than or equal to about 70%, greater than or equal to about 80%, greater than or equal to about 85%, greater than or equal to about 90%, greater than or equal to about 95%, or greater than or equal to about 99%, and less than or equal to about 100%, for example, less than or equal to about 99%, or less than or equal to about 95%, with respect to the light emitted from the semiconductor nanoparticle for example included in the light emitting layer (or the emission layer). In an embodiment, the substrate or the container (or the light-transmitting member) may be opaque or reflective.

In an embodiment, a thin film transistor may be disposed in each region of the substrate, but it is not limited thereto. In an embodiment, a source electrode or a drain electrode of the thin film transistor may be electrically connected to the first electrode or the second electrode. In an embodiment, the light-transmitting electrode may be disposed on a (e.g., insulating) transparent substrate. The substrate 100 may be a rigid or a flexible substrate.

The electrode may include or be made of, for example, a metal oxide such as an indium tin oxide (ITO) or an indium zinc oxide (IZO), a gallium indium tin oxide, a zinc indium tin oxide; a metal nitride such as a titanium nitride; a conductive polymer such as a polyaniline; LiF/Mg:Ag; a metal thin film of a single layer or a plurality of layers; or a combination thereof. In an embodiment, the electrode (e.g., the first electrode and/or the second electrode) may include aluminum (Al), a lithium-aluminum (Li:Al) alloy, a magnesium-silver (Mg:Ag) alloy, lithium fluoride-aluminum (LiF:Al), gold, silver, or a combination thereof. A ratio of the alloy may be appropriately selected and is not particularly limited. The electrode may be formed by vacuum deposition, thermal deposition, sputtering deposition, or the like.

A thickness of each of the electrode (the first electrode, the second electrode, or a combination thereof or the conductive thin film) is not particularly limited and may be appropriately selected taking into consideration device efficiency. For example, the thickness of the electrode (or the thin film conductor or the conductive thin film) may be greater than or equal to about 5 nm, greater than or equal to about 10 nm, greater than or equal to about 20 nm, greater than or equal to about 30 nm, greater than or equal to about 40 nm, or greater than or equal to about 50 nm. For example, the thickness of the electrode (or the thin film conductor) may be less than or equal to about 100 micrometers ($\mu$m), less than or equal to about 90 $\mu$m, less than or equal to about 80 $\mu$m, less than or equal to about 70 $\mu$m, less than or equal to about 60 $\mu$m, less than or equal to about 50 $\mu$m, less than or equal to about 40 $\mu$m, less than or equal to about 30 $\mu$m, less than or equal to about 20 $\mu$m, less than or equal to about 10 $\mu$m, less than or equal to about 1 $\mu$m, less than or equal to about 900 nm, less than or equal to about 500 nm, or less than or equal to about 100 nm.

A light transmitting electrode or a non-light transmitting or non-transmissive electrode (e.g., a reflective electrode) may be formed by adjusting the composition and/or thickness of the electrode. In an embodiment, the non-transmissive electrode may include a metal (e.g., aluminum, silver, or the like) layer disposed between layers of a metal oxide (e.g., light-transmitting metal oxide) such as an indium tin oxide. In an embodiment, the light-transmitting electrode may include a light-transmitting metal oxide, a thin metal or alloy thin film, or a combination thereof. The light-transmitting electrode may include a transparent electrode and a translucent electrode.

In the electroluminescent device of an embodiment, the second electrode or the thin film conductor may have a thickness of greater than or equal to about 1 nm, for example, greater than or equal to about 5 nm, greater than or equal to

about or 9 nm and less than 100 nm, less than or equal to about 99 nm, or less than or equal to about 95 nm. The thickness of the second electrode or thin film conductor may be greater than about 10 nm, greater than or equal to about 11 nm, greater than or equal to about 12 nm, greater than or equal to about 13 nm, greater than or equal to about 14 nm, greater than or equal to about 15 nm, greater than or equal to about 16 nm, greater than or equal to about 17 nm, greater than or equal to about 18 nm, greater than or equal to about 19 nm, or greater than or equal to about 20 nm. The thin film conductor may have a thickness of less than or equal to about 80 nm, less than or equal to about 60 nm, less than or equal to about 50 nm, or less than or equal to about 40 nm.

In the electroluminescent device of an embodiment, the first electrode, or the second electrode may have a light transmittance for the first light that is greater than or equal to about 20%, greater than or equal to about 25%, greater than or equal to about 30%, greater than or equal to about 35%, greater than or equal to about 40%, greater than or equal to about 45%, greater than or equal to about 50%, greater than or equal to about 55%, greater than or equal to about 57%, greater than or equal to about 59%, greater than or equal to about 60%, greater than or equal to about 63%, greater than or equal to about 65%, greater than or equal to about 67%, greater than or equal to about 69%, greater than or equal to about 70%, greater than or equal to about 75%, greater than or equal to about 78%, greater than or equal to about 80%, greater than or equal to about 82%, greater than or equal to about 85%, or greater than or equal to about 89%. The light transmittance of the first electrode, or the second electrode for the first light may be less than or equal to about 100%, less than or equal to about 99%, less than or equal to about 98%, less than or equal to about 97%, less than or equal to about 96%, less than or equal to about 95%, less than or equal to about 94%, less than or equal to about 93%, less than or equal to about 92%, less than or equal to about 91%, less than or equal to about 90%, less than or equal to about 89%, less than or equal to about 88%, less than or equal to about 87%, less than or equal to about 86%, less than or equal to about 85%, less than or equal to about 84%, less than or equal to about 83%, less than or equal to about 82%, less than or equal to about 80%, less than or equal to about 79%, less than or equal to about 76%, less than or equal to about 73%, less than or equal to about 68%, less than or equal to about 66%, less than or equal to about 64%, less than or equal to about 61%, less than or equal to about 60%, less than or equal to about 55%, less than or equal to about 50%, less than or equal to about 49%, less than or equal to about 48%, or less than or equal to about 47%.

In an embodiment of the light emitting device, the second electrode or the first electrode may be configured to reflect at least a portion (e.g., greater than or equal to about 50%, greater than or equal to about 60%, greater than or equal to about 70%, greater than or equal to about 80%, greater than or equal to about 90%, greater than or equal to about 95%, or greater than or equal to about 99%) of the first light. In an embodiment of the light emitting device, the second electrode or the first electrode may include a multi-layered structure, for example, having a structure of ITO/aluminum/ITO, ITO/Ag/ITO, Ag/ITO; a conductive metal electrode such as Ag, Al, Cu, Au, tungsten, nickel, cobalt, platinum; or a combination thereof.

The electrode (the first electrode or the second electrode) may include silver, aluminum, magnesium, tungsten, nickel, cobalt, platinum, palladium, calcium, LiF, gold, copper, or a combination thereof (e.g., an alloy therebetween). The electrode (the first electrode or the second electrode) may include silver and magnesium or an alloy thereof, aluminum and magnesium or an alloy thereof, or a combination thereof. The electrode (the first electrode or the second electrode) may be an electrode that can be formed by thermal evaporation. In an embodiment, the electrode (the first electrode or the second electrode), when a cross-section thereof is observed with an optical microscope or an electron microscope, may exhibit a metal pore and/or a grain boundary. In an embodiment, the electrode (the first electrode or the second electrode), when a cross-section thereof is observed with an optical microscope or an electron microscope, may not exhibit a metal pore and/or a grain boundary.

In the electroluminescent device of an embodiment and the method of manufacturing the same, the second electrode or the thin film conductor may exhibit conductivity sufficient to serve as an electrode, and at the same time, the acid and moisture supplied from the acid material (or the organic layer) may pass through the thin film conductor and reach the electron transport layer including a metal oxide nanoparticle, under the post-treatment conditions described herein. Without wishing to be bound by any theory, it is believed that the acid and the moisture reaching the electron transport layer may modify a surface of the metal oxide nanoparticle, whereby a hydrogen ion (H+) and a hydroxide ion (OH-) may be supplied to the metal oxide nanoparticle in the electron transport layer to passivate a surface defect through a chemical reaction. The inclusion of the post-treated electron transport layer in the electroluminescent device of an embodiment can reduce hole leakage current, which can be confirmed by a lower driving voltage and a higher efficiency of the device than the device prior to the post treatment. The inclusion of the post-treated electron transport layer in the electroluminescent device of an embodiment can increase the hole blocking performance and electron mobility of the electron transport layer, and this can contribute to the improvement of the brightness of the device. The inclusion of the post-treated electron transport layer in the electroluminescent device of an embodiment may alleviate a charging phenomenon at an interface between the light emitting layer and the electron transport layer, and the device of an embodiment may exhibit a reduced interfacial degradation and an increased lifespan.

The light emitting layer (or the emission layer) 3, 30 may be disposed between the first electrode 1 and the second electrode 5 (e.g., the anode 1, 10 and the cathode 5, 50) and may include a semiconductor nanoparticle (e.g., blue light

emitting nanoparticles, red light emitting nanoparticles, green light emitting nanoparticles, or a combination thereof). The light emitting layer may include one or more (e.g., 2 or more or 3 or more and 10 or less) monolayers of the plurality of semiconductor nanoparticles.

The emission layer may be patterned. In an embodiment, the patterned emission layer may include a blue emission layer (e.g., disposed in a blue pixel in a display device described below), a red emission layer (e.g., disposed in a red pixel in a display device described below), a green emission layer (e.g., disposed in a green pixel in a display device described below), or a combination thereof. Each emission layer may be separated from an adjacent emission layer by a partition wall (e.g., optically). In an embodiment, between a red emission layer(s) 30R, a green emission layer(s) 30G, and a blue emission layer(s) 30B, a partition wall or a bank such as a black matrix or a pixel definition layer (PDL) may be disposed (see FIG. 10). In a non-limiting embodiment, the red emission layer, the green emission layer, and the blue emission layer may each be optically substantially isolated.

In an embodiment, the light emitting layer 3, 30 or the semiconductor nanoparticle may not include cadmium. In an embodiment, the light emitting layer 3, 30 or the semiconductor nanoparticle may not include mercury, lead, or a combination thereof.

In an embodiment, the semiconductor nanoparticle may have a core-shell structure. In an embodiment, the semiconductor nanoparticle or the core-shell structure may include a core including a first semiconductor nanocrystal and a shell disposed on the core and including a second semiconductor nanocrystal having a composition different from that of the first semiconductor nanocrystal.

The semiconductor nanoparticle (or the first semiconductor nanocrystal, the second semiconductor nanocrystal, or a combination thereof) may include a Group II-VI compound, a Group III-V compound, a Group IV-VI compound, a Group IV element or compound, a Group I-III-VI compound, a Group II-III-VI compound, a Group I-II-IV-VI compound, or a combination thereof. In an embodiment, the light emitting layer or the semiconductor nanoparticle (e.g., the first semiconductor nanocrystal or the second semiconductor nanocrystal) may not include cadmium. In an embodiment, the light emitting layer or the semiconductor nanoparticle (e.g., the first semiconductor nanocrystal or the second semiconductor nanocrystal) may not include lead. In an embodiment, the light emitting layer or the semiconductor nanoparticle (e.g., the first semiconductor nanocrystal or the second semiconductor nanocrystal) may not include a combination of lead and cadmium.

The Group II-VI compound may be a binary element compound such as ZnS, ZnSe, ZnTe, ZnO, HgS, HgSe, HgTe, MgSe, MgS, or a combination thereof; a ternary element compound such as ZnSeS, ZnSeTe, ZnSTe, HgSeS, HgSeTe, HgSTe, HgZnS, HgZnSe, HgZnTe, MgZnSe, MgZnS, or a combination thereof; a quaternary element compound such as HgZnTeS, HgZnSeS, HgZnSeTe, HgZnSTe, or a combination thereof; or a combination thereof. The Group II-VI compound may further include a Group III metal.

The Group III-V compound may be a binary element compound such as GaN, GaP, GaAs, GaSb, AlN, AlP, AlAs, AlSb, InN, InP, InAs, InSb, or a combination thereof; a ternary element compound such as GaNP, GaNAs, GaNSb, GaPAs, GaPSb, AlNP, AlNAs, AlNSb, AlPAs, AlPSb, InNP, InNAs, InNSb, InPAs, InPSb, or a combination thereof; a quaternary element compound such as GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, or a combination thereof; or a combination thereof. The Group III-V compound may further include a Group II metal (e.g., InZnP).

The Group IV-VI compound may be a binary element compound such as SnS, SnSe, SnTe, PbS, PbSe, PbTe, or a combination thereof; a ternary element compound such as SnSeS, SnSeTe, SnSTe, PbSeS, PbSeTe, PbSTe, SnPbS, SnPbSe, SnPbTe, or a combination thereof; a quaternary element compound such as SnPbSSe, SnPbSeTe, SnPbSTe, or a combination thereof; or a combination thereof.

Examples of the Group I-III-VI compound may be $CuInSe_2$, $CuInS_2$, CuInGaSe, and CuInGaS, but are not limited thereto.

Examples of the Group I-II-IV-VI compound may be CuZnSnSe, and CuZnSnS, but are not limited thereto. Examples of I-III-VI semiconductor compounds may include a ternary element compound such as AgInS, $AgInS_2$, $AgInSe_2$, AgGaS, $AgGaS_2$, $AgGaSe_2$, CulnS, $CuInS_2$, $CuInSe_2$, $CuGaS_2$, $CuGaSe_2$, $CuGaO_2$, $AgGaO_2$, or $AgAlO_2$; a quaternary element compound such as $AgInGaS_2$, $AgInGaSe_2$; or a combination thereof.

Examples of the Group I-II-IV-VI compound include, but are not limited to, CuZnSnSe and CuZnSnS.

The Group IV element or compound may include a single-element such as Si, Ge, or a combination thereof; a binary element compound such as SiC, SiGe, or a combination thereof; or a combination thereof.

Each element included in a multi-element compound such as a binary element compound, a ternary element compound, or a quaternary element compound may be present in the particle at a uniform concentration or at a non-uniform concentration. For example, the chemical formula described above means the types of elements included in the compound, and the stoichiometries among the elements in the compound may be different the recited chemical formula. For example, the chemical formula "$AgInGaS_2$" may include $AgIn_xGa_{1-x}S_2$ (x is a real number of greater than 0 and less than or equal to 1), but is not limited thereto.

In an embodiment, the semiconductor nanoparticle or the first semiconductor nanocrystal may include a metal

including indium, zinc, or a combination thereof and a non-metal including phosphorus, selenium, tellurium, sulfur, or a combination thereof. In an embodiment, the second semiconductor nanocrystal may include a metal including indium, zinc, or a combination thereof, and a non-metal including phosphorus, selenium, tellurium, sulfur, or a combination thereof.

In an embodiment, a first semiconductor nanocrystal may include InP, InZnP, ZnSe, ZnSeS, ZnSeTe, or a combination thereof; the second semiconductor nanocrystal may include ZnSe, ZnSeS, ZnS, ZnTeSe, or a combination thereof. In an embodiment, the shell may include zinc, sulfur, and optionally selenium in the outermost layer.

In an embodiment, the semiconductor nanoparticle may emit blue or green light and may include a core including ZnSeTe, ZnSe, or a combination thereof and a shell including a zinc chalcogenide (e.g., ZnS, ZnSe, ZnSeS, or a combination thereof). An amount of sulfur in the shell may increase or decrease in a radial direction (from the core toward the surface), e.g., the amount of sulfur may have a concentration gradient wherein the concentration of sulfur varies radially (e.g., decreases or increases in a direction toward the core).

In an embodiment, the semiconductor nanoparticle may emit red or green light, the core may include InP, InZnP, or a combination thereof, and the shell may include a Group II metal including zinc and a non-metal including sulfur, selenium, or a combination thereof.

In an embodiment, as the semiconductor nanoparticle has a core-shell structure, on the interface between the core and the shell, an alloyed interlayer may be present or may not be present. The alloyed interlayer layer may include a homogeneous alloy or may have a concentration gradient. The gradient alloy may have a concentration gradient wherein the concentration of an element of the shell varies radially (e.g., decreases or increases in a direction toward the core).

In an embodiment, the shell may have a composition that varies in a radial direction. In an embodiment, the shell may be a multilayered shell including two or more layers. In a multilayered shell, adjacent two layers may have different compositions from each other. In a multilayered shell, a, e.g., at least one, layer may independently include a semiconductor nanocrystal having a single composition. In a multilayered shell, a, e.g., at least one, layer may independently have an alloyed semiconductor nanocrystal. In a multilayered shell, a, e.g., at least one, layer may have a concentration gradient that varies radially in terms of a composition of a semiconductor nanocrystal.

In an embodiment, in a semiconductor nanoparticle having a core-shell structure, a shell material may have a bandgap energy that is larger, e.g., greater, than that of the core. The materials of the shell may have a bandgap energy that is smaller, e.g., less, than that of the core. In the case of a multilayered shell, the bandgap energy of the outermost layer material of the shell may be greater than the bandgap energies of the core and the inner layer material of the shell (layers that are closer to the core). In the case of a multilayered shell, a semiconductor nanocrystal of each layer is selected to have an appropriate bandgap, thereby effectively showing, e.g., exhibiting, a quantum confinement effect.

The semiconductor nanoparticle according to an embodiment may include, for example, an organic ligand which is bonded or coordinated to a surface thereof.

An absorption/emission wavelength of the semiconductor nanoparticle may be controlled by adjusting the compositions, sizes, or a combination thereof of the semiconductor nanoparticle. The semiconductor nanoparticle included in the light emitting layer 3, 30 may be configured to emit light of a desired color. The semiconductor nanoparticle may include a blue light emitting semiconductor nanoparticle, a green light emitting semiconductor nanoparticle, or a red light emitting semiconductor nanoparticle.

In an embodiment, a maximum emission peak wavelength of the semiconductor nanoparticle or a light emission layer (or the light emitted from the electroluminescent device) may be in a wavelength range of from ultraviolet to infrared.

In an embodiment, a maximum emission peak wavelength of the semiconductor nanoparticle or the light emitting layer (or the light emitted from the electroluminescent device) may be greater than or equal to about 300 nm, greater than or equal to about 500 nm, greater than or equal to about 510 nm, greater than or equal to about 520 nm, greater than or equal to about 530 nm, greater than or equal to about 540 nm, greater than or equal to about 550 nm, greater than or equal to about 560 nm, greater than or equal to about 570 nm, greater than or equal to about 580 nm, greater than or equal to about 590 nm, greater than or equal to about 600 nm, or greater than or equal to about 610 nm. The maximum emission peak wavelength of the semiconductor nanoparticle or a light emission layer (or the light emitted from the electroluminescent device) may be less than or equal to about 900 nm, less than or equal to about 800 nm, less than or equal to about 650 nm, less than or equal to about 640 nm, less than or equal to about 630 nm, less than or equal to about 620 nm, less than or equal to about 610 nm, less than or equal to about 600 nm, less than or equal to about 590 nm, less than or equal to about 580 nm, less than or equal to about 570 nm, less than or equal to about 560 nm, less than or equal to about 550 nm, or less than or equal to about 540 nm. The maximum emission peak wavelength of the semiconductor nanoparticle or a light emission layer (or the light emitted from the electroluminescent device) may be in a range of a green light or red light wavelength, for example, in a range of greater than or equal to about 490 nm or greater than or equal to about 500 nm to less than or equal to about 660 nm or less than or equal to about 650 nm.

The semiconductor nanoparticle (or the light emitted from the electroluminescent device) may emit green light (for example, on an application of a voltage or irradiation with light) and a maximum emission peak wavelength thereof may be in the range of greater than or equal to about 500 nm (for example, greater than or equal to about 510 nm, or greater than or equal to about 515 nm) and less than or equal to about 560 nm, for example, less than or equal to about 540 nm. The

semiconductor nanoparticle (or the light emitted from the electroluminescent device) may emit red light, (for example, on an application of voltage or irradiation with light), and a maximum emission peak wavelength thereof may be in the range of greater than or equal to about 600 nm, for example, greater than or equal to about 610 nm and less than or equal to about 650 nm, or less than or equal to about 640 nm.

The semiconductor nanoparticle (or the light emitted from the electroluminescent device) may emit blue light, (for example, on an application of voltage or irradiation with light) and a maximum emission peak wavelength thereof may be greater than or equal to about 430 nm, greater than or equal to about 440 nm (for example, greater than or equal to about 450 nm, greater than or equal to about 455 nm, greater than or equal to about 460 nm, or greater than or equal to about 465 nm) and less than or equal to about 480 nm (for example, less than or equal to about 475 nm, less than or equal to about 470 nm, or less than or equal to about 465 nm).

In an embodiment, the semiconductor nanoparticle may exhibit a luminescent spectrum (e.g., photo- or electroluminescent spectrum) with a relatively narrow full width at half maximum. In an embodiment, in the photo- or electroluminescent spectrum, the semiconductor nanoparticle may exhibit a full width at half maximum of less than or equal to about 45 nm, less than or equal to about 44 nm, less than or equal to about 43 nm, less than or equal to about 42 nm, less than or equal to about 41 nm, less than or equal to about 40 nm, less than or equal to about 39 nm, less than or equal to about 38 nm, less than or equal to about 37 nm, less than or equal to about 36 nm, or less than or equal to about 35 nm. The full width at half maximum may be greater than or equal to about 10 nm, greater than or equal to about 15 nm, greater than or equal to about 20 nm, or greater than or equal to about 25 nm.

The semiconductor nanoparticle may exhibit (or may be configured to exhibit) a quantum efficiency (or quantum yield) of greater than or equal to about 10%, for example, greater than or equal to about 30%, greater than or equal to about 50%, greater than or equal to about 60%, greater than or equal to about 70%, greater than or equal to about 80%, greater than or equal to about 90%, or about 100%.

The semiconductor nanoparticle may have a size (or an average size, hereinafter, at times referred to as "size") of greater than or equal to about 1 nm and less than or equal to about 100 nm. The size may be a diameter or equivalent diameter converted by assuming a spherical shape from an electron microscope image when not spherical. The size may be calculated from a result of an inductively coupled plasma atomic emission spectroscopy (ICP-AES) analysis. In an embodiment, the semiconductor nanoparticle may have a size of from about 1 nm to about 50 nm, for example, from about 2 nm (or about 3 nm) to about 35 nm. In an embodiment, a size (or an average size) of the semiconductor nanoparticle may be greater than or equal to about 3 nm, greater than or equal to about 4 nm, greater than or equal to about 5 nm, greater than or equal to about 6 nm, greater than or equal to about 7 nm, greater than or equal to about 8 nm, greater than or equal to about 9 nm, greater than or equal to about 10 nm, greater than or equal to about 11 nm, or greater than or equal to about 12 nm. In an embodiment, a size (or an average size) of the semiconductor nanoparticle may be less than or equal to about 50 nm, less than or equal to about 40 nm, less than or equal to about 30 nm, less than or equal to about 25 nm, less than or equal to about 20 nm, less than or equal to about 19 nm, less than or equal to about 18 nm, less than or equal to about 17 nm, less than or equal to about 16 nm, less than or equal to about 15 nm, less than or equal to about 14 nm, less than or equal to about 13 nm, or less than or equal to about 12 nm.

The shape of the semiconductor nanoparticle or the semiconductor nanostructure is not particularly limited. For example, the shape of the semiconductor nanoparticle may include, but is not limited to, a sphere, a polyhedron, a pyramid, a multi-pod shape, a hexahedron, a cube, a cuboid, a nanotube, a nanorod, a nanowire, a nanosheet, or a combination thereof.

The semiconductor nanoparticle may be prepared in an appropriate method. The semiconductor nanoparticle may be prepared for example by a chemical wet method wherein a nanocrystal particle may grow by a reaction between precursors in a reaction system including an organic solvent and an organic ligand. The organic ligand or the organic solvent may coordinate (with or to) a surface of the semiconductor nanocrystal to control the growth thereof.

In an embodiment, for example, the method of preparing the semiconductor nanoparticle having a core/shell structure may include obtaining the core; reacting a first shell precursor including a metal (e.g., zinc) and a second shell precursor including a non-metal element (e.g., selenium, sulfur, or a combination thereof) in the presence of the core in a reaction medium including an organic ligand and an organic solvent at a reaction temperature (e.g., of greater than or equal to about 180 °C, greater than or equal to about 200 °C, greater than or equal to about 240 °C, or greater than or equal to about 280 °C and less than or equal to about 360°C, less than or equal to about 340 °C, or less than or equal to about 320 °C) to form a shell including a second semiconductor nanocrystal on a core including a first semiconductor nanocrystal. In the semiconductor nanoparticle of an embodiment, the core may be prepared in an appropriate manner. The method may further include separating a core from a reaction system producing the same and dispersing the core in an organic solvent to obtain a core solution.

In an embodiment, in order to form the shell, a solvent and optionally a ligand compound may be heated at a predetermined temperature (e.g., greater than or equal to about 100 °C) under vacuum (also referred to herein as vacuum-treated) and then, after introducing an inert gas into the reaction vessel, the mixture may be heat-treated again at a predetermined temperature (e.g., greater than or equal to 100 °C). Then, the core and the shell precursors may be added to

the mixture and heated at a reaction temperature. The shell precursors may be added at different ratios during a reaction time simultaneously or sequentially.

In an embodiment, the organic solvent may include a C6 to C22 primary amine such as a hexadecylamine, a C6 to C22 secondary amine such as dioctylamine, a C6 to C40 tertiary amine such as a trioctyl amine, a nitrogen-containing heterocyclic compound such as pyridine, a C6 to C40 olefin such as octadecene, a C6 to C40 aliphatic hydrocarbon such as hexadecane, octadecane, or squalane, an aromatic hydrocarbon substituted with a C6 to C30 alkyl group such as phenyldodecane, phenyltetradecane, or phenyl hexadecane, a primary, secondary, or tertiary phosphine (e.g., trioctyl phosphine) substituted with a, e.g., at least one (e.g., 1, 2, or 3), C6 to C22 alkyl group, a phosphine oxide (e.g., trioctylphosphine oxide) substituted with a (e.g., 1, 2, or 3) C6 to C22 alkyl group, a C12 to C22 aromatic ether such as phenyl ether or benzyl ether, or a combination thereof.

The organic ligand may include RCOOH, $RNH_2$, $R_2NH$, $R_3N$, RSH, $RH_2PO$, $R_2HPO$, $R_3PO$, $RH_2P$, $R_2HP$, $R_3P$, ROH, RCOOR', $RPO(OH)_2$, $R_2POOH$ or a combination thereof. Herein, R and R' are each independently a substituted or unsubstituted, C3 or greater, C6 or greater, or C10 or greater and about C40 or less, C35 or less, or C25 or less, aliphatic hydrocarbon group (e.g., alkyl, alkenyl, alkynyl, etc.), a substituted or unsubstituted C6 to C40 aromatic hydrocarbon group (e.g., aryl group), or a combination thereof. In an embodiment, at least two different organic ligands may be used.

In an embodiment, after completing the reaction (for the formation of the core or for the formation of the shell), a nonsolvent is added to reaction products and a nanoparticle coordinated with the ligand compound may be separated. The nonsolvent may be a polar solvent that is miscible with the solvent used in the core formation reactions, shell formation reaction, or a combination thereof and is not capable of dispersing the prepared nanocrystals. The nonsolvent may be selected depending on the solvent used in the reaction and may include, for example, acetone, ethanol, butanol, isopropanol, ethanediol, water, tetrahydrofuran (THF), dimethylsulfoxide (DMSO), diethylether, formaldehyde, acetaldehyde, a solvent having a similar solubility parameter to the foregoing non-solvents, or a combination thereof. The semiconductor nanocrystal particles may be separated through centrifugation, sedimentation, or chromatography. The separated nanocrystals may be washed with a washing solvent, if desired. The washing solvent has no particular limit and may have a similar solubility parameter to that of the ligand and may, for example, include hexane, heptane, octane, chloroform, toluene, benzene, and the like.

The semiconductor nanoparticles of an embodiment may be non-dispersible or insoluble in water, the aforementioned nonsolvent, or a combination thereof. The semiconductor nanoparticles of an embodiment may be dispersed in the aforementioned organic solvent. In an embodiment, the aforementioned semiconductor nanoparticles may be dispersed in a substituted or unsubstituted C6 to C40 aliphatic hydrocarbon, a substituted or unsubstituted C6 to C40 aromatic hydrocarbon, or a combination thereof.

The prepared semiconductor nanoparticles may be treated with a halogen compound. By the treatment with the halogen compound, at least a portion of the organic ligand may be replaced with the halogen. The halogen treated semiconductor nanoparticles may include a reduced amount of the organic ligand. The halogen treatment may be carried out contacting the semiconductor nanoparticles with the halogen compound (e.g., a metal halide such as a zinc chloride) at a predetermined temperature of from about 30 °C to about 100 °C or from about 50 °C to about 150 °C in an organic solvent. The halogen-treated semiconductor nanoparticles may be separated using the non-solvent described above.

In the light emitting device or the display device of an embodiment, a thickness of the light emitting layer may be appropriately selected. In an embodiment, the light emitting layer may include a monolayer of nanoparticles. In an embodiment, the light emitting layer may include one or more, for example, two or more, three or more, or four or more and 20 or less, 10 or less, 9 or less, 8 or less, 7 or less, or 6 or less monolayers of nanoparticles. The light emitting layer may have a thickness of greater than or equal to about 5nm, for example, greater than or equal to about 10 nm, greater than or equal to about 20 nm, or greater than or equal to about 30 nm and less than or equal to about 200 nm, less than or equal to about 150 nm, less than or equal to about 100 nm, less than or equal to about 90 nm, less than or equal to about 80 nm, less than or equal to about 70 nm, less than or equal to about 60 nm, or less than or equal to about 50 nm. The light emitting layer may have a thickness of, for example, about 10 nm to about 150 nm, about 20 nm to about 100 nm, or about 30 nm to about 50 nm.

In an embodiment, the forming of the light emitting layer including the semiconductor nanoparticles may be performed by obtaining a coating liquid including semiconductor nanoparticles and an organic solvent (e.g., an alkane solvent such as octane, heptane, or the like, an aromatic solvent such as toluene, or a combination thereof) and applying or depositing the coating liquid on a substrate or charge auxiliary layer (e.g., a hole auxiliary layer) in an appropriate manner (e.g., by spin coating, inkjet printing, etc.). A type of the organic solvent for the coating liquid is not particularly limited and may be selected appropriately. In an embodiment, the organic solvent may include a substituted or unsubstituted aliphatic hydrocarbon, a substituted or unsubstituted aromatic hydrocarbon, a substituted or unsubstituted alicyclic hydrocarbon, an acetate solvent, or a combination thereof.

In an embodiment, the formation of the light emitting layer may further include contacting the film of the semiconductor nanoparticles with a metal halide (e.g., a zinc chloride)-containing organic solution (e.g., including an alcohol solvent). In an embodiment, the light emitting layer may include a first light emitting layer including a first

semiconductor nanoparticle and a second light emitting layer including a second semiconductor nanoparticle, wherein the first semiconductor nanoparticle has a halogen (e.g., chlorine) exchanged surface and the second light emitting layer has an increased amount of an organic ligand. A halogen (e.g., chlorine) amount and an organic ligand amount of the light emitting layer may be controlled with an appropriate manner (e.g., a post treatment for the formed layer). In an embodiment, a thin film of the semiconductor nanoparticles having an organic ligand (e.g., having a carboxylic acid group) is formed, which is then treated with a solution including a metal halide (e.g., a zinc halide such as a zinc chloride in alcohol solvent) to control an amount of the organic ligand of the semiconductor nanoparticles in the thin film. The treated thin film may have an increased halogen amount, showing, e.g., exhibiting, a changed property (e.g., solubility) to, e.g., relative to, an organic solvent, and it may be possible to form a layer of semiconductor nanoparticles having a different amount of an organic ligand (e.g., a halogen treated semiconductor nanoparticle or a semiconductor nanoparticle with a ligand having a carboxylic acid group) on the treated thin film, subsequently.

In an embodiment, the light emitting layer may be a single layer or a multi-layered structure having at least two layers. In a multi-layered structure, adjacent layers (e.g., a first light emitting layer and a second light emitting layer) may be configured to emit a first light (e.g., green light, blue light, or red light). In a multi-layered structure, adjacent layers (e.g., a first light emitting layer and a second light emitting layer) may have the same or different composition, ligands, or a combination thereof. In an embodiment, the (multi-layered) light emitting layer may exhibit a halogen content that varies (increase or decrease) in a thickness direction. In an embodiment, in the (multi-layered) light emitting layer, the amount of the halogen may increase in a direction toward the electron auxiliary layer. In the (multi-layered) light emitting layer, the amount of the organic ligand may decrease in a direction toward the electron auxiliary layer. In the (multi-layered) light emitting layer, the content of the organic ligand may increase in a direction toward the electron auxiliary layer.

In an embodiment, the light emitting layer thus formed (or treated with the halogen solution) may be washed water or an organic washing solvent (an organic solvent miscible with the water). A manner of the washing is not particularly limited and may be conducted by a spin and dry, a dipping, or a combination thereof.

The light emitting layer may be heat-treated. The heat treating may be carried out in air or in an inert gas atmosphere. A temperature of the heat treating may be greater than or equal to about 50 °C, greater than or equal to about 70 °C, greater than or equal to about 90 °C, greater than or equal to about 100 °C, greater than or equal to about 120 °C, greater than or equal to about 150 °C, greater than or equal to about 170 °C, or greater than or equal to about 200 °C. A temperature of the heat treating may be less than or equal to about 250 °C, less than or equal to about 230 °C, less than or equal to about 200 °C, less than or equal to about 180 °C, less than or equal to about 160 °C, less than or equal to about 140 °C, or less than or equal to about 130 °C.

A hole auxiliary layer 2 may be disposed between the emission layer 3 and the first electrode 1. The hole auxiliary layer includes a hole injection/transport material and a base quencher. The hole injection/transport material may be a material configured to perform injection of holes into the emission layer, transport of holes, or both injection and transport of holes. For example, the hole auxiliary layer may include a hole injection layer 2b including a hole injection material (or a hole injection/transport material), a hole transport layer 2a including a hole transport material (or a hole injection/transport material), or both thereof. In an embodiment, the hole injection layer may be disposed between the first electrode and the hole transport layer (see FIG. 1C, FIG. 1E, and FIG. 1F).

The hole injection/transport material may be a material that exhibits a post-heat-treatment current density of less than or equal to about 80% of a pre-heat-treatment current density when subjected to heat treatment under the following conditions:

A stacked structure including a hole auxiliary layer having a thickness of greater than or equal to about 120 nm and less than or equal to about 150 nm, and including the hole transport material between a Ag-containing anode and a Ag-containing cathode is left for 24 hours together with an aqueous solution of a polyacrylic acid having a weight average molecular weight of greater than or equal to about 100,000 g/mole and less than or equal to about 500,000 g/mole in a sealed space at 70 °C.

The current density after the heat treatment may be less than or equal to about 75%, less than or equal to about 65%, less than or equal to about 55%, less than or equal to about 50%, less than or equal to about 45%, less than or equal to about 40%, less than or equal to about 35%, less than or equal to about 30%, or less than or equal to about 25% of the current density before the heat treatment. Such a decrease in the current density may suggest an increase in resistance of a hole transport material or a hole auxiliary layer.

The hole injection/transport material may include a compound represented by Chemical formula 1, a polymer including a repeating unit represented by Chemical formula 2 in a main chain, a polymer including a repeating unit represented by Chemical formula 2a in a main chain, a polymer including a repeating unit represented by Chemical formula 3 in a main chain, a copolymer including a repeating unit represented by Chemical formula 2 and a repeating unit represented by Chemical formula 3 in a main chain, a polyvinylcarbazole, or a combination thereof.

Chemical formula 1

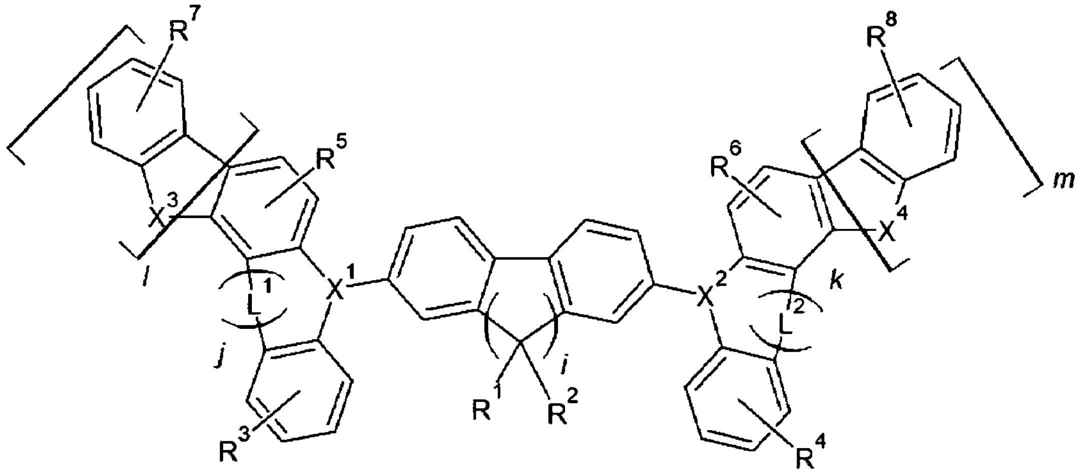

In Chemical formula 1, each $R^1$ to $R^8$ are each independently hydrogen, a substituted or unsubstituted C1 to C40 or C3 to C20 alkyl group, a substituted or unsubstituted C2 to C40 or C3 to C20 alkenyl group, a substituted or unsubstituted C2 to C40 or C3 to C20 alkynyl group, a substituted or unsubstituted C3 to C20 cycloalkyl group, a substituted or unsubstituted C6 to C20 aryl group, a substituted or unsubstituted C3 to C20 heteroaryl group, a substituted or unsubstituted alkylamine group, a substituted or unsubstituted arylamine group, a substituted or unsubstituted carbazolyl group, or a combination thereof.,

$X^1$ and $X^2$ are each independently N or C(-$R^a$),
$X^3$ and $X^4$ are each independently S, N- $R^b$, or C(-$R^c$)(- $R^d$),
wherein $R^a$, $R^b$, $R^c$, and $R^d$ are each independently hydrogen, a substituted or unsubstituted C1 to C20 or C2 to C15 alkyl group, a substituted or unsubstituted C2 to C20 or C3 to C15 alkenyl group, a substituted or unsubstituted C3 to C20 cycloalkyl group, a substituted or unsubstituted C6 to C20 aryl group, a substituted or unsubstituted C3 to C20 heteroaryl group, or a combination thereof,
$L^1$ and $L^2$ are each independently a single bond, a substituted or unsubstituted C1 to C4 alkylene group, a substituted or unsubstituted C1 to C4 alkenylene group, or a combination thereof, and
i, j, k, l, and m are each independently 0 or 1.

Chemical formula 2

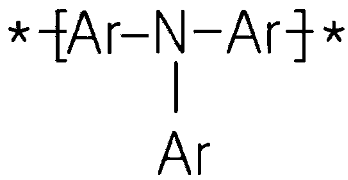

Chemical formula 2a

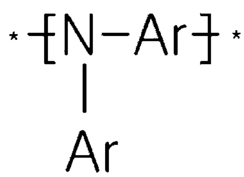

in Chemical formula 2 and Chemical formula 2a, each Ar is the same or different, and each is independently a substituted or unsubstituted C6 to C24 aromatic hydrocarbon group (an aromatic ring), and * is a portion connected to an adjacent atom or an adjacent repeating unit;

Chemical Formula 3

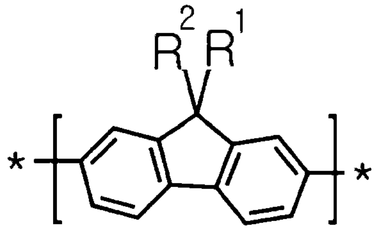

In Chemical formula 3, $R^1$ and $R^2$ are each independently hydrogen, a substituted or unsubstituted C1 to C40 or C3 to C20 alkyl group, a substituted or unsubstituted C2 to C40 or C3 to C20 alkenyl group, a substituted or unsubstituted C2 to C40 or C3 to C20 alkynyl group, a substituted or unsubstituted C3 to C20 cycloalkyl group, a substituted or unsubstituted C6 to C20 aryl group, a substituted or unsubstituted C3 to C20 heteroaryl group, a substituted or unsubstituted alkylamine group, a substituted or unsubstituted arylamine group, a substituted or unsubstituted carbazolyl group, or a combination thereof, and * is a portion connected to an adjacent atom or an adjacent repeating unit.

Although not shown in the Chemical formulas, an aromatic ring may further include any substituent, and the substituent is as defined herein. Herein, the aromatic ring may include both a case including a heteroatom and a case consisting of carbon.

The hole injection/transport material may include a compound represented by Chemical formula 1-1, a compound represented by Chemical formula 1-2, a compound represented by Chemical formula 1-3, a polymer including a repeating unit represented by Chemical formula 2-1, polyvinylcarbazole, or a combination thereof.

Chemical Formula 1-1

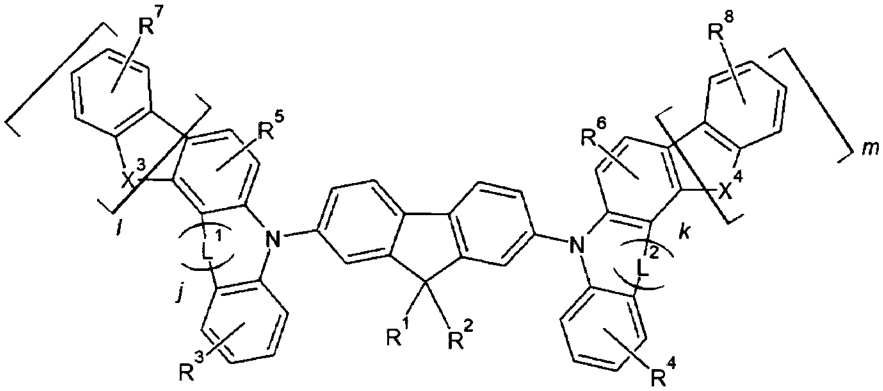

$R^1$ to $R^8$, $X^3$, $X^4$, $L^1$, $L^2$, j, k, l, and m are the same as those defined in Chemical formula 1.

Chemical Formula 1-2

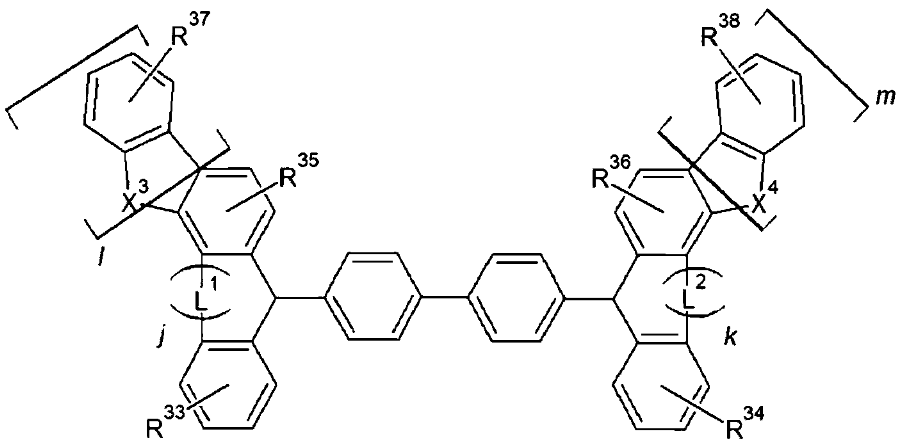

Chemical Formula 1-3

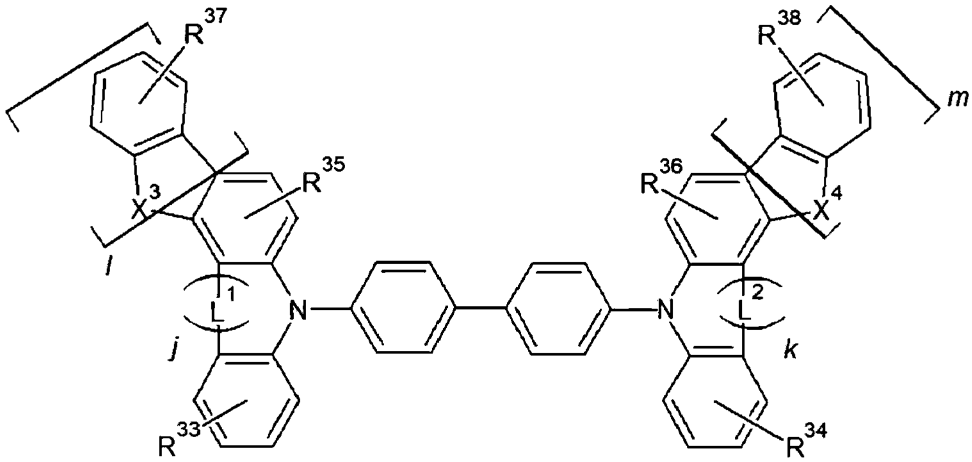

$X^3$, $X^4$, $L^1$, $L^2$, j, k, l, and m are the same as those defined in Chemical formula 1.

$R^{33}$, $R^{34}$, $R^{35}$, $R^{36}$, $R^{37}$, and $R^{38}$ are each independently hydrogen, a substituted or unsubstituted C1 to C40 or C3 to C20 alkyl group, a substituted or unsubstituted C2 to C40 or C3 to C20 alkenyl group, a substituted or unsubstituted C2 to C40 or C3 to C20 alkynyl group, a substituted or unsubstituted C3 to C20 cycloalkyl group, a substituted or unsubstituted C6 to C20 aryl group, a substituted or unsubstituted C3 to C20 heteroaryl group, a substituted or unsubstituted alkylamine group, a substituted or unsubstituted arylamine group, a substituted or unsubstituted carbazolyl group, or a combination thereof.

Chemical Formula 2-1

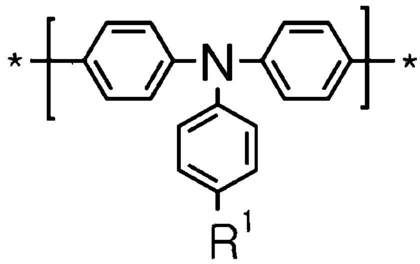

$R^1$ is independently hydrogen, a substituted or unsubstituted C1 to C40 or C3 to C20 alkyl group, a substituted or unsubstituted C2 to C40 or C3 to C20 alkenyl group, a substituted or unsubstituted C2 to C40 or C3 to C20 alkynyl group, a substituted or unsubstituted C3 to C20 cycloalkyl group, a substituted or unsubstituted C6 to C20 aryl group, a substituted or unsubstituted C3 to C20 heteroaryl group, a substituted or unsubstituted alkylamine group, a substituted or unsubstituted arylamine group, a substituted or unsubstituted carbazolyl group, or a combination thereof, and * is a portion connected to an adjacent atom or an adjacent repeating unit.

In the Chemical formulas, when at least one of $R^3$ to $R^8$ is a substituted or unsubstituted C3 to C20 cycloalkyl group, a substituted or unsubstituted C6 to C20 aryl group, or a substituted or unsubstituted C3 to C20 heteroaryl group, each may independently form or may not form a C8 to C15 fused ring by being fused with an adjacent aromatic ring. In the Chemical formulas, the aromatic ring may further include a substituent or may not include any substituent. The definition of the substituent is as described herein.

The hole injection/transport material or the compound represented by Chemical formula 1-1 may include at least one selected from among compounds represented by Chemical formula 1-1-1 to Chemical formula 1-1-2.

Chemical Formula 1-1-1

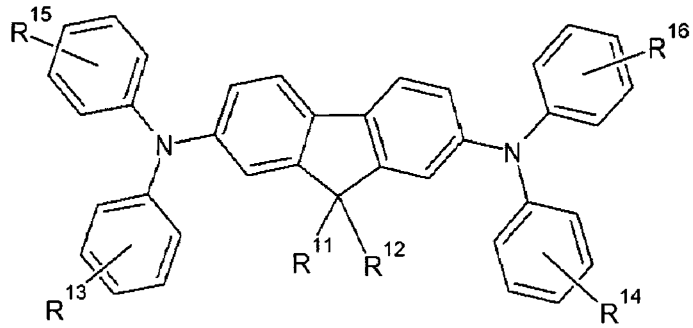

Chemical Formula 1-1-2

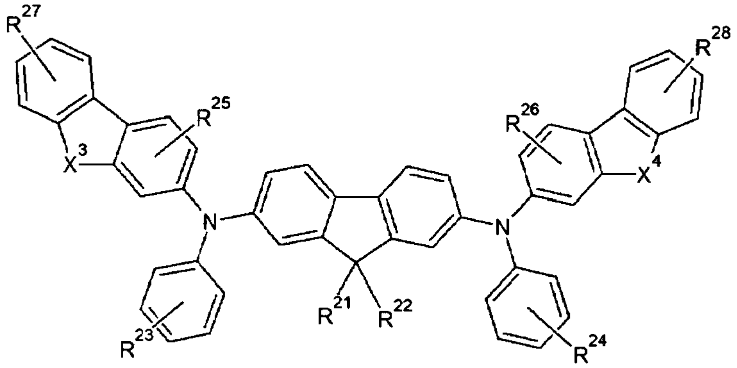

In Chemical formula 1-1-1 to Chemical formula 1-1-2,

$X^3$ and $X^4$ are the same as defined in Chemical formula 1, and
$R^{11}$, $R^{12}$, $R^{13}$, $R^{14}$, $R^{21}$, $R^{22}$, $R^{23}$, $R^{24}$, $R^{25}$, and $R^{26}$ are each independently hydrogen, a substituted or unsubstituted C1 to C40 or C3 to C20 alkyl group, a substituted or unsubstituted C2 to C40 or C3 to C20 alkenyl group, a substituted or unsubstituted C2 to C40 or C3 to C20 alkynyl group, a substituted or unsubstituted C3 to C20 cycloalkyl group, a substituted or unsubstituted C6 to C20 aryl group, a substituted or unsubstituted C3 to C20 heteroaryl group, a substituted or unsubstituted alkylamine group, a substituted or unsubstituted arylamine group, a substituted or unsubstituted carbazolyl group, or a combination thereof, and
$R^{27}$ and $R^{28}$ are each independently hydrogen, a substituted or unsubstituted C1 to C40 or C3 to C20 alkyl group, a substituted or unsubstituted alkylamine group, a substituted or unsubstituted arylamine group, a substituted or unsubstituted carbazolyl group, or a combination thereof.

In the Chemical formulas, when at least one of $R^{13}$, $R^{14}$, $R^{15}$, $R^{16}$, $R^{23}$, $R^{24}$, $R^{25}$, and/or $R^{26}$ is selected from a substituted or unsubstituted C3 to C20 cycloalkyl group, a substituted or unsubstituted C6 to C20 aryl group, or a substituted or unsubstituted C3 to C20 heteroaryl group, it may independently form (or may not form) a C8 to C15 fused ring by being fused with an adjacent aromatic ring.

The hole injection/transport material or the compound represented by Chemical formula 1-3 may include a compound represented by Chemical formula 1-3-1, a compound represented by Chemical formula 1-3-2, a compound represented by Chemical formula 1-3-3 or a combination thereof.

Chemical Formula 1-3-1

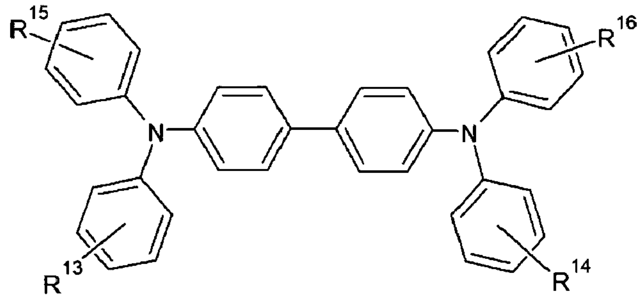

Chemical Formula 1-3-2

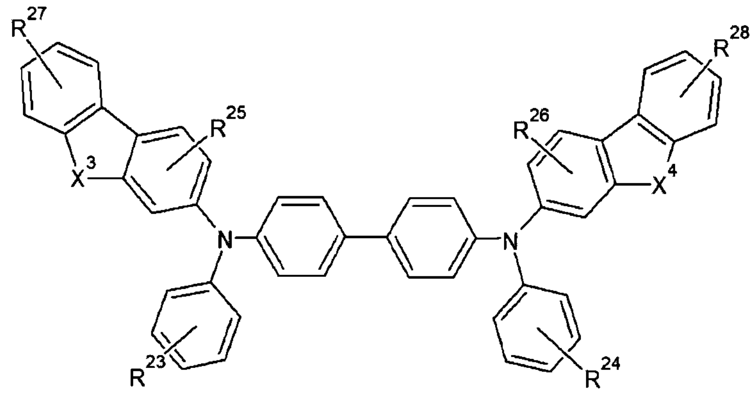

Chemical Formula 1-3-3

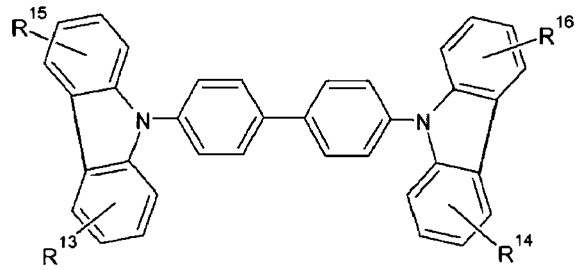

In Chemical formulas above,

$R^{13}$, $R^{14}$, $R^{15}$, $R^{16}$, $R^{21}$, $R^{22}$, $R^{23}$, $R^{24}$, $R^{25}$, and $R^{26}$ are each independently hydrogen, a substituted or unsubstituted C1 to C40 or C3 to C20 alkyl group, a substituted or unsubstituted C2 to C40 or C3 to C20 alkenyl group, a substituted or unsubstituted C2 to C40 or C3 to C20 alkynyl group, a substituted or unsubstituted C3 to C20 cycloalkyl group, a substituted or unsubstituted C6 to C20 aryl group, a substituted or unsubstituted C3 to C20 heteroaryl group, a substituted or unsubstituted alkylamine group, a substituted or unsubstituted arylamine group, a substituted or unsubstituted carbazolyl group, or a combination thereof,

$R^{27}$ and $R^{28}$ are each independently hydrogen, a substituted or unsubstituted C1 to C20 alkyl group, a substituted or unsubstituted C2 to C20 alkenyl group, a substituted or unsubstituted C3 to C20 cycloalkyl group, a substituted or unsubstituted C6 to C20 aryl group, a substituted or unsubstituted C3 to C20 heteroaryl group, a substituted or unsubstituted alkylamine group, a substituted or unsubstituted arylamine group, a substituted or unsubstituted carbazolyl group, or a combination thereof.

When at least one of $R^{13}$, $R^{14}$, $R^{15}$, $R^{16}$, $R^{23}$, $R^{24}$, $R^{25}$, and $R^{26}$ is any one of a substituted or unsubstituted C3 to C20 cycloalkyl group, a substituted or unsubstituted C6 to C20 aryl group, or a substituted or unsubstituted C3 to C20 heteroaryl group, each may independently fuse with an adjacent aromatic ring to form or may not form a C8 to C15 fused ring.

The hole injection/transport material may include one or more selected from among compounds represented by

Chemical formula A to Chemical formula F.

Chemical Formula A

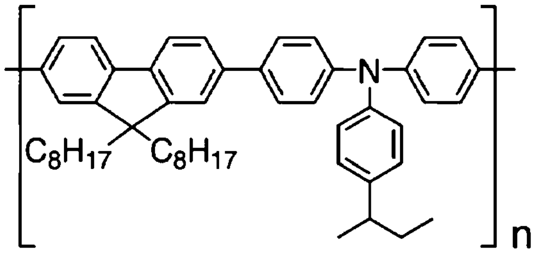

Chemical Formula B

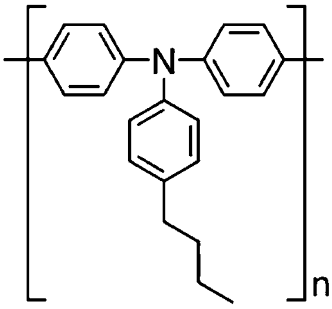

Chemical Formula C

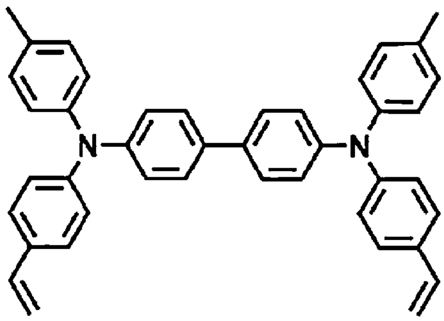

Chemical Formula D

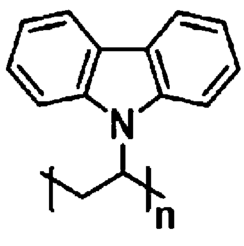

Chemical Formula F

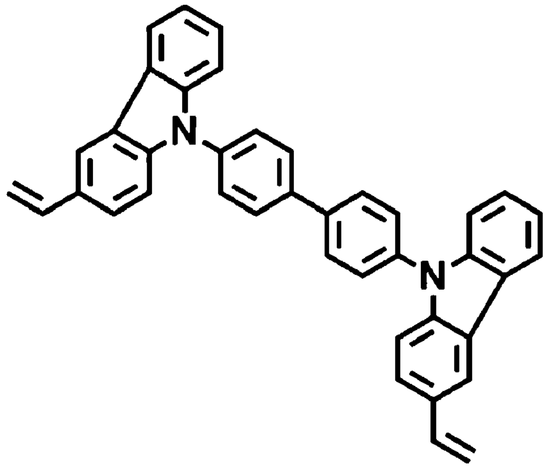

In the above formulas, n is a number representing a degree of polymerization of a polymer and may be determined according to an average molecular weight.

When the hole injection/transport material is a polymer, a molecular weight of the polymer may be appropriately selected and is not particularly limited. In an embodiment, a molecular weight of the polymer may be greater than or equal to about 10,000 g/mole and less than or equal to about 1,000,000 g/mole, greater than or equal to about 50,000 g/mole and less than or equal to about 500,000 g/mole, greater than or equal to about 70,000 g/mole and less than or equal to about 700,000 g/mole, greater than or equal to about 90,000 g/mole and less than or equal to about 500,000 g/mole, or greater than or equal to about 100,000 g/mole and less than or equal to about 450,000 g/mole, but is not limited thereto.

The hole injection/transport material may exhibit a property (e.g., vapor pressure, viscosity, water contact angle, surface tension, etc.) suitable for forming a hole auxiliary layer by an inkjet printing method.

The hole injection/transport material may further include a p-type dopant. The hole injection/transport material or the p-type dopant may include a quinone derivative, a cyano group-containing compound, a boron-containing compound, or a combination thereof. In an embodiment, the p-type dopant may include a quinone derivative such as TCNQ (tetracyanoquinodimethane), F4-TCNQ (2,3,5,6-tetrafluoro-7,7,8,8-tetracyanoquinodimethane), F6-TCNNQ(1,3,4,5,7,8-Hexafluorotetracyano-naphthoquinodimethane), or a combination thereof; HAT-CN (1,4,5,8,9,12-hexaazatriphenylene-hexacarbonitrile); ; a borate salt compound; or a combination thereof. In an embodiment, the borate salt compound may include a borate anion having a pentafluorophenyl group. The borate salt compound may include 4-isopropyl-4'-methyldiphenyliodonium tetrakis(pentafluorophenyl)borate (PIPB) represented by the following chemical formula.

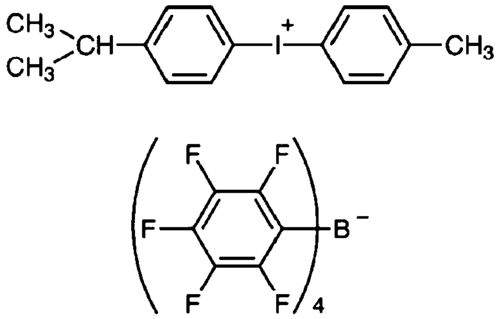

The hole auxiliary layer (e.g., a hole injection layer or a hole transport layer) of an embodiment may further include a base quencher together with the hole injection/transport material and optionally a p-type dopant. In an electroluminescent device including a semiconductor nanoparticle as a light emitting material, an electron transport layer including metal oxide nanoparticles may be improved by post-treatment of the device using acid/moisture, which is referred to as positive aging. The positive aging can increase the performance of the electroluminescent device to a desired level. However, the present inventors have found that, while the post-treatment provides the effect of positive aging in an electroluminescent device manufactured by spin coating, it may provide a detrimental effect of significantly decreasing electroluminescent properties (i.e., negative aging) in a device, for example, manufactured by an inkjet printing method.

In addition, the present inventors have found that such negative aging is related to the hole auxiliary layer in the

electroluminescent device. Without wishing to be bound by any theory, this is considered to be because acid and moisture used in the post-treatment can diffuse into the electroluminescent device and reach the hole auxiliary layer after passing through the electron transport layer and the emission layer. The diffusion of post-treatment components may deteriorate electrical properties of the hole auxiliary layer (e.g., the hole transport layer). As a result, upon application of a predetermined voltage, a current density of the hole auxiliary layer (or the hole transport layer) may be significantly reduced. Such a decrease in current density of the hole auxiliary layer (e.g., the hole injection layer (HIL) or the hole transport layer (HTL)) means that resistance of these layers is increased, which may not only increase a driving voltage of the device as a whole, but also degrade hole injection characteristics, thereby decreasing light emission efficiency of the device and reducing device lifetime.

The light emitting device of an embodiment includes a basic quencher or a protective layer including the same within the device, for example, in the hole auxiliary layer. Accordingly, the base quencher can effectively block acid components that can otherwise diffuse from an upper portion of the device during a post-treatment process, thereby preventing deterioration of the hole injection and transport layers. In the electroluminescent device of an embodiment, a hole injection/transport material in the hole auxiliary layer (e.g., the hole transport material described herein) may exhibit a property (e.g., viscosity, surface tension, vapor pressure, flowability, etc.) capable of providing the hole auxiliary layer through a solution process.

Meanwhile, the poly(3,4-ethylenedioxythiophene):polystyrene sulfonate (PEDOT:PSS) and poly(3,4-ethylenedioxythiophene) (PEDOT) can be processed into a hole auxiliary layer via a spin coating method, and the positive aging effect may be obtained by a post-treatment process. However, due to low viscosity, it is technically difficult for the PEDOT:PSS and PEDOT to form a hole auxiliary layer by an inkjet printing process. In an embodiment, for example, the hole injection/transport material described herein may be a partially doped polymer in which a p-dopant is added to a polymer chain to secure conductivity, and such a hole injection/transport material may be dissolved in an appropriate solvent (e.g., a solvent having a relatively high viscosity or an inkjet-printing solvent such as cyclohexyl benzene) to form an ink composition for an inkjet printing. In an embodiment, for example, the hole injection/transport material described herein may include a non-polymeric organic compound and a dopant (e.g., a p-dopant), and may be dissolved in an appropriate solvent (e.g., a solvent having a relatively high viscosity or an inkjet-printing solvent such as cyclohexyl benzene) to form an ink composition for an inkjet printing.

In an embodiment, the electroluminescent device includes a hole auxiliary layer that is formed by an inkjet printing process, the hole auxiliary layer including a base quencher or a protective layer including the base quencher. As a result, even during or following a subsequent post-treatment (e.g., placing the device in a container including acid/moisture and exposing the device to a high-temperature environment of greater than or equal to about 70 °C for several hours), it is possible to suppress or prevent deterioration of a p-dopant included in an ink composition for forming the hole auxiliary layer by an acid component from a host material. Accordingly, a decrease in conductivity of the hole auxiliary layer can be minimized or even avoided due to the inclusion of the basic quencher or an auxiliary layer including the base quencher. Accordingly, the hole auxiliary layer of an embodiment can minimize a damage or a negative aging that may otherwise occur during the post-treatment. Without wishing to be bound by any theory, it is believed that the base quencher included in the hole auxiliary layer as described herein can effectively prevent acid components diffused from an upper portion of the device during a post-process from adversely affecting the hole injection/transport material or a p-dopant included in the hole auxiliary layer, without interfering with hole injection/transport.

The base quencher included in the hole auxiliary layer of an embodiment includes an alkali metal hydroxide, an alkaline earth metal hydroxide, an ammonium hydroxide compound, an amine compound, or a combination thereof.

The alkali metal hydroxide may include a lithium hydroxide, a sodium hydroxide, a potassium hydroxide, a cesium hydroxide, a rubidium hydroxide, or a combination thereof. The ammonium hydroxide compound may include a tetraalkylammonium hydroxide.

The amine compound may include a substituted or unsubstituted aliphatic amine compound, a substituted or unsubstituted aliphatic cyclic amine compound, or a combination thereof. The aliphatic amine compound may include a substituted or unsubstituted C1 to C30 aliphatic primary amine, a substituted or unsubstituted C1 to C30 aliphatic secondary amine, a substituted or unsubstituted C1 to C30 aliphatic tertiary amine, or a combination thereof. The aliphatic amine compound may include trihexylamine, trioctylamine, tridecylamine, tridodecylamine, or triethanolamine.

The cyclic amine compound may include a piperidine compound, a pyrrolidone compound, a diazacycloalkene compound, or a combination thereof. The cyclic compound may include, but is not limited to, piperidineethanol, piperidinopropanediol, pyridine, or the like.

In an embodiment, the hole auxiliary layer includes a first surface facing the emission layer and a second surface opposite the first surface, and the base quencher may have a concentration distribution, for example, a gradient or relatively constant concentration distribution, within the hole auxiliary layer. The term "gradient" in this context may refer to a continuous gradient or a step-wise gradient in a thickness direction of the hole auxiliary layer. In an embodiment, the base quencher may be present on at least a portion of the first surface.

Within the hole auxiliary layer 2, a concentration of the base quencher may increase toward a first surface of the

hole auxiliary layer. See, FIG. 1A, and shading of hole auxiliary layer 2. As indicated, in the hole auxiliary layer 2, a concentration of the base quencher in a portion adjacent to the first surface, i.e., the surface adjacent emission layer 3, may be greater than that in a portion adjacent to the second surface opposite the first surface. In an embodiment, the concentration of the base quencher within the hole auxiliary layer may increase from the second surface and then decrease at some point in the thickness direction of layer toward the first surface. (see FIG. 1B) As indicated in FIG. 1C, the hole auxiliary layer may include a hole transport layer 2a and a hole injection layer 2b, and the base quencher may be included in the hole transport layer. As indicated in FIG. 1F, the base quencher may also be included in the hole injection layer. In an embodiment, the base quencher may be predominantly distributed at an interface between the hole transport layer 2a and the hole injection layer 2b (see FIG. 1F). In FIGS. 1A to 1F, gradation represents a concentration of the base quencher, wherein a darker portion may indicate a higher concentration, and a lighter portion may indicate a lower concentration. In an embodiment, the base quencher may be distributed throughout an entire cross section of the layer or may be present only in a portion thereof (FIGS. 1D, 1E, and 1F). For example, as indicated in FIG. 1D or FIG. 1E, the base quencher may be predominantly distributed on a first surface of the hole transport layer 2a or the hole auxiliary layer 2 (i.e., a surface facing the emission layer 3) and may be substantially absent on a second surface (a surface opposite to the first surface).

The hole auxiliary layer may include a protective layer including the base quencher. The hole auxiliary layer may include a protective layer consisting of the base quencher, i.e., a base quencher protective layer. The hole transport layer may be disposed between the protective layer and the hole injection layer. In an embodiment, the protective layer may be disposed between the hole transport layer and the hole injection layer. The protective layer may be disposed on the first surface of the hole auxiliary layer 2, 20. The base quencher or the protective layer may be disposed between the emission layer and the hole transport layer (see FIGS. 2A to 2C).

The protective layer may be in a form of a continuous film or a discontinuous film.

In an embodiment, a concentration of a base quencher in a hole auxiliary layer or a thickness of the protective layer may be adjusted to an extent that does not interfere with hole transport.

In the hole auxiliary layer, the concentration of the base quencher, based on a total number of moles of elements in the hole auxiliary layer or based on carbon, may be greater than or equal to about 0.0001%, greater than or equal to about 0.001%, greater than or equal to about 0.005%, greater than or equal to about 0.01%, greater than or equal to about 0.05%, greater than or equal to about 0.1%, greater than or equal to about 0.5%, greater than or equal to about 1%, greater than or equal to about 1.5%, greater than or equal to about 2%, greater than or equal to about 2.5%, greater than or equal to about 3%, greater than or equal to about 3.5%, greater than or equal to about 4%, greater than or equal to about 4.5%, greater than or equal to about 5%, greater than or equal to about 5.5%, greater than or equal to about 6%, greater than or equal to about 6.5%, greater than or equal to about 7%, greater than or equal to about 7.5%, greater than or equal to about 8%, greater than or equal to about 8.5%, greater than or equal to about 9%, greater than or equal to about 9.5%, greater than or equal to about 10%, and/or less than or equal to about 25%, less than or equal to about 24.5%, less than or equal to about 24%, less than or equal to about 23.5%, less than or equal to about 23%, less than or equal to about 22.5%, less than or equal to about 22%, less than or equal to about 21.5%, less than or equal to about 21%, less than or equal to about 20.5%, less than or equal to about 20%, less than or equal to about 19.5%, less than or equal to about 19%, less than or equal to about 18.5%, less than or equal to about 18%, less than or equal to about 17.5%, less than or equal to about 17%, less than or equal to about 16.5%, less than or equal to about 16%, less than or equal to about 15.5%, less than or equal to about 15%, less than or equal to about 14.5%, less than or equal to about 14%, less than or equal to about 13.5%, less than or equal to about 13%, less than or equal to about 12.5%, less than or equal to about 12%, less than or equal to about 11.5%, less than or equal to about 11%, less than or equal to about 10.5%, less than or equal to about 10%, less than or equal to about 9.5%, less than or equal to about 9%, less than or equal to about 8.5%, less than or equal to about 8%, less than or equal to about 7.5%, less than or equal to about 7%, less than or equal to about 6.5%, less than or equal to about 6%, less than or equal to about 5.5%, less than or equal to about 5%, less than or equal to about 4.5%, less than or equal to about 4%, less than or equal to about 3.5%, less than or equal to about 3%, less than or equal to about 2.5%, less than or equal to about 2%, less than or equal to about 1.5%, or less than or equal to about 1%.

In an embodiment, the thickness of the base quencher protective layer may be less than or equal to about 10 nm, less than or equal to about 9 nm, less than or equal to about 8 nm, less than or equal to about 7 nm, less than or equal to about 6 nm, less than or equal to about 5 nm, less than or equal to about 4 nm, or less than or equal to about 3 nm. In an embodiment, the thickness of the protective layer may be greater than or equal to about 0.5 nm, greater than or equal to about 1 nm, or greater than or equal to about 1.5 nm.

The hole auxiliary layer may further include an element derived from the base quencher. In an embodiment, the base quencher may include cesium hydroxide, rubidium hydroxide, or a combination thereof. Accordingly, the hole auxiliary layer may include cesium, rubidium, or a combination thereof. In the hole auxiliary layer, the presence of cesium or rubidium may be identified and determined by XPS or other appropriate detection means. In an embodiment, the base quencher may include or may not include sodium hydroxide, potassium hydroxide, or a combination thereof.

In an embodiment, the electroluminescent device may not include a carbon particle between the hole auxiliary

layer and the emission layer. In an embodiment of the electroluminescent device, the emission layer may be in contact with the hole auxiliary layer (or the base quencher protective layer included therein). The emission layer may be in contact with base quencher protective layer. The emission layer may be in contact with a hole transporting layer.

In an embodiment, a hole auxiliary layer may further include, in addition to the layer of the hole injection/transport material, an additional hole injection layer and/or hole transport layer. The type of the additional hole injection layer and/or hole transport layer is not particularly limited and may be appropriately selected. In an embodiment, a material included in the additional hole injection layer and/or hole transport layer may include a p-type semiconductor material or a material doped with a p-type dopant. Examples of the hole injection layer include a PEDOT [poly(3,4-ethylenedioxythiophene)] derivative, a PSS [poly(styrene sulfonate)] derivative, a poly-N-vinylcarbazole (PVK) derivative, a polyphenylenevinylene derivative, a poly p-phenylene vinylene (PPV) derivative, a polymethacrylate derivative, a poly(9,9-octylfluorene) derivative, a poly(spiro-fluorene) derivative, TCTA (tris(4-carbazoyl-9-ylphenyl)amine), TPD (N,N'-diphenyl-N,N'-bis(3-methylphenyl)-(1,1'-biphenyl)-4,4'-diamine), NPB (N,N'-di(naphthalen-1-yl)-N,N'-diphenylbenzidine), m-MTDATA (tris(3-methylphenylphenylamino)-triphenylamine), TFB (poly[(9,9-dioctylfluorenyl)-2,7-diyl-co-4,4'-(N-4-butylphenyl)diphenylamine]), PFB (poly(9,9-dioctylfluorene)-co-N,N-diphenyl-N,N-di-(p-butylphenyl)-1,4-diaminobenzene), poly-TPD, and metal oxides such as NiO and $MoO_3$, or a combination thereof, but are not limited thereto. In an embodiment, the hole injection layer may include, but is not limited to, an aryl amine compound such as TPD, an imidazole compound such as TPBi, a carbazole biphenyl compound such as CBP, a carbazole phenylamine compound such as TCTA, a naphthyl biphenyl diamine compound such as NPB, polymers such as PEDOT, PEDOT:PSS, PVK, and TFB, or a combination thereof.

In an embodiment of a device, a thickness of the hole auxiliary layer, the layer of the hole injection/transport material, the hole injection layer, or the hole transport layer may be appropriately selected. For example, the thickness for each of the hole auxiliary layer, the layer of the hole injection/transport material, the hole injection layer, or the hole transport layer may be greater than or equal to about 5 nm, greater than or equal to about 10 nm, greater than or equal to about 15 nm, greater than or equal to about 20 nm, greater than or equal to about 22 nm, greater than or equal to about 25 nm, greater than or equal to about 30 nm, greater than or equal to about 35 nm, greater than or equal to about 40 nm, greater than or equal to about 45 nm, greater than or equal to about 50 nm, greater than or equal to about 55 nm, greater than or equal to about 60 nm, greater than or equal to about 65 nm, greater than or equal to about 70 nm, greater than or equal to about 75 nm, greater than or equal to about 80 nm, greater than or equal to about 85 nm, greater than or equal to about 90 nm, greater than or equal to about 95 nm, greater than or equal to about 100 nm, and less than or equal to about 300 nm, less than or equal to about 295 nm, less than or equal to about 290 nm, less than or equal to about 285 nm, less than or equal to about 280 nm, less than or equal to about 275 nm, less than or equal to about 270 nm, less than or equal to about 265 nm, less than or equal to about 260 nm, less than or equal to about 255 nm, less than or equal to about 250 nm, less than or equal to about 245 nm, less than or equal to about 240 nm, less than or equal to about 235 nm, less than or equal to about 230 nm, less than or equal to about 225 nm, less than or equal to about 220 nm, less than or equal to about 215 nm, less than or equal to about 210 nm, less than or equal to about 205 nm, less than or equal to about 200 nm, less than or equal to about 195 nm, less than or equal to about 190 nm, less than or equal to about 185 nm, less than or equal to about 180 nm, less than or equal to about 175 nm, less than or equal to about 170 nm, less than or equal to about 165 nm, less than or equal to about 160 nm, less than or equal to about 155 nm, less than or equal to about 150 nm, less than or equal to about 145 nm, less than or equal to about 140 nm, less than or equal to about 135 nm, less than or equal to about 130 nm, less than or equal to about 125 nm, less than or equal to about 120 nm, less than or equal to about 115 nm, less than or equal to about 110 nm, less than or equal to about 105 nm, less than or equal to about 100 nm, less than or equal to about 95 nm, less than or equal to about 90 nm, less than or equal to about 85 nm, less than or equal to about 80 nm, less than or equal to about 75 nm, less than or equal to about 70 nm, less than or equal to about 65 nm, less than or equal to about 60 nm, less than or equal to about 55 nm, less than or equal to about 50 nm, less than or equal to about 45 nm, less than or equal to about 40 nm, less than or equal to about 35 nm, or less than or equal to about 30 nm, but is not limited thereto.

An electroluminescent device of an embodiment includes, on the emission layer, for example, an electron auxiliary layer disposed between a second electrode (hereinafter, referred to as a second electrode) and the emission layer. In the electron auxiliary layer, electron transport, injection, or transport and injection may occur. The electron auxiliary layer 4, 40 includes an electron transport layer (ETL). The electron transport layer includes metal oxide nanoparticles. In an embodiment, the electron auxiliary layer may further include an electron injection layer, a hole blocking layer, or a combination thereof. The electron injection layer, the hole blocking layer, or a combination thereof may be disposed between the electron transport layer and the second electrode, but is not limited thereto. In an embodiment, a hole blocking layer may be disposed between the electron injection layer and the electron transport layer. In another embodiment, an electron injection layer may be disposed between the hole blocking layer and the electron transport layer. The electron transport layer may be disposed adjacent to the emission layer (for example, directly above the emission layer). In an embodiment, the electron transport layer may be in contact with the emission layer.

The electroluminescent device of an embodiment includes an electron auxiliary layer 4, 40 disposed on the light emitting layer 3, 30, for example, between the light emitting layer and the thin film conductor or the second electrode 5, 50.

In the electron auxiliary layer 4, 40, transporting, injecting, or transporting and injecting of electrons may occur. The electron auxiliary layer 4, 40 includes an electron transport layer (ETL). The electron transport layer includes a metal oxide nanoparticle. The electron auxiliary layer 4, 40 may further include an electron injection layer, a hole blocking layer, or a combination thereof. The electron injection layer, the hole blocking layer, or a combination thereof may be disposed between the electron transport layer and the second electrode, but it is not limited thereto. In an embodiment, the hole blocking layer may be disposed between the electron injection layer and the electron transport layer. In an embodiment, the electron injection layer may be disposed between the hole blocking layer and the electron transport layer. The electron transport layer may be adjacent (e.g., directly adjacent or directly disposed on) the light emitting layer. In an embodiment, the light emitting layer 3, 30 may contact the electron transport layer.

In an embodiment, the second electrode 5, 50 may have a first surface facing a surface of the electron transport layer (or the electron auxiliary layer) and a second surface opposite the first surface. The metal oxide (nanoparticle) may include a zinc oxide. The metal oxide (nanoparticle) or the zinc oxide may include zinc; and optionally a Group IIA metal, Zr, W, Li, Ti, Y, Al, gallium, indium, tin (Sn), cobalt (Co), vanadium (V), or a combination thereof. In an embodiment, the metal oxide (nanoparticle) or the zinc oxide may include zinc, a Group IIA metal, and optionally an alkali metal.

The metal oxide (nanoparticle) or the zinc oxide may include a compound represented by $Zn_{1-x}M_xO$, wherein, M is Mg, Ca, Zr, Co, W, Li, Ti, Y, Al, or a combination thereof, and $0 \leq x \leq 0.5$. The x may be greater than or equal to about 0.01, greater than or equal to about 0.03, greater than or equal to about 0.05, greater than or equal to about 0.07, greater than or equal to about 0.1, greater than or equal to about 0.13, greater than or equal to about 0.15, greater than or equal to about 0.17, greater than or equal to about 0.2, greater than or equal to about 0.23, or greater than or equal to about 0.25. The x may be less than or equal to about 0.47, less than or equal to about 0.45, less than or equal to about 0.43, less than or equal to about 0.4, less than or equal to about 0.37, less than or equal to about 0.35, or less than or equal to about 0.3.

For example, the metal oxide or the zinc oxide may further include magnesium. The electron transport layer or the zinc oxide may include $Zn_{1-x}Mg_xO$ (x is greater than or equal to 0, or greater than 0 and less than or equal to about 0.5, greater than 0.03 and less than or equal to about 0.3, greater than 0.04 and less than or equal to about 0.2, the x is the same as defined herein), ZnO, or a combination thereof.

A size or an average size (hereinafter, referred at times as "size") of the metal oxide nanoparticle may be greater than or equal to about 1 nm, greater than or equal to about 2 nm, greater than or equal to about 2.5 nm, greater than or equal to about 3 nm, or greater than or equal to about 3.5 nm and less than or equal to about 10 nm, less than or equal to about 9 nm, less than or equal to about 8 nm, less than or equal to about 7 nm, less than or equal to about 6 nm, less than or equal to about 5 nm, or less than or equal to about 4.5 nm. A size of metal oxide nanoparticle can be a diameter or an equivalent diameter. The equivalent diameter is the value obtained by converting the size of a non-spherical particle into the diameter of a spherical particle. The size of the nanoparticles can be measured by appropriate means such as electron microscopy analysis like TEM or XRD. In this specification, the size can refer to the size of individual particles or the average size of a particle group.

In an embodiment, the metal oxide nanoparticle (e.g., the zinc oxide nanoparticle) may be prepared in any proper method, which is not particularly limited. The preparation of the metal oxide nanoparticle may include a sol-gel reaction. In an embodiment, the zinc oxide (e.g., zinc magnesium oxide) nanoparticle may be prepared by placing a zinc compound (e.g., an organic zinc compound such as zinc acetate dihydrate) and optionally an additional metal compound (e.g., an additional organic metal compound such as magnesium acetate tetrahydrate) in an organic solvent (e.g., dimethylsulfoxide) in a flask to have a desired mole ratio and heating the same at a predetermined temperature (e.g., from about 40 °C to about 120 °C, or from about 60 °C to about 100 °C) (e.g., in air), and adding a precipitation accelerator solution (for example, a solution of tetramethyl ammonium hydroxide pentahydrate and ethanol) at a predetermined rate with, e.g., while, stirring. The prepared zinc oxide nanoparticle (e.g., $Zn_{1-x}Mg_xO$ nanoparticle) may be recovered from a reaction solution, for example via centrifugation.

In an embodiment, the electron auxiliary layer or the electron transport layer may be prepared in a solution process. In an embodiment, the electron auxiliary layer or the electron transport layer may be prepared by dispersing a plurality of metal oxide nanoparticles in an organic solvent (for example, a polar solvent, a non-polar solvent, or a combination thereof) to obtain an electron transport layer precursor dispersion, which is then applied to a surface to form a film. The electron transport layer precursor dispersion may be applied to the light emitting layer. The solution process may further include removing the organic solvent from the formed film for example by evaporation. The organic solvent may include a C1 to C10 alcohol solvent or a combination thereof.

In an embodiment, a thickness of the electron transport layer (ETL) may be greater than or equal to about 3 nm, greater than or equal to about 5 nm, greater than or equal to about 6 nm, greater than or equal to about 7 nm, greater than or equal to about 8 nm, greater than or equal to about 9 nm, greater than or equal to about 10 nm, greater than or equal to about 11 nm, greater than or equal to about 12 nm, greater than or equal to about 13 nm, greater than or equal to about 14 nm, greater than or equal to about 15 nm, greater than or equal to about 16 nm, greater than or equal to about 17 nm, greater than or equal to about 18 nm, greater than or equal to about 19 nm, greater than or equal to about 20 nm, greater than or equal to about 21 nm, greater than or equal to about 22 nm, greater than or equal to about 23 nm, greater than or

equal to about 24 nm, greater than or equal to about 25 nm, greater than or equal to about 26 nm, greater than or equal to about 27 nm, greater than or equal to about 28 nm, greater than or equal to about 29 nm, greater than or equal to about 30 nm, greater than or equal to about 31 nm, greater than or equal to about 32 nm, greater than or equal to about 33 nm, greater than or equal to about 34 nm, or greater than or equal to about 35 nm. The thickness of the electron transport layer may be less than or equal to about 90 nm, less than or equal to about 80 nm, less than or equal to about 70 nm, less than or equal to about 60 nm, less than or equal to about 50 nm, less than or equal to about 45 nm, less than or equal to about 40 nm, or less than or equal to about 35 nm.

The thickness of the electron injection layer, the hole blocking layer, or a combination thereof is not particularly limited and may be appropriately selected. A thickness of the electron injection layer, the hole blocking layer, or a combination thereof may be greater than or equal to about 5 nm, greater than or equal to about 6 nm, greater than or equal to about 7 nm, greater than or equal to about 8 nm, greater than or equal to about 9 nm, greater than or equal to about 10 nm, greater than or equal to about 11 nm, greater than or equal to about 12 nm, greater than or equal to about 13 nm, greater than or equal to about 14 nm, greater than or equal to about 15 nm, greater than or equal to about 16 nm, greater than or equal to about 17 nm, greater than or equal to about 18 nm, greater than or equal to about 19 nm, greater than or equal to about 20 nm, or greater than or equal to about 21 nm and less than or equal to about 120 nm, less than or equal to about 110 nm, less than or equal to about 100 nm, less than or equal to about 90 nm, less than or equal to about 80 nm, less than or equal to about 70 nm, less than or equal to about 60 nm, less than or equal to about 50 nm, less than or equal to about 40 nm, less than or equal to about 30 nm, or less than or equal to about 25 nm, but is not limited thereto.

In an embodiment, a material for the electron injection layer, the hole blocking layer, or a combination thereof may include 1,4,5,8-naphthalene-tetracarboxylic dianhydride (NTCDA), bathocuproine (BCP), tris[3-(3-pyridyl)-mesityl]borane (3TPYMB), LiF, tris(8-hydroxyquinolinato)aluminum ($Alq_3$), tris(8-hydroxyquinolinato)gallium ($Gaq_3$), tris(8-hydroxyquinolinato)indium ($Inq_3$), bis-(8-hydroxyquinolinato)zinc ($Znq_2$), bis[2-(2-hydroxyphenyl)benzothiazolato]zinc ($Zn(BTZ)_2$), bis(10-hydroxybenzo[H]quinolinato)beryllium ($BeBq_2$), 8-(4-(4,6-di(naphthalen-2-yl)-1,3,5-triazin-2-yl)phenyl)quinolone (ET204), 8-hydroxyquinolinato lithium (Liq), 2,2',2"-(1,3,5-Benzinetriyl)-tris(1-phenyl-1-H-benzimidazole) (TPBi), an n-type metal oxide (e.g., ZnO, $HfO_2$, etc.), 8-(4-(4,6-di(naphthalen-2-yl)-1,3,5-triazin-2-yl)phenyl)quinolone:8-hydroxyquinolinato lithium (ET204:Liq), or a combination thereof, but is not limited thereto.

The electroluminescent device may further include an organic layer. The organic layer may further include an acid material, and the material may include a polymer with an acidic moiety, a non-polymeric carboxylic acid compound, or a combination thereof. The acid material may be as described herein.

In an embodiment of the electroluminescent device, the organic layer may be disposed on the electron transport layer and, optionally, on the second electrode. The organic layer may be disposed adjacent to the electron transport layer and the second electrode (see FIG. 3A, FIG. 3B, and FIG. 5A, FIG. 5B, and FIG. 5C). The organic layer may be included while being spaced apart from the electron transport layer and the second electrode (in a non-contact or remote manner) (see FIG. 4A, FIG. 4B, and FIG. 4C, FIG. 6, FIG. 7A, and FIG. 10).

An electroluminescent device of an embodiment may further include a container that at least partially accommodates a stacked structure including the electron transport layer and the second electrode, or further including a first electrode and an emission layer in addition thereto. The container may further include a light-transmitting member; a non-light-transmitting member (for example, an additional member such as a seal); or a combination thereof. A first surface of the container faces the second electrode, and the organic layer may be provided on the first surface of the container to be adjacent to or in contact with the container or the light-transmitting member. A first surface of the organic layer is adjacent to the container, and a second surface of the organic layer opposite to the first surface may face the second electrode and/or the electron transport layer (see FIG. 4A, FIG. 4B, and FIG. 4C, FIG. 6, FIG. 7A, and FIG. 10).

According to embodiments, an electroluminescent device capable of simultaneously exhibiting improved lifetime and electroluminescent characteristics (for example, device efficiency and luminance) is provided. The electroluminescent device of an embodiment can substantially block hole leakage through the electron auxiliary layer (for example, the electron transport layer), can exhibit increased electron transportability, can achieve improved electron-hole balance, and can effectively suppress or prevent material degradation due to charging.

In an embodiment of the electroluminescent device, the organic layer may be formed from a composition exhibiting a desired viscosity or a relatively low viscosity, and may not exhibit absorbance characteristics in a predetermined wavelength range (for example, about 320 nm to about 440 nm), and thus may be used without limitation on an emission mode (for example, both bottom emission and top emission). In an embodiment of the electroluminescent device, the electron transport layer (ETL, electron transport layer) may exhibit improved electron mobility, which may be desirable for hole-electron balance in the emission layer and may efficiently deliver electrons from the electrode to a quantum dot emission layer.

In an embodiment of the electroluminescent device, the electron auxiliary layer (for example, the electron transport layer) may have a HOMO energy level having a desired depth, and generation of trap levels may be suppressed, thereby relatively effectively blocking unwanted hole migration from an emission layer including semiconductor nanoparticles such as quantum dots to the second electrode.

In an embodiment, the electron transport layer or the electron auxiliary layer includes a first face (or a first surface) facing the emission layer and a second face (or a second surface) opposite to the first face, and the organic layer or a polymer material may be disposed on (or over) at least a portion or all of the second face. In an embodiment, the second electrode includes a first face facing the electron transport layer and a second face opposite to the first face, and the organic layer may be disposed on (or over) at least a portion or an entire of the second face.

In an embodiment, the organic layer or the polymer material may be in contact with the second face of the electron transport layer and the second face of the second electrode (see FIG. 3A, FIG. 3B, FIG. 5A, and FIG. 5B). In an embodiment, the organic layer or the polymer material may be disposed to face the electron transport layer or the second electrode while being spaced apart from the electron transport layer or the second electrode. An electroluminescent device of an embodiment may further include a container configured to accommodate at least a portion or all of a stacked structure including a first electrode, an emission layer, an electron transport layer, and a second electrode (or a conductive thin film), and the organic layer may be disposed on one surface of the container (see FIG. 4A, FIG. 4B, FIG. 4C, FIG. 6, FIG. 7B, and FIG. 8A).

The organic layer may be disposed to face the conductive thin film (for example, a surface of the conductive thin film). The organic layer may be disposed to face the electron transport layer. The second electrode or the conductive thin film may be disposed between the organic layer and the electron transport layer.

In an embodiment, the acid material may include a polymeric acid compound, and the polymeric acid compound may include, for example, in a repeating unit thereof, a carboxyl group (COOH), a phosphonic acid group ($PO(OH)_2$), a sulfonic acid group ($SO_3H$), or a combination thereof. In an embodiment, the acid material may be a non-polymeric acid compound including an inorganic acid such as sulfuric acid, hydrochloric acid, or the like; a C2-50 carboxylic acid compound (for example, represented by $R(COOH)_n$); a sulfinic acid compound (for example, represented by $R(SO_2H)_n$); a sulfonic acid compound (for example, represented by $R(SO_3H)_n$), or a combination thereof. In an embodiment, the acid material may include, for example, a non-polymeric carboxylic acid compound represented by $R(COOH)_n$. In the above formulas, R is a C1 to C50 or C3-C25 or C5-C8 substituted or unsubstituted aliphatic or aromatic hydrocarbon group, and n is 1 to 10 or 2 to 8 or 3 to 6, 4 to 5. The acid material may include both the polymeric acid compound and the non-polymeric acid compound (e.g., the non-polymeric carboxylic acid compound).

In an embodiment, the acid material (e.g., the polymeric acid compound or the non-polymeric carboxylic acid compound) may have a molecular weight or an average molecular weight (hereinafter, referred to as "molecular weight") that is greater than or equal to about 50 g/mol, greater than or equal to about 80 g/mol, greater than or equal to about 100 g/mol, greater than or equal to about 150 g/mol, greater than or equal to about 200 g/mol, greater than or equal to about 250 g/mol, greater than or equal to about 300 g/mol, greater than or equal to about 350 g/mol, greater than or equal to about 400 g/mol, greater than or equal to about 450 g/mol, greater than or equal to about 500 g/mol, greater than or equal to about 550 g/mol, greater than or equal to about 600 g/mol, greater than or equal to about 650 g/mol, greater than or equal to about 700 g/mol, greater than or equal to about 750 g/mol, greater than or equal to about greater than or equal to about 800 g/mol, greater than or equal to about 900 g/mol, greater than or equal to about 1000 g/mol, greater than or equal to about 1100 g/mol, greater than or equal to about 1200 g/mol, greater than or equal to about 1300 g/mol, greater than or equal to about 1400 g/mol, greater than or equal to about 1500 g/mol, greater than or equal to about 1600 g/mol, greater than or equal to about 1700 g/mol, greater than or equal to about 1800 g/mol, greater than or equal to about 1900 g/mol, greater than or equal to about 2000 g/mol, greater than or equal to about 2100 g/mol, greater than or equal to about 2200 g/mol, greater than or equal to about 2300 g/mol, greater than or equal to about 2400 g/mol, greater than or equal to about 2500 g/mol, greater than or equal to about 3000 g/mol, greater than or equal to about 3500 g/mol, greater than or equal to about 4000 g/mol, greater than or equal to about 4500 g/mol, greater than or equal to about 5000 g/mol, greater than or equal to about 5500 g/mol, greater than or equal to about 6000 g/mol, greater than or equal to about 7000 g/mol, greater than or equal to about 8000 g/mol, greater than or equal to about 9000 g/mol, greater than or equal to about 10000 g/mol, greater than or equal to about 15000 g/mol, greater than or equal to about 20000 g/mol, greater than or equal to about 25000 g/mol, greater than or equal to about 30000 g/mol, greater than or equal to about 35000 g/mol, greater than or equal to about 40000 g/mol, greater than or equal to about 45000 g/mol, greater than or equal to about 50000 g/mol, greater than or equal to about 55000 g/mol, greater than or equal to about 60000 g/mol, greater than or equal to about 65000 g/mol, greater than or equal to about 70000 g/mol, greater than or equal to about 75000 g/mol, greater than or equal to about 80000 g/mol, greater than or equal to about 85000 g/mol, greater than or equal to about 90000 g/mol, greater than or equal to about 95000 g/mol, greater than or equal to about 100000 g/mol, greater than or equal to about 120000 g/mol, greater than or equal to about 140000 g/mol, greater than or equal to about 160000 g/mol, greater than or equal to about 180000 g/mol, greater than or equal to about 200000 g/mol, greater than or equal to about 220000 g/mol, greater than or equal to about 240000 g/mol, greater than or equal to about 260000 g/mol, greater than or equal to about 280000 g/mol, greater than or equal to about 300000 g/mol, greater than or equal to about 350000 g/mol, greater than or equal to about 400000 g/mol, greater than or equal to about 450000 g/mol, greater than or equal to about 500000 g/mol, greater than or equal to about 550000 g/mol, or a combination thereof.

The molecular weight of the acid material may be less than or equal to about 8000000 g/mol, less than or equal to

about 7000000 g/mol, less than or equal to about 6000000 g/mol, less than or equal to about 5000000 g/mol, less than or equal to about 4000000 g/mol, less than or equal to about 3000000 g/mol, less than or equal to about 2000000 g/mol, less than or equal to about 1500000 g/mol, less than or equal to about 1200000 g/mol, less than or equal to about 1000000 g/mol, less than or equal to about 900000 g/mol, less than or equal to about 800000 g/mol, less than or equal to about 700000 g/mol, less than or equal to about 600000 g/mol, less than or equal to about 500000 g/mol, less than or equal to about 450000 g/mol, less than or equal to about 200,000 g/mol, less than or equal to about 150,000 g/mol, less than or equal to about 100,000 g/mol, less than or equal to about 90,000 g/mol, less than or equal to about 80,000 g/mol, less than or equal to about 70,000 g/mol, less than or equal to about 50,000 g/mol, less than or equal to about 20,000 g/mol, less than or equal to about 10,000 g/mol, less than or equal to about 5000 g/mol, less than or equal to about 3000 g/mol, less than or equal to about 2000 g/mol, less than or equal to about 1000 g/mol, less than or equal to about 800 g/mol, less than or equal to about 500 g/mol, less than or equal to about 450 g/mol, less than or equal to about 400 g/mol, less than or equal to about 350 g/mol, less than or equal to about 300 g/mol, less than or equal to about 250 g/mol, less than or equal to about 200 g/mol, or a combination thereof.

In case where the acid material is a polymeric acid compound, the molecular weight (i.e., an average molecular weight) of the polymer may be obtained taking into consideration a molecular weight (e.g., g/mol) of a monomer and a degree of polymerization of the repeating unit and may exhibit a molecular weight distribution. The average molecular weight of the polymeric acid compound may be an average molecular weight of the polymer, and may be a number average molecular weight, a weight average molecular weight, or a viscosity average molecular weight.

In an embodiment, the average molecular weight of the polymeric acid compound may be measured by using a solution of the polymer. In order to reduce interactions between molecules of the polymer, the molecular weight may be measured by a dilute solution. The concentration of the polymer solution may be appropriately selected, and may be measured using, for example, a solution in which 1 gram or less of a polymer is dissolved per 100 milliliters (mL). The average molecular weight of the polymer may be measured by an appropriate method, such as a gel permeation chromatography, an end group analysis method, an osmotic pressure method, a capillary viscosity method, or the like. In a gel permeation chromatography method, a polymer dissolved in a solvent may be separated in accordance with its size and an obtained result can be calibrated using a standard material with a determined molecular weight. In the terminal group analysis method, the molecular weight may be measured by quantifying a carboxyl group by dissolving a polymer in a solvent. Each measurement method may easily and reproducibly provide substantially the same information on molecular weight using commercially available devices according to established standards. The number average molecular weight, the weight average molecular weight, and the viscosity average molecular weight of the polymer may be related to each other.

The acid material (e.g., the polymeric acid compound, the non-polymeric carboxylic acid compound, or a combination thereof) may be commercially available from various manufacturers. The manufacturers provide information about the acid material (e.g., in case of the polymeric acid compound, a number average molecular weight, a weight average molecular weight, or the like), and thus the polymeric acid compound having a desired level and type of a molecular weight value may be commercially obtained.

The acid material (e.g., a polymeric acid compound, a non-polymeric carboxylic acid compound, or a combination thereof) may be water soluble and/or alcohol soluble. In an embodiment, the acid material (e.g., a polymeric acid compound, a non-polymeric carboxylic acid compound, or a combination thereof) may have a solubility in water or C1 to C10 alcohol, such as ethanol (e.g., at room temperature or at a temperature of 20°C or at 25°C) of greater than or equal to about 1 g/L, greater than or equal to about 10 g/L, greater than or equal to about 20 g/L, greater than or equal to about 30 g/L, greater than or equal to about 40 g/L, greater than or equal to about 50 g/L, greater than or equal to about 60 g/L, greater than or equal to about 70 g/L, greater than or equal to about 80 g/L, greater than or equal to about 90 g/L, greater than or equal to about 100 g/L, greater than or equal to about 110 g/L, greater than or equal to about 120 g/L, greater than or equal to about 130 g/L, greater than or equal to about 140 g/L, greater than or equal to about 150 g/L, greater than or equal to about 160 g/L, greater than or equal to about 170 g/L, greater than or equal to about 180 g/L, greater than or equal to about 190 g/L, greater than or equal to about 200 g/L, greater than or equal to about 210 g/L, greater than or equal to about 220 g/L, greater than or equal to about 230 g/L, greater than or equal to about 240 g/L, greater than or equal to about 250 g/L, greater than or equal to about 260 g/L, greater than or equal to about 270 g/L, greater than or equal to about 280 g/L, greater than or equal to about 290 g/L, greater than or equal to about 300 g/L, or a combination thereof, but is not limited thereto. In an embodiment, the solubility in water or C1 to C10 alcohol, such as ethanol (e.g., at room temperature or at a temperature of 20°C or at 25°C) of the acid material may be less than or equal to about 5000 g/L, less than or equal to about 4000 g/L, less than or equal to about 3000 g/L, less than or equal to about 1000 g/L, less than or equal to about 900 g/L, less than or equal to about 800 g/L, less than or equal to about 700 g/L, less than or equal to about 600 g/L, less than or equal to about 500 g/L, less than or equal to about 400 g/L, less than or equal to about 300 g/L, less than or equal to about 200 g/L, or a combination thereof, but is not limited thereto.

In an embodiment, the acid material may have a relatively high level of solubility with respect to water or a water miscible organic solvent e.g., an alcohol solvent, and a viscosity of a composition or a coating solution for forming the

organic layer may be relatively readily controlled to form a layer or a film. Therefore, a higher degree of flexibility to form a film or a layer may be realized in comparison with an adhesive composition with a relatively high viscosity (e.g., a curable resin-based composition).

In an embodiment, the acid material may be configured to exhibit, in an aqueous or alcoholic solution state, a pH of less than or equal to about 5, less than or equal to about 4.9, less than or equal to about 4.7, less than or equal to about 4.4, less than or equal to about 4.2, less than or equal to about 4, less than or equal to about 3.8, less than or equal to about 3.6, less than or equal to about 3.4, less than or equal to about 3.2, less than or equal to about 3, less than or equal to about 2.8, less than or equal to about 2.6, less than or equal to about 2.4, less than or equal to about 2, less than or equal to about 1.8, less than or equal to about 1.7, less than or equal to about 1.6, less than or equal to about 1.55, less than or equal to about 1.5, or less than or equal to about 1.

In an embodiment, the acid material may be configured to exhibit, in an aqueous or alcoholic solution state, a pH of greater than or equal to about 0.5, greater than or equal to about 1, greater than or equal to about 1.5, greater than or equal to about 1.8, greater than or equal to about 2, greater than or equal to about 2.5, greater than or equal to about 3, greater than or equal to about 3.5, greater than or equal to about 4, greater than or equal to about 4.5, or greater than or equal to about 4.8. In the aqueous or alcoholic solution of the acid material, a concentration of the polymeric acid compound may be from about 5 wt% to about 80 wt%, from about 10 wt% to about 75 wt%, from about 15 wt% to about 70wt%, from about 18 wt% to about 65 wt%, from about 20 wt% to about 60 wt%, from about 25 wt% to about 55 wt%, from about 30 wt% to about 50 wt%, or a combination thereof.

In an embodiment, the acid material may include a polymeric acid compound. The polymeric acid compound may include a polyacrylic acid, a polymethacrylic acid, a polyacrylic acid-methacrylic acid, a polyacrylic acid (partial or full) alkali metal salt, a copolymer including a (meth)acrylic acid repeating unit, a polyvinyl phosphonic acid compound, a poly(aromatic sulfonic acid), a poly(vinyl sulfonic acid) compound, a polymaleic acid, or a combination thereof (e.g., a copolymer or mixture thereof). The polymeric acid compound may further include an ester of the corresponding acid group (i.e., -COOR, R is an alkyl group or an aryl group). The poly(aromatic sulfonic acid) may include a polystyrene sulfonic acid, a polystyrene sulfonic acid-co-maleic acid, an alkali metal salt thereof, or a combination thereof.

In the embodiment, the acid material may include a non-polymeric carboxylic acid compound. The non-polymeric carboxylic acid compound may include a compound represented by $R(COOH)_n$, wherein R is a substituted or unsubstituted C1 to C50 (C2-C10, C3-C6, C4-C5) aliphatic or aromatic hydrocarbon group, for example, a substituted or unsubstituted alkyl or alkylene group, a substituted or unsubstituted alkenyl or alkenylene group, a substituted or unsubstituted alkynyl or alkynylene group, or a substituted or unsubstituted aryl or arylene group, and the n is an integer of 1 to 10, 2 to 8, or 3 to 6.

The non-polymeric carboxylic acid compound may include a polycarboxylic acid compound having two or more carboxylic acid groups. The polycarboxylic acid compound may be a compound having 2 to 10, 3 to 7, 4 to 6, or 5 to 8 carboxylic acid groups. The polycarboxylic acid compound may have 1 to 10, 2 to 5, 3 to 4, substituted or unsubstituted, $C_{1-100}$, $C_{2-50}$, $C_{6-15}$, $C_{3-5}$ aliphatic hydrocarbon group(s), 1 to 10, 2 to 5, 3 to 4, substituted or unsubstituted, $C_{6-15}$ aromatic hydrocarbon group(s), or a combination thereof. The polycarboxylic acid compound may further include a hydroxyl group.

The non-polymeric carboxylic acid compound (e.g., the polycarboxylic acid compound) may include a compound represented by $HOOC\text{-}A\text{-}(COOH)_m$, wherein A is a single bond, a carbon atom, a substituted or unsubstituted C1 to C100 (C1-C50, C2-C45, C3-C40, C4-C20, C5-C15, C6-C12) aliphatic hydrocarbon group, such as alkylene, alkenylene, or alkynylene, a substituted or unsubstituted C6 to C40 aromatic hydrocarbon group, or a combination thereof, m is greater than or equal to about 1, greater than or equal to about 2, greater than or equal to about 3, or greater than or equal to about 4, and less than or equal to about 10, less than or equal to about 8, less than or equal to about 6, or less than or equal to about 3. In the group A, at least one methylene may be replaced with CO, NH, O, COO, CONH, or a combination thereof. The group A may further have a hydroxyl group, for example, as a substituent.

The non-polymeric carboxylic acid compound or the polycarboxylic acid compound may have a carbon number of greater than or equal to about 2, greater than or equal to about 3, greater than or equal to about 4, greater than or equal to about 5, greater than or equal to about 6, greater than or equal to about 7, or greater than or equal to about 8. The non-polymeric carboxylic acid compound or the polycarboxylic acid compound may have a carbon number of less than or equal to about 100, less than or equal to about 60, less than or equal to about 15, less than or equal to about 14, less than or equal to about 13, less than or equal to about 12, less than or equal to about 11, less than or equal to about 10, less than or equal to about 9, less than or equal to about 8, less than or equal to about 7, less than or equal to about 6, or less than or equal to about 5. The non-polymeric carboxylic acid compound or the polycarboxylic acid compound may include a benzoic acid, a succinic acid, a maleic acid, a fumaric acid, a malic acid, a glutaric acid, an adipic acid, a pimelic acid, a citric acid, an oxalic acid, a malonic acid, a phthalic acid, an isophthalic acid, a terephthalic acid, a trimellitic acid, a hemimellitic acid, an azelaic acid, a suberic acid, a tartaric acid, an itaconic acid, a dodecanedioic acid, an acetic acid, a (meth)acrylic acid, or a combination thereof.

The acid material may include both the polymeric acid compound and the non-polymeric carboxylic acid compound.

The acid material may further include or may not include an additive. The additive may include an inorganic acid such as a hydrochloric acid, a phosphoric acid, a carbonic acid, or a sulfuric acid; a sulfinic acid compound (e.g., represented by $R(SO_2H)_n$); a sulfonic acid compound (e.g., represented by $R(SO_3H)_n$); or a combination thereof. In the formulae, R may be a substituted or unsubstituted C1 to C50 aliphatic or aromatic hydrocarbon group, for example, a substituted or unsubstituted alkyl group, a substituted or unsubstituted alkenyl group, a substituted or unsubstituted alkynyl group, or a substituted or unsubstituted aryl group, and n is an integer of 1 to 10, 2 to 8, or 3 to 6. The sulfinic acid compound, the sulfonic acid compound, or a combination thereof may further include a hydroxyl group.

In the acid material (film), an amount of a crosslink type polymer (e.g., a crosslinked poly(meth)acrylate, a crosslinked epoxy, a crosslinked polysiloxane, a crosslinked urethane polymer, a crosslinked thiolene polymer, etc.) may be less than or equal to about 5 wt%, less than or equal to about 3 wt%, less than or equal to about 1 wt%, less than or equal to about 0.9 wt%, less than or equal to about 0.8 wt%, less than or equal to about 0.7 wt%, less than or equal to about 0.6 wt%, less than or equal to about 0.5 wt%, less than or equal to about 0.4 wt%, less than or equal to about 0.3 wt%, less than or equal to about 0.2 wt%, or less than or equal to about 0.1 wt%, based on a total weight of the organic layer. The acid material (film) may not substantially include the crosslinked polymer.

The acid material (film) may be configured to dissolve at least a portion thereof as being immersed in water (or a C1 to C5 alcohol). The temperature of the water (or the temperature of the C1 to C5 alcohol) may be greater than or equal to about 25 °C. The temperature of the water (or the temperature of the C1 to C5 alcohol) may be less than or equal to a boiling point thereof (for example, less than or equal to about 50°C, or less than or equal to about 30°C).

In an embodiment, if present, the acid material may have a form of a film, and a thickness of the organic layer including the acid material (or a film thereof) may have may be greater than or equal to about 10 nm, greater than or equal to about 30 nm, greater than or equal to about 50 nm, greater than or equal to about 70 nm, greater than or equal to about 90 nm, greater than or equal to about 100 nm, greater than or equal to about 120 nm, greater than or equal to about 140 nm, greater than or equal to about 160 nm, greater than or equal to about 180 nm, greater than or equal to about 200 nm, greater than or equal to about 250 nm, greater than or equal to about 300 nm, greater than or equal to about 350 nm, greater than or equal to about 400 nm, greater than or equal to about 450 nm, greater than or equal to about 500 nm, greater than or equal to about 550 nm, greater than or equal to about 600 nm, greater than or equal to about 650 nm, greater than or equal to about 700 nm, greater than or equal to about 750 nm, greater than or equal to about 800 nm, greater than or equal to about 850 nm, greater than or equal to about 900 nm, greater than or equal to about 950 nm, greater than or equal to about 1 micrometer (μm), or greater than or equal to about 1.5 μm.

The thickness of the organic layer may be less than or equal to about 1 centimeter(cm), for example, less than or equal to about 50 millimeters (mm), less than or equal to about 10 mm, less than or equal to about 1 mm, less than or equal to about 0.5 mm, less than or equal to about 0.15 mm, less than or equal to about 100 micrometers (μm), less than or equal to about 90 μm, less than or equal to about 80 μm, less than or equal to about 70 μm, less than or equal to about 60 μm, less than or equal to about 50 μm, less than or equal to about 40 μm, less than or equal to about 30 μm, less than or equal to about 20 μm, less than or equal to about 10 μm, less than or equal to about 9 μm, less than or equal to about 8 μm, less than or equal to about 7 μm, less than or equal to about 6 μm, less than or equal to about 5 μm, less than or equal to about 4 μm, less than or equal to about 3 μm, less than or equal to about 2 μm, or less than or equal to about 1 μm.

The thickness of the acid material (film) may be greater than or equal to about 10 nm, greater than or equal to about 100 nm, greater than or equal to about 500 nm, greater than or equal to about 1 μm, or greater than or equal to about 1.5 μm.

The organic layer may be configured such that at least a portion (or all) thereof is dissolved when immersed in water (or a mixed solvent of water and DMSO or a mixed solvent of water and an alcohol). The temperature of the water (or the temperature of a C1 to C5 alcohol) may be greater than or equal to about 20 °C, greater than or equal to about 25 °C, or greater than or equal to about 30 °C. The temperature of the water (or the temperature of the C1 to C5 alcohol) may be less than or equal to about a boiling point thereof (for example, less than or equal to about 50 °C or less than or equal to about 30 °C).

In an embodiment, the electroluminescent device may further include a container configured to accommodate at least a portion of a stacked structure including a first electrode, an emission layer, an electron transport layer, and a conductive thin film (or a second electrode). The container may include a light transmitting member. The container may further include an additional member connected to the light transmitting member (for example, a light-transmitting or non-light-transmitting material, or a seal material). In an embodiment, the container may be an integral material or structure. In an embodiment, the container may be formed by combining a plurality of members. In an embodiment, the container may be an integral light transmitting member (an encap glass) (see FIG. 8A and FIG. 8B encap glass).

In an embodiment, the container may include a light transmitting member and a seal. The container may be an encapsulation element for the stacked structure. The container or the light transmitting member may include an organic material such as a polymer, an inorganic material such as glass, an organic-inorganic hybrid material, or a combination thereof. The container may be an oven or a chamber. Detailed descriptions of the container (for example, materials, transmittance, etc.) may refer to descriptions provided for a substrate. Herein, the oven is equipment configured to expose

a given material to a high-temperature environment (for example, a post-treatment temperature described herein, greater than or equal to about 50 °C, greater than or equal to about 70 °C, or greater than or equal to about 90 °C), and a heating method thereof is not particularly limited. The oven includes a hollow chamber and includes a heating element configured to heat the chamber in a controlled manner. The hollow chamber may provide a defined space.

In an embodiment of the electroluminescent device, the organic layer or the acid material may be disposed to be adjacent to or in contact with the container or the light transmitting member. The organic layer or the acid material may be applied or coated on one surface of the container or the light transmitting member.

In an embodiment of the electroluminescent device, the container including the organic layer or the acid material may be replaced with a new container after post-treatment, and thus, the electroluminescent device of an embodiment may not include the organic layer.

In an embodiment, a method of manufacturing an electroluminescent device an embodiment includes: forming a hole auxiliary layer on a first electrode; forming an emission layer including a semiconductor nanoparticle on the hole auxiliary layer; forming an electron transport layer including a metal oxide nanoparticle on the emission layer; forming a second electrode (or a conductive thin film) on the electron transport layer to obtain a stacked structure; and post-treating the stacked structure together with an acid material.

In an embodiment, the forming of the hole auxiliary layer of an embodiment may include forming a layer of a hole injection/transport material on the first electrode; applying a base quencher-containing composition on the layer of the hole injection/transport material, and optionally, removing a solvent. The forming of the hole auxiliary layer may include, after removing the solvent, forming a hole transport layer on an exposed surface to obtain the hole auxiliary layer.

In an embodiment, the forming of the hole auxiliary layer may include: forming a layer of a hole injection/transport material; forming a hole transport layer on the layer of the hole injection/transport material; and applying a base quencher-containing composition on the formed hole transport layer, and optionally, removing a solvent to form a base quencher-containing layer.

Post-treatment may be the same as described herein. Detailed descriptions of the emission layer, the organic layer, the acid material, the first and second electrodes, and the container are as described herein.

In an embodiment, a hole auxiliary layer may be optionally formed on the first electrode (for example, an anode) and, for example, between pixel defining layers (PDLs), an emission layer and an electron transport layer may be formed, and then a conductive thin film may be formed thereon to obtain a stacked structure. By providing an organic layer (or an acid material) and a container to the obtained stacked structure, at least a portion of the stacked structure (that is, the electron transport layer and the conductive thin film) and the organic layer or a polymer material may be disposed within a defined space (see FIG. 7A, FIG. 8A, and FIG. 10). The container may be an oven or a chamber (see FIG. 9).

The forming of the hole auxiliary layer may include: forming a layer of a hole injection/transport material, and optionally, forming a hole transport layer on the layer, applying a base quencher-containing composition on the layer of the hole injection/transport material or on the hole transport layer, and optionally, removing a solvent in the base quencher-containing composition. The hole transport layer may be formed on an exposed layer (for example, the base quencher-containing layer) after solvent removal.

Details of the hole injection/transport material and the base quencher are the same as described herein. A method of forming the layer of the hole injection/transport material is not particularly limited and may be appropriately selected. In an embodiment, the layer of the hole injection/transport material may be formed by an inkjet printing method. A composition for forming the layer of the hole injection/transport material (hereinafter, an HIL ink) may further include a dopant (for example, a p-dopant). In the HIL ink, a mole ratio of the hole injection/transport material to the dopant may be in a range of 20:1 to 6:4, 7:3 to 9:1, 7.5:2.5, 8:2, or a combination thereof, but is not limited thereto. A concentration of a total of the hole injection/transport material and the dopant in the HIL ink is not particularly limited and may be appropriately selected in consideration of a desired layer thickness and the like. The concentration of total of the hole injection/transport material and the dopant in the HIL ink may be greater than or equal to about 0.1 wt%, greater than or equal to about 0.5 wt%, greater than or equal to about 1 wt%, greater than or equal to about 1.5 wt%, greater than or equal to about 2 wt%, greater than or equal to about 2.5 wt%, greater than or equal to about 3 wt%, greater than or equal to about 3.5 wt%, greater than or equal to about 4 wt%, greater than or equal to about 4.5 wt%, greater than or equal to about 5 wt%, greater than or equal to about 5.5 wt%, greater than or equal to about 6 wt%, greater than or equal to about 6.5 wt%, greater than or equal to about 7 wt%, greater than or equal to about 7.5 wt%, greater than or equal to about 8 wt%, greater than or equal to about 8.5 wt%, greater than or equal to about 9 wt%, greater than or equal to about 9.5 wt%, greater than or equal to about 10 wt%, and less than or equal to about 20 wt%.

Optionally, a hole transport layer may be formed on the layer of the hole injection/transport material. Materials for the hole transport layer are known to those of ordinary skill, and is not particularly limited and may be appropriately selected. A method of forming the hole transport layer is also not particularly limited. In an embodiment, the hole transport layer may not include a dopant (for example, a p-dopant).

Application of the base quencher-containing composition may be performed on the layer of the hole injection/-transport material or on the hole transport layer. The base quencher-containing composition may include a base quencher,

and optionally, a solvent. A type of the solvent may be selected according to a type of the base quencher and is not particularly limited. In an embodiment, the solvent may be one that does not substantially affect the formed layer of the hole transport material.

In an embodiment, the solvent may be a polar solvent such as water or an C1-C5 alcohol (e.g., ethanol), but is not limited thereto. A method of applying the base quencher-containing composition is not particularly limited and may be appropriately selected. In an embodiment, application of the base quencher-containing composition may be performed by an inkjet printing method.

A concentration of the base quencher in the composition (including solvent) is not particularly limited and may be appropriately selected. The concentration of the base quencher may be in a range of 1 mM to 10 M, 10 mM to 1 M, 40 mM to 0.5 M, 50 mM to 100 mM, or a combination thereof. A manner of removing the solvent is not particularly limited and may be performed by drying and volatilization.

Formation of the emission layer may be performed as described herein and with methods known to those of ordinary skill. An electron transport layer may be formed by applying a dispersion of metal oxide nanoparticles for the electron transport layer on the formed emission layer. A stacked structure may be obtained by disposing an electrode on the formed electron transport layer by a method such as deposition. A method of forming the electron transport layer and a method of depositing the electrode are not particularly limited and may be appropriately selected.

In an embodiment, the post-treatment includes positioning the stacked structure and the acid material together in a first space; and maintaining the first space at a post-treatment temperature of greater than or equal to about 40 °C. The post-treatment temperature may be less than or equal to about 200 °C, for example, less than or equal to about 180 °C, or less than or equal to about 150 °C. The first space (e.g., at least a portion of the first space) may be defined by the container.

The acid material may be provided in a form of an organic layer or in a form of a composition for forming an organic layer. The method may further include providing a container to the stacked structure, and the container may be configured to define at least a portion of the first space. Matters related to the container are as described above.

The first space may be a closed space, for example, a sealed or hermetic (airtight) space. The manufacturing method may include removing the container after the post-treatment.

The container may include a light transmitting member. The container may be a separate piece of equipment capable of controlling temperature and providing a closed space such as an oven or a chamber.

In an embodiment, the second electrode may have a conductivity capable of serving as an electron-injecting conductor and may also have a defined thickness such that acid/moisture released from the acid material or the organic layer during post-treatment can be delivered (for example, by diffusing downward (for example, spreading)) to the electron transport layer disposed under the second electrode or the conductive thin film. When such an acid/moisture vapor environment is provided and a high-temperature environment is formed, a surface modification reaction may be promoted or achieved.

The method may include dissolving the acid material in a liquid vehicle to obtain a composition. The method may include applying the composition on the electron transport layer (and optionally on the second electrode). The method may include applying the composition to one surface of the container such that the composition faces the electron transport layer or the second electrode. In the method, the composition may be applied to the electron transport layer (and the second electrode) or to one surface of the container to form an organic layer. The method may include removing at least a portion of the liquid vehicle (for example, by evaporation) from the applied composition to form the organic layer.

The liquid vehicle may include water; a C1-C10 alcohol such as ethanol, methanol, propanol, isopropanol, (iso) butanol, (iso)pentanol, hexanol, heptanol, octanol, and nonanol; a nitrile solvent such as acetonitrile; a sulfoxide solvent such as dimethyl sulfoxide, diethyl sulfoxide, and ethyl methyl sulfoxide; an ester solvent such as ethyl acetate; or a combination thereof. The liquid vehicle may include a mixture of water and a C1-C10 alcohol.

In the composition for forming the organic layer, a concentration of the acid material may be appropriately selected in consideration of a polymer type, a desired organic layer thickness, and the like, and is not particularly limited. In an embodiment, in the composition for forming the organic layer, the concentration of the acid material, based on a total weight of the composition, may be greater than or equal to about 0.01 wt%, greater than or equal to about 0.05 wt%, greater than or equal to about 0.1 wt%, greater than or equal to about 0.5 wt%, greater than or equal to about 1 wt%, greater than or equal to about 2 wt%, greater than or equal to about 3 wt%, greater than or equal to about 3.3 wt%, greater than or equal to about 4 wt%, greater than or equal to about 5 wt%, greater than or equal to about 6 wt%, greater than or equal to about 7 wt%, greater than or equal to about 8 wt%, greater than or equal to about 9 wt%, greater than or equal to about 10 wt%, greater than or equal to about 11 wt%, greater than or equal to about 12 wt%, greater than or equal to about 13 wt%, greater than or equal to about 14 wt%, greater than or equal to about 15 wt%, greater than or equal to about 16 wt%, greater than or equal to about 17 wt%, greater than or equal to about 18 wt%, greater than or equal to about 19 wt%, greater than or equal to about 20 wt%, greater than or equal to about 21 wt%, greater than or equal to about 22 wt%, greater than or equal to about 23 wt%, greater than or equal to about 24 wt%, greater than or equal to about 25 wt%, greater than or equal to about 26 wt%, greater than or equal to about 27 wt%, greater than or equal to about 28 wt%, greater than or equal to about 29 wt%, greater than or equal to about 30 wt%, greater than or equal to about 31 wt%, greater than or equal to about 32 wt%,

greater than or equal to about 33 wt%, greater than or equal to about 34 wt%, greater than or equal to about 35 wt%, greater than or equal to about 36 wt%, greater than or equal to about 37 wt%, greater than or equal to about 38 wt%, greater than or equal to about 39 wt%, or greater than or equal to about 40 wt%.

The concentration of the acid material, based on a total weight of the solution, may be less than or equal to about 99 wt%, less than or equal to about 90 wt%, less than or equal to about 85 wt%, less than or equal to about 80 wt%, less than or equal to about 75 wt%, less than or equal to about 70 wt%, less than or equal to about 65 wt%, less than or equal to about 60 wt%, less than or equal to about 55 wt%, less than or equal to about 50 wt%, less than or equal to about 45 wt%, less than or equal to about 40 wt%, less than or equal to about 35 wt%, less than or equal to about 30 wt%, less than or equal to about 25 wt%, less than or equal to about 20 wt%, less than or equal to about 15 wt%, less than or equal to about 10 wt%, or less than or equal to about 5 wt%.

In an embodiment, when present, a concentration of an additive in the composition for forming an organic layer may be in a range of greater than or equal to about 0.0001 mole/L (M) and less than or equal to about 10 M, greater than or equal to about 0.0005 M and less than or equal to about 5 M, greater than or equal to about 0.001 M and less than or equal to about 4 M, greater than or equal to about 0.005 M and less than or equal to about 3 M, greater than or equal to about 0.01 M and less than or equal to about 2 M, greater than or equal to about 0.05 M and less than or equal to about 1.5 M, greater than or equal to about 0.1 M and less than or equal to about 1.3 M, greater than or equal to about 0.1 M and less than or equal to about 1.2 M, greater than or equal to about 0.15 M and less than or equal to about 1 M, greater than or equal to about 0.15 M and less than or equal to about 0.9 M, greater than or equal to about 0.2 M and less than or equal to about 0.8 M, greater than or equal to about 0.3 M and less than or equal to about 0.7 M, greater than or equal to about 0.4 M and less than or equal to about 0.6 M, greater than or equal to about 0.45 M and less than or equal to about 0.55 M, or a combination thereof.

The composition for forming an organic layer may exhibit a pH of greater than or equal to about 1, greater than or equal to about 1.5, greater than or equal to about 2, greater than or equal to about 3, greater than or equal to about 3.5, greater than or equal to about 4, greater than or equal to about 4.5, greater than or equal to about 5, or greater than or equal to about 5.5, and less than or equal to about 8, less than or equal to about 7.5, less than or equal to about 7, less than or equal to about 6.5, less than or equal to about 6, less than or equal to about 5.5, less than or equal to about 5.2, less than or equal to about 5, less than or equal to about 4.8, or less than or equal to about 4. At such pH values, a concentration of the composition for forming an organic layer may be as described herein.

A method of applying the composition for forming an organic layer is not particularly limited and may be appropriately selected. The application may include spin coating, blading, dropping, or a combination thereof. After application of a forming liquid, excess liquid may be removed by spinning or the like.

In an embodiment, the post-treatment may be performed under an appropriate atmosphere (for example, under an inert gas atmosphere, under an oxygen-free atmosphere, or in air).

The post-treatment temperature may be greater than or equal to about 40 °C, greater than or equal to about 45 °C, greater than or equal to about 50 °C, greater than or equal to about 55 °C, greater than or equal to about 60 °C, greater than or equal to about 65 °C, greater than or equal to about 70 °C, or greater than or equal to about 75 °C. The post-treatment temperature may be less than or equal to about 200 °C, less than or equal to about 190 °C, less than or equal to about 180 °C, less than or equal to about 160 °C, less than or equal to about 140 °C, less than or equal to about 120 °C, less than or equal to about 100 °C, less than or equal to about 90 °C, less than or equal to about 80 °C, or less than or equal to about 70 °C.

A post-treatment time may be greater than or equal to about 30 minutes, greater than or equal to about 1 hour, greater than or equal to about 2 hours, greater than or equal to about 3 hours, greater than or equal to about 5 hours, greater than or equal to about 7 hours, greater than or equal to about 10 hours, greater than or equal to about 12 hours, greater than or equal to about 20 hours, greater than or equal to about 24 hours, greater than or equal to about 36 hours, greater than or equal to about 48 hours, or greater than or equal to about 50 hours, and less than or equal to about 30 days, less than or equal to about 20 days, less than or equal to about 10 days, less than or equal to about 5 days, less than or equal to about 3 days, less than or equal to about 70 hours, less than or equal to about 50 hours, less than or equal to about 2 days, less than or equal to about 30 hours, less than or equal to about 1 day, less than or equal to about 18 hours, less than or equal to about 14 hours, less than or equal to about 8 hours, less than or equal to about 7 hours, less than or equal to about 6 hours, less than or equal to about 5 hours, less than or equal to about 4 hours, less than or equal to about 3 hours, less than or equal to about 2 hours, or less than or equal to about 1 hour. In an embodiment, the post-treatment time may be greater than or equal to about 10 hours and less than or equal to about 3 days.

The method of an embodiment may further include, after the post-treatment, removing the container; and further providing a conductive layer on the conductive thin film to increase a thickness of the conductive thin film (or the second electrode). After formation of the conductive thin film having the increased thickness, a new container may be further disposed (see FIG. 8A and FIG. 8B).

The electroluminescent device of an embodiment may be configured to emit red light, green light, or blue light. Details (e.g., the wavelength) of red light, green light, or blue light are the same as described herein.

In an embodiment, an electroluminescent device may have a maximum external quantum efficiency (max EQE)

of greater than or equal to about 1%, greater than or equal to about 2%, greater than or equal to about 3%, greater than or equal to about 4%, greater than or equal to about 5%, greater than or equal to about 5.5%, greater than or equal to about 6%, greater than or equal to about 6.5%, greater than or equal to about 7%, greater than or equal to about 7.5%, greater than or equal to about 7.7%, greater than or equal to about 8%, greater than or equal to about 8.5%, greater than or equal to about 9%, greater than or equal to about 9.5%, greater than or equal to about 10%, greater than or equal to about 10.5%, greater than or equal to about 11%, greater than or equal to about 11.5%, greater than or equal to about 12%, greater than or equal to about 12.5%, greater than or equal to about 13%, greater than or equal to about 13.5%, or greater than or equal to about 14%. In an embodiment, the electroluminescent device may have a maximum external quantum efficiency of less than or equal to about 60%, less than or equal to about 50%, less than or equal to about 40%, less than or equal to about 30%, or less than or equal to about 20%.

In an embodiment, the electroluminescent device may have a maximum luminance of greater than or equal to about 1,000 candela per square meter (cd/$m^2$), greater than or equal to about 3,000 cd/$m^2$, greater than or equal to about 10,000 cd/$m^2$, greater than or equal to about 30,000 cd/$m^2$, greater than or equal to about 40,000 cd/$m^2$, greater than or equal to about 60,000 cd/$m^2$, greater than or equal to about 65,000 cd/$m^2$, greater than or equal to about 70,000 cd/$m^2$, greater than or equal to about 80,000 cd/$m^2$, greater than or equal to about 90,000 cd/$m^2$, greater than or equal to about 100,000 cd/$m^2$, greater than or equal to about 110,000 cd/$m^2$, or greater than or equal to about 120,000 cd/$m^2$.

In an embodiment, the electroluminescent device may have a maximum current efficiency of greater than or equal to about 5 candela per ampere (cd/A), greater than or equal to about 5.5 cd/A, greater than or equal to about 6 cd/A, greater than or equal to about 7 cd/A, greater than or equal to about 8 cd/A, greater than or equal to about 9 cd/A, greater than or equal to about 10 cd/A, greater than or equal to about 15 cd/A, greater than or equal to about 20 cd/A, greater than or equal to about 30 cd/A, greater than or equal to about 60 cd/A, greater than or equal to about 90 cd/A, or greater than or equal to about 100 cd/A.

In an embodiment, the electroluminescent device, at a predetermined initial luminance (for example, when driven at 650 nit or 146 nit), may have a T50 of greater than or equal to about 10 hours, greater than or equal to about 20 hours, for example, greater than or equal to about 25 hours, greater than or equal to about 30 hours, greater than or equal to about 40 hours, greater than or equal to about 50 hours, greater than or equal to about 60 hours, greater than or equal to about 65 hours, greater than or equal to about 70 hours, greater than or equal to about 80 hours, greater than or equal to about 90 hours, greater than or equal to about 100 hours, greater than or equal to about 120 hours, greater than or equal to about 150 hours, greater than or equal to about 180 hours, greater than or equal to about 200 hours, or greater than or equal to about 250 hours.

The electroluminescent device, at a predetermined luminance (for example, when driven at 650 nit or 146 nit), may have a T90 of greater than or equal to about 5 hours, greater than or equal to about 6 hours, greater than or equal to about 7 hours, greater than or equal to about 7.5 hours, greater than or equal to about 8 hours, greater than or equal to about 9 hours, greater than or equal to about 10 hours, greater than or equal to about 20 hours, greater than or equal to about 30 hours, greater than or equal to about 40 hours, greater than or equal to about 50 hours, greater than or equal to about 60 hours, greater than or equal to about 70 hours, greater than or equal to about 80 hours, greater than or equal to about 90 hours, greater than or equal to about 100 hours, greater than or equal to about 110 hours, greater than or equal to about 120 hours, or greater than or equal to about 130 hours. The electroluminescent device, at a predetermined luminance (for example, when driven at 650 nit or 146 nit), may have a T90 in a range of greater than or equal to about 35 hours and less than or equal to about 1,500 hours, greater than or equal to about 55 hours and less than or equal to about 1,200 hours, greater than or equal to about 85 hours and less than or equal to about 1,000 hours, greater than or equal to about 105 hours and less than or equal to about 900 hours, greater than or equal to about 115 hours and less than or equal to about 800 hours, greater than or equal to about 145 hours and less than or equal to about 500 hours, or a combination thereof.

In an embodiment, a display device includes the electroluminescent device described herein. The display device may include a first pixel and a second pixel that is configured to emit light different from the light of the first pixel. Referring to FIG. 11, a display panel 1000 according to an embodiment includes a display area 1000D for displaying an image and a non-display area 1000P disposed around the display area 1000D, in which the binding element may be located. The display area 1000D may include a plurality of pixels PXs arranged along a row (e.g., x direction) and/or a column (e.g., y direction), and each pixel PX may include a plurality of sub-pixels $PX_1$, $PX_2$, and $PX_3$ displaying different colors. As an example, a configuration in which three sub-pixels $PX_1$, $PX_2$, and $PX_3$ constitute one pixel PX is illustrated, but the configuration is not limited thereto. An additional sub-pixel such as a white sub-pixel may be further included in the display area 1000D, and one or more sub-pixel displaying the same color may be included in the display area 1000D. The plurality of pixels PXs may be arranged in, for example, a Bayer matrix, a PenTile matrix, and/or a diamond matrix, but is not limited thereto.

Each of the sub-pixels $PX_1$, $PX_2$, and $PX_3$ may be configured to display a color of three primary colors or a combination of three primary colors, for example, red, green, blue, or a combination thereof (e.g., white light). For example, the first sub-pixel $PX_1$ may be configured to display red, the second sub-pixel $PX_2$ may be configured to display green, and

the third sub-pixel $PX_3$ may be configured to display blue. In FIG 11, each of the sub-pixels are depicted to have the same size, but the present disclosure is not limited thereto. For example, at least one of the sub-pixels may be larger or smaller, or have a different shape, than another sub-pixel.

In an embodiment, the display panel of an embodiment may include a light emitting panel which may include a lower substrate 110, a buffer layer 111, a thin film transistor TFT, and a light emitting element 180. The display panel may further include a circuit element for switching and/or driving each of the light emitting elements. Referring to FIG. 12, in the light emitting panel of an embodiment, the light emitting element 180 may be disposed for each sub-pixel $PX_1$, $PX_2$, and $PX_3$. The light emitting element 180 disposed in each sub-pixel $PX_1$, $PX_2$, and $PX_3$ may be independently driven. The subpixel may include a blue subpixel, red subpixel, or a green subpixel. At least one of the light emitting element 180 may be an electroluminescent element according to an embodiment described herein.

Details of the substrate are the same as described herein. The buffer layer 111 may include an organic material, an inorganic material, or an organic-inorganic material. The buffer layer 111 may include, for example, an oxide, a nitride, or an oxynitride, and may include, for example, silicon oxide, silicon nitride, silicon oxynitride, or a combination thereof, but is not limited thereto. The buffer layer 111 may be one layer or two or more layers and may cover a portion of or the entire surface of the lower substrate 110. The buffer layer 111 may be omitted.

The thin film transistor TFT may be a three terminal element for switching and/or driving the light emitting element 180, and one or two or more thin film transistors TFT may be included for each sub-pixel. The thin film transistor TFT may include a gate electrode 124, a semiconductor layer 154 overlapped with the gate electrode 124, a gate insulating layer 140 between the gate electrode 124 and the semiconductor layer 154, and a source electrode 173 and a drain electrode 175 electrically connected to the semiconductor layer 154. A coplanar top gate structure is shown as an example, but the structure is not limited thereto and may have various structures.

The gate electrode 124 is electrically connected to a gate line (not shown), and may include, for example, a low-resistance metal such as aluminum (Al), molybdenum (Mo), copper (Cu), titanium (Ti), silver (Ag), gold (Au), an alloy thereof, or a combination thereof, but is not limited thereto. The semiconductor layer 154 may be an inorganic semiconductor such as amorphous silicon, polycrystalline silicon, or oxide semiconductor; an organic semiconductor; an organic-inorganic semiconductor; or a combination thereof. For example, the semiconductor layer 154 may include an oxide semiconductor including at least one of indium (In), zinc (Zn), tin (Sn), and gallium (Ga), and the oxide semiconductor may include, for example, indium-gallium-zinc oxide, zinc-tin oxide, or a combination thereof, but they are not limited thereto. the semiconductor layer 154 may include a channel region and doped regions disposed on both sides of the channel region and electrically connected to the source electrode 173 and the drain electrode 175, respectively.

The gate insulating layer 140 may include an organic material, an inorganic material, or an organic-inorganic material, and may include, for example, an oxide, a nitride, or an oxynitride, and may include, for example, silicon oxide, silicon nitride, silicon oxynitride, or a combination thereof, but is not limited thereto. In the drawing, an example in which the gate insulating layer 140 is formed on the entire surface of the lower substrate 110 is illustrated, but the present disclosure is not limited thereto and the gate insulating layer 140 may be selectively formed between the gate electrode 124 and the semiconductor layer 154. the gate insulating layer 140 may be formed of one or two or more layers.

The source electrode 173 and the drain electrode 175 may include, for example, a low-resistance metal such as aluminum (Al), molybdenum (Mo), copper (Cu), titanium (Ti), silver (Ag), gold (Au), an alloy thereof, or a combination thereof, but are not limited thereto. The source electrode 173 and the drain electrode 175 may be electrically connected to the doped regions of the semiconductor layer 154, respectively. the source electrode 173 is electrically connected to a data line (not shown), and the drain electrode 175 is electrically connected to a light emitting element 180.

An interlayer insulating layer 145 is additionally formed between the gate electrode 124 and the source/drain electrodes 173 and 175. The interlayer insulating layer 145 may include an organic material, an inorganic material, or an organic-inorganic material, for example, oxide, nitride, or oxynitride, for example, silicon oxide, silicon nitride, silicon oxynitride, or a combination thereof, but is not limited thereto. The interlayer insulating layer 145 may be formed of one or two or more layers.

In an embodiment, a protective layer 160 may be formed on the thin film transistor TFT. The protective layer 160 may be, for example, a passivation layer. The protective layer 160 may include an organic material, an inorganic material, or an organic-inorganic material, for example, polyacrylic, polyimide, polyamide, poly(amideimide), or a combination thereof, but is not limited thereto. The protective layer 160 may be formed of one or two or three or more layers.

In an embodiment, one of the first electrode 1, 10 and the second electrode 5, 50, may be a pixel electrode linked to the TFT and the other of them may be a common electrode.

In an embodiment, the electroluminescent device or the display device including the same may be used in a top emission type, a bottom emission type, a dual emission type, or a combination thereof.

In an embodiment, the first electrode 1, 10 (see. FIGs. 2A and 2B) may be a light transmitting electrode and the second electrode 5, 50 may be a reflective electrode, and the display panel may be a bottom emission type display panel that emits light toward the first electrode 1, 10 and the lower substrate 110, if present. In an embodiment, the first electrode 1, 10 may be a reflective electrode and the second electrode 5, 50 may be a light transmitting electrode, and the display

panel may be a top emission type display panel that emits light to the opposite side of the first electrode 10 and the lower substrate if present. In an embodiment, both the first electrode and the second electrode may be translucent electrodes, and the display panel may be a both side emission type display panel that emits light on the substrate side and on the opposite side of the substrate.

The display device or an electronic apparatus may include (or may be) a television, a virtual reality/augmented reality (VR/AR) device, a handheld terminal, a monitor, a notebook computer, an electronic display board, a camera, or a part for an automatic, e.g., autonomous, vehicle.

Specific examples are described below. However, the examples described below are only for specifically illustrating or explaining the disclosure, and the scope of the disclosure is not limited thereto.

Examples

Analysis Method

1. Electroluminescence Measurement
Electroluminescent properties were measured by applying a voltage and measuring a current according to the applied voltage using a Keithley 2635B or 2200 source meter, and measuring electroluminescent luminance using a CS2000 spectroradiometer.

2. Life-span Characteristics
T90 (h): when the device is driven at a predetermined luminance (e.g., 146 nit), a time (hr) required for a luminance to reach 90% relative to an initial luminance of 100% was measured.

The following synthesis is performed under an inert gas atmosphere (e.g., under nitrogen) unless otherwise specified. A precursor content is provided as a molar content, unless otherwise specified.

Synthesis Example 1:

2 moles per liter (M) of a Se/trioctylphosphine (TOP) stock solution, 1M of a S/TOP stock solution, and 0.1M of a Te/TOP stock solution were prepared by dispersing selenium (Se), sulfur (S), and tellurium (Te) in trioctylphosphine (TOP), respectively. In a reactor containing trioctylamine, 0.125 millimoles (mmol) of zinc acetate was added to the reactor with oleic acid and heated at 120 °C under vacuum. After 1 hour, nitrogen was introduced into the reactor.

The reactor was heated to 300 °C, and the Se/TOP stock solution and the Te/TOP stock solution in a Te:Se mole ratio of 1:15 were rapidly added to, e.g., injected into, the reactor. After 40 minutes, the reaction was complete, and the reaction solution was rapidly cooled to room temperature and acetone was added to the reactor. The resulting product mixture was centrifuged, and the precipitate was separated and dispersed in toluene to prepare a ZnSeTe core particle dispersion.

1.8 mmol of zinc acetate together with oleic acid were added to a flask containing trioctylamine and the mixture was heated at 120 °C under vacuum for 10 minutes. Nitrogen ($N_2$) was then introduced into the reactor, the reactor was heated to 180 °C, and the prepared ZnTeSe core particle dispersion was added quickly to the reactor. The Se/TOP stock solution and the S/TOP stock solution were also added to the reactor, and the reactor temperature was raised to about 280 °C.

After the reaction was complete, the reactor was cooled to room temperature. Ethanol was added to facilitate precipitation of the semiconductor nanoparticles, which were separated by centrifuge. The prepared semiconductor nanoparticles emitted blue light, and a photoluminescent spectroscopy analysis using Hitachi F-7000 spectrophotometer confirmed that the blue light had a maximum emission peak wavelength of about 455 nanometers (nm).

The synthesized semiconductor nanoparticles were precipitated with ethanol and centrifuged and the separated nanoparticles dispersed in cyclohexylbenzene to prepare a QD dispersion.

Synthesis Example 2: Synthesis of ZnMgO nanoparticles

Zinc acetate dihydrate and magnesium acetate tetrahydrate were added into a reactor including dimethylsulfoxide at a pre-determined mole ratio according to the following chemical formula, $Zn_{1-x}Mg_xO$, and heated at 60 °C in an air atmosphere. Subsequently, a solution of tetramethylammonium hydroxide pentahydrate and ethanol was added into the reactor in a dropwise manner at a speed of 3 milliliters per minute (mL/min). After stirring the mixture, the prepared $Zn_{1-x}Mg_xO$ nanoparticles were centrifuged, separated, and dispersed in ethanol to provide an ethanol dispersion of $Zn_{1-x}Mg_xO$

(x = 0.15) nanoparticles.

The prepared nanoparticles were analyzed by a transmission electron microscopic analysis, and the results show that the particles have an average particle size of about 3 nm.

Example 1:

The dispersion of zinc magnesium oxide nanoparticles prepared in Synthesis Example 2 was used as an electron transport layer dispersion (hereinafter, ETL dispersion).

Poly(acrylic acid) (weight-average molecular weight: 450,000 g/mole; product name: Poly(acrylic acid), PAA; manufacturer and product number: Sigma-Aldrich (181285)) was dissolved in ethanol to prepare a composition solution for forming an organic layer (PAA concentration: 5 wt%).

An ink for forming a layer of a hole injection/transport material including 4,4'-bis(3-vinyl-9H-carbazol-9-yl)-1,1'-biphenyl (CBP-V) as a hole injection material and 4-isopropyl-4'-methyldiphenyliodonium tetrakis(pentafluorophenyl) borate (PIPB) as a p-dopant (a 2 wt% solution with a mole ratio of host:dopant = 8:2, hereinafter referred to as an HIL ink) was prepared.

A 1 M cesium hydroxide (CsOH) solution (a base quencher solution) was prepared.

After performing surface treatment on an ITO-deposited glass substrate by UV-ozone for 15 minutes, the HIL ink was spin-coated on the substrate to form a thin film, followed by heat treatment at 230 °C for 30 minutes in an air atmosphere to form a layer of the hole injection/transport material having a thickness of 120 nm. On the layer of the hole injection/transport material, an HTL ink including TFB (solvent: cyclohexylbenzene) was spin-coated to form a thin film, followed by heat treatment at 230 °C for 30 minutes to form a hole transport layer having a thickness of 35 nm.

On the formed hole transport layer, the base quencher solution was dropped and spin-coated to form a hole auxiliary layer including a base quencher. It was confirmed that, in the hole auxiliary layer, a protective layer that includes the base quencher had a thickness of about 3 nm.

On the obtained hole auxiliary layer, an octane dispersion of the semiconductor nanoparticles obtained in Synthesis Example 1 was spin-coated to form an emission layer having a thickness of 30 nm. The formed emission layer was heat-treated at a temperature of 140 °C for 30 minutes under an air atmosphere. After the heat treatment, an electron transport layer was formed on the emission layer using an ETL ink, followed by heat treatment at 140 °C to form the electron transport layer having a thickness of 50 nm.

On the obtained electron auxiliary layer, magnesium and silver were thermally deposited at a mole ratio of 10:1 to a thickness of 20 nm to form a second electrode, thereby obtaining a stacked structure (hereinafter, referred to as a QD stack).

As shown in FIG. 7C, the prepared composition for forming an organic layer was dropped onto a bottom surface of an open box-shaped encap glass (container), spin-coated, and the solvent was removed to form an organic layer having a thickness of about 3 μm. As shown in FIG. 7C, the stacked structure was covered with the obtained encap glass so that, within a sealed space, the organic layer was disposed to face a thin-film conductor while being spaced apart therefrom, and the obtained product was left in a constant-temperature oven at 70 °C for 1 day and 2 days to obtain an electroluminescent device.

Electroluminescent properties of the manufactured electroluminescent device were measured after 1 day and after 2 days, respectively, and the results are summarized in Table 1 and FIGS. 13-16.

Comparative Example 1

An electroluminescent device was obtained in the same manner as in Example 1, except that a base quencher-containing layer was not formed.

Electroluminescent properties of the manufactured electroluminescent device were measured after 1 day and after 2 days, respectively, and the results are summarized in Table 1 and FIGS. 13-16.

Table 1

| | V @5mA | Cd/A @146nt | Cd/A/y | V @146nt | Norm. T90 |
|---|---|---|---|---|---|
| Comp. Ex. 1 after 1 day | 3.6 | 4.5 | 66.8 | 3.5 | 41.5 |
| Comp. Ex. 1 after 2 days | 4.8 | 4.6 | 33.4 | 4.4 | 21.9 |
| Example 1 after 1 day | 3.8 | 5.6 | 79.6 | 3.5 | 32.7 |

(continued)

| | V @5mA | Cd/A @146nt | Cd/A/y | V @146nt | Norm. T90 |
|---|---|---|---|---|---|
| Example 1 after 2 days | 3.6 | 8.3 | 107.6 | 3.2 | 50.4 |
| V@5 mA: a voltage (volt) at 5 mA<br>Cd/A@146 nit: a current efficiency at 146 nit<br>Cd/A: Maximum current efficiency<br>V@146 nit: a voltage at 146 nit<br>Norm. T90: lifetime | | | | | |

From the results of Table 1 and FIGS. 13 to 16, it can be confirmed that the electroluminescent device of Example 1 exhibits significantly improved electroluminescent properties compared to the Comparative Example 1.

In the case of the device of Comparative Example 1, when a post-treatment time exceeded 2 days, a typical negative aging phenomenon (that is, driving voltage shift, efficiency/lifetime degradation, and an increase in lifetime driving voltage) was observed. In contrast, in the device of Example 1, as the post-treatment progressed from day 1 to day 2, a pulling-in of the driving voltage and improvement effects in efficiency and lifetime were confirmed.

Experimental Example

As in Example 1, A film including, i.e., a layer of a hole injection/transport material (120 nm) and a hole transport layer (20 nm) was formed on an Ag/ITO electrode, and an Ag/Mg electrode (thickness: 20 nm) was formed on the formed film.

A PAA solution was prepared as noted above.

A voltage of 4 volts was applied between the two electrodes, and a current density was measured.

Thereafter, as shown in FIG. 9, the stacked structure was placed in an oven together with the PAA solution or without the PAA solution (none), and left at 70 °C for 1 day, and then a current density exhibited by the stacked structure was measured in the same manner as above. The results are summarized in Table 2.

Table 2

| | Relative current density after 1 day of heat treatment | Relative current density after 5 days of heat treatment |
|---|---|---|
| Absence of a PAA solution | 101% | 105% |
| Presence of a PAA solution | 20% | 1% |

Relative current density refers to a current density of a given device divided by a current density of the device prior to heat treatment.

From the results of Table 2, it can be confirmed that, in the Experimental Example, when the layer of the hole injection material and the layer of the hole transport material used in the Example are heat-treated at 70 °C for 1 day in the presence of a PAA solution, the current density decreases to less than or equal to about 20% of the current density before the heat treatment (that is, resistance is significantly increased).

While this disclosure has been described in connection with what is presently considered to be practical embodiments, it is to be understood that the invention is not limited to the disclosed embodiments. On the contrary, it is intended to cover various modifications and equivalent arrangements included within the scope of the appended claims.

## Claims

**1.** An electroluminescent device comprising:

a first electrode and a second electrode;
an emission layer disposed between the first electrode and the second electrode, wherein the emission layer comprises a semiconductor nanoparticle, and the emission layer is configured to emit first light;
an electron transport layer disposed between the emission layer and the second electrode; and
a hole auxiliary layer disposed between the emission layer and the first electrode;
wherein the electron transport layer includes a metal oxide nanoparticle, the metal oxide nanoparticle having a

particle size of greater than or equal to 1 nanometer and less than or equal to 30 nanometers, and
the metal oxide nanoparticles include zinc, and optionally, a Group IIA metal, Zr, W, Li, Ti, Y, Al, Ga, In, Sn, Co, V, or a combination thereof, and
wherein the hole auxiliary layer includes a hole injection/transport material and a base quencher, wherein the base quencher includes an alkali metal hydroxide, an ammonium hydroxide compound, an amine compound, or a combination thereof.

2. The electroluminescent device of Claim 1, wherein the hole auxiliary layer has a first surface facing the emission layer, and the base quencher is present on at least a portion of the first surface.

3. The electroluminescent device of Claims 1 or 2, wherein the hole auxiliary layer comprises a protective layer that includes the base quencher;
preferably wherein a thickness of the protective layer is greater than or equal to 0.5 nanometers and less than or equal to 10 nanometers.

4. The electroluminescent device of any of Claims 1-3, wherein the hole auxiliary layer comprises a hole transport layer, a hole injection layer, and a protective layer that includes the base quencher; and
the protective layer is disposed between the hole transport layer and the hole injection layer or disposed between the hole transport layer and the emission layer.

5. The electroluminescent device of any of Claims 1-4, wherein the base quencher includes cesium hydroxide, rubidium hydroxide, or a combination thereof.

6. The electroluminescent device of any of Claims 1-5, wherein the hole injection/transport material exhibits a current density of less than or equal to 80% of a current density prior to a heat treatment in a test stacked cell structure,

wherein the test stacked cell structure has a layer of the hole injection/transport material with a thickness of greater than or equal to 120 nanometers and less than or equal to 150 nanometers between a Ag-containing anode and a Ag-containing cathode, and
wherein the heat treatment is conducted under the following conditions;
maintaining the test stacked cell structure in the presence of an aqueous solution of a polyacrylic acid having a weight average molecular weight of greater than or equal to 100,000 g/mole and less than or equal to 500,000 g/mole in a sealed space at 70 °C for 24 hours.

7. The electroluminescent device of any of Claims 1-6, wherein the hole injection/transport material comprises a compound represented by Chemical Formula 1, a polymer including a repeating unit represented by Chemical Formula 2 in a main chain, a polymer including a repeating unit represented by Chemical Formula 2a in a main chain, a polymer including a repeating unit represented by Chemical Formula 3 in a main chain, polyvinylcarbazole, or a combination thereof:

Chemical Formula 1

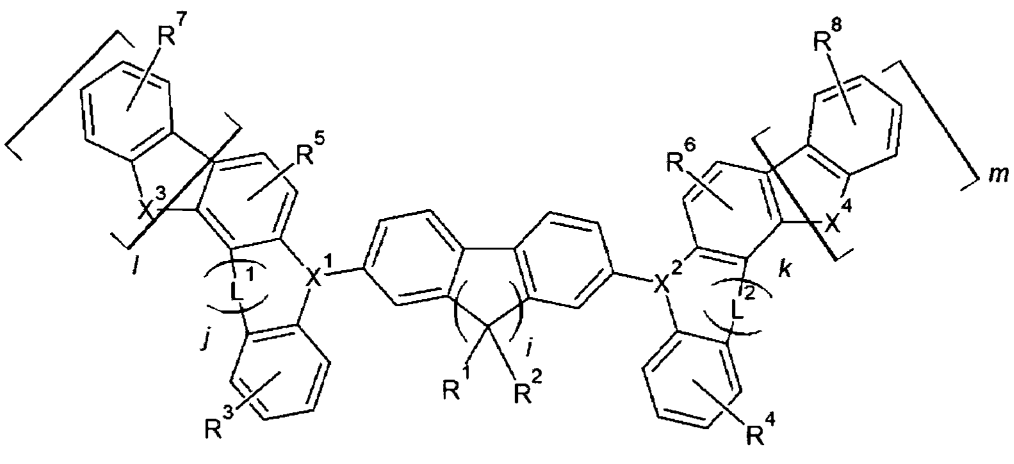

in Chemical formula 1, each $R^1$ to $R^8$ are each independently hydrogen, a substituted or unsubstituted C1 to C40

alkyl group, a substituted or unsubstituted C2 to C40 alkenyl group, a substituted or unsubstituted C2 to C40 alkynyl group, a substituted or unsubstituted C3 to C20 cycloalkyl group, a substituted or unsubstituted C6 to C20 aryl group, a substituted or unsubstituted C3 to C20 heteroaryl group, a substituted or unsubstituted alkylamine group, a substituted or unsubstituted arylamine group, a substituted or unsubstituted carbazolyl group, or a combination thereof,

$X^1$ and $X^2$ are each independently N or C(-$R^a$),

$X^3$ and $X^4$ are each independently S, N- $R^b$, or C(-$R^c$)(- $R^d$),

wherein $R^a$, $R^b$, $R^c$, and $R^d$ are each independently hydrogen, a substituted or unsubstituted C1 to C20 alkyl group, a substituted or unsubstituted C2 to C20 alkenyl group, a substituted or unsubstituted C3 to C20 cycloalkyl group, a substituted or unsubstituted C6 to C20 aryl group, a substituted or unsubstituted C3 to C20 heteroaryl group, or a combination thereof,

$L^1$ and $L^2$ are each independently a single bond, a substituted or unsubstituted C1 to C4 alkylene group, a substituted or unsubstituted C1 to C4 alkenylene group, or a combination thereof, and

i, j, k, l, and m are each independently 0 or 1.

Chemical formula 2

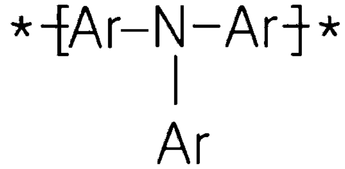

Chemical formula 2a

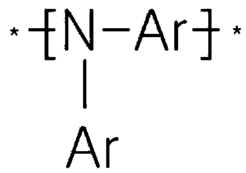

in Chemical formula 2 and Chemical formula 2a, each Ar is the same or different, and each is independently a substituted or unsubstituted C6 to C24 aromatic hydrocarbon group, and

* is a portion connected to an adjacent atom or an adjacent repeating unit;

Chemical Formula 3

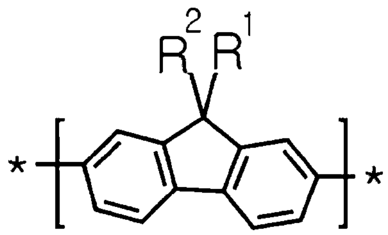

in Chemical formula 3, $R^1$ and $R^2$ are each independently hydrogen, a substituted or unsubstituted C1 to C40 alkyl group, a substituted or unsubstituted C2 to C40 alkenyl group, a substituted or unsubstituted C2 to C40 alkynyl group, a substituted or unsubstituted C3 to C20 cycloalkyl group, a substituted or unsubstituted C6 to C20 aryl group, a substituted or unsubstituted C3 to C20 heteroaryl group, a substituted or unsubstituted alkylamine group, a substituted or unsubstituted arylamine group, a substituted or unsubstituted carbazolyl group, or a combination thereof, and

* is a portion connected to an adjacent atom or an adjacent repeating unit;

preferably wherein the hole injection/transport material further comprises a p-dopant;

preferably wherein the p-dopant includes a boron-containing compound.

**8.** The electroluminescent device of any of Claims 1-7, wherein the hole injection/transport material comprises a compound represented by Chemical Formula 1-3-1, a compound represented by Chemical Formula 1-3-3, or a combination thereof:

Chemical Formula 1-3-1

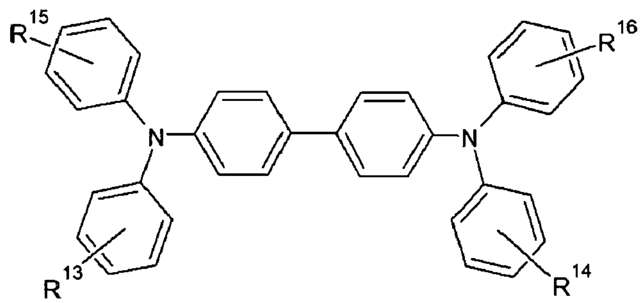

Chemical Formula 1-3-3

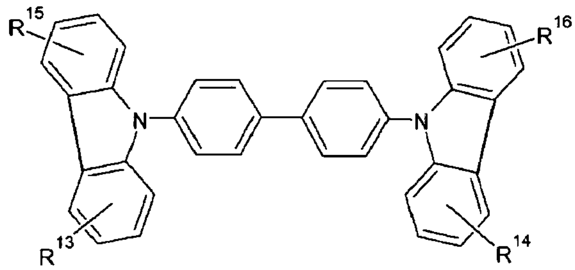

wherein, in the Chemical Formulae,
each $R^{13}$, $R^{14}$, $R^{15}$, and $R^{16}$ are each independently hydrogen, a substituted or unsubstituted C1 to C40 alkyl group, a substituted or unsubstituted C2 to C40 alkenyl group, a substituted or unsubstituted C2 to C40 alkynyl group, a substituted or unsubstituted C3 to C20 cycloalkyl group, a substituted or unsubstituted C6 to C20 aryl group, a substituted or unsubstituted C3 to C20 heteroaryl group, a substituted or unsubstituted alkylamine group, a substituted or unsubstituted arylamine group, a substituted or unsubstituted carbazolyl group, or a combination thereof.

**9.** The electroluminescent device of any of Claims 1-8,

wherein the electroluminescent device further comprises an organic layer disposed on the electron transport layer or the second electrode, and
wherein the organic layer comprises an acid material, and the acid material comprises a polymer acid compound, a non-polymeric carboxylic acid compound, or a combination thereof, and
wherein the organic layer is spaced apart from the electron transport layer and the second electrode;
preferably wherein the electroluminescent device further comprises a container including a light transmitting member, and the organic layer is disposed on a surface of the container

**10.** The electroluminescent device of any of Claims 1-9, wherein the second electrode has a thickness of greater than or equal to 11 nanometers and less than or equal to 40 nanometers; and/or
wherein the hole auxiliary layer is in contact with the emission layer.

**11.** A method of manufacturing an electroluminescent device, the method comprises:

forming a hole auxiliary layer on a first electrode;
forming an emission layer on the hole auxiliary layer;
forming an electron transport layer comprising a metal oxide nanoparticle on the emission layer;
forming a second electrode on the electron transport layer to obtain a stacked structure; and
post-treating the stacked structure together with an acid material,

wherein the forming of the hole auxiliary layer comprises forming a layer of a hole injection/transport material; applying a base quencher-containing composition on the layer of the hole injection/transport material, and optionally, removing a solvent, and
wherein the post-treating comprises:

placing the stacked structure and the acid material a first space; and
maintaining the first space at a post-treatment temperature of greater than or equal to 40 °C.

**12.** The method of Claim 11, wherein the method further comprises providing a container to the stacked structure, and the container is configured to define at least a portion of the first space.

**13.** The method of Claims 11 or 12, wherein the post-treatment temperature is greater than or equal to 70 °C and less than or equal to 180 °C, and/or
the post-treatment time is greater than or equal to 10 hours and less than or equal to 3 days.

**14.** A display device including one or more pixels,
wherein the pixel comprises the electroluminescent device of any of Claims 1-10.

**15.** The display device of Claim 14, wherein the hole auxiliary layer comprises a protective layer that includes the base quencher, and the protective layer is disposed between the hole auxiliary layer and the emission layer.

FIG. 1A

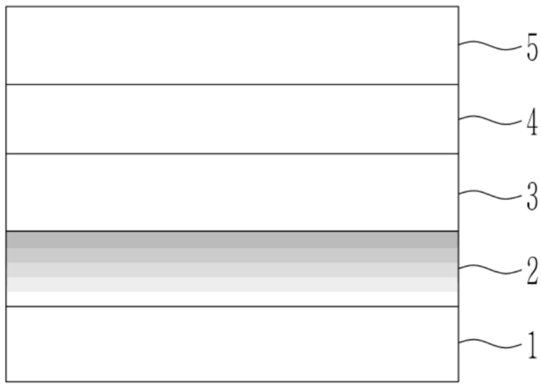

FIG. 1B

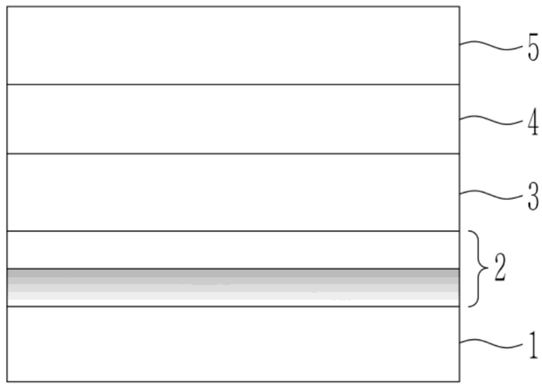

FIG. 1C

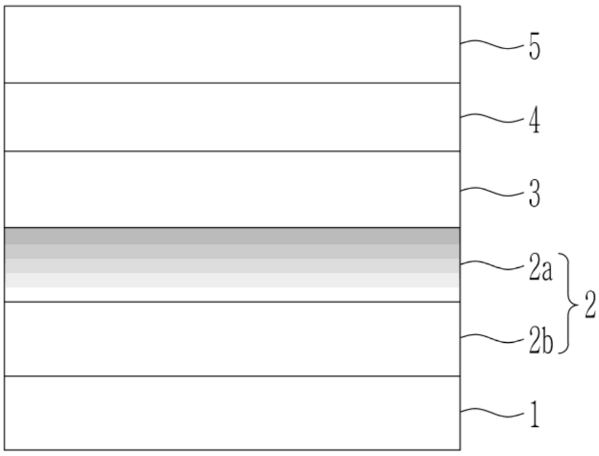

FIG. 1D

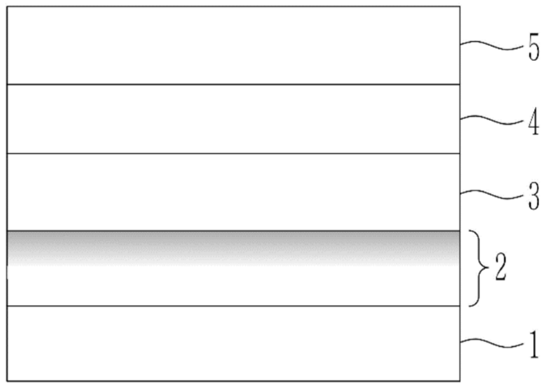

FIG. 1E

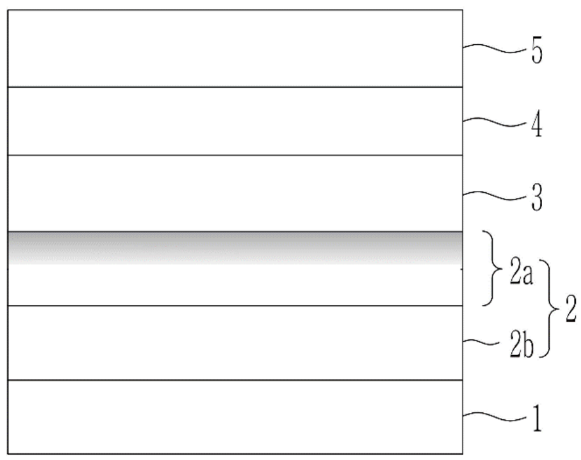

FIG. 1F

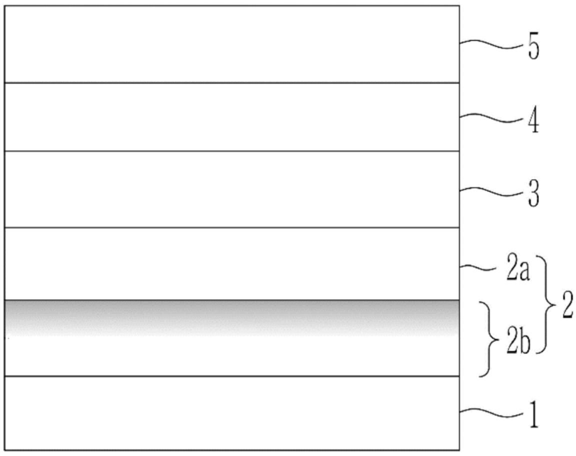

FIG. 2A

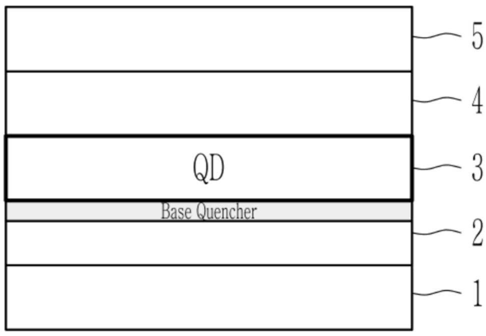

FIG. 2B

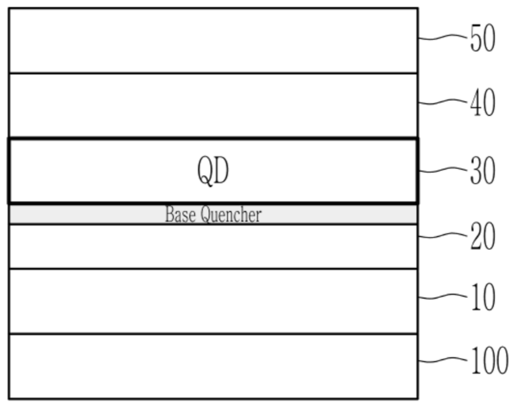

FIG. 2C

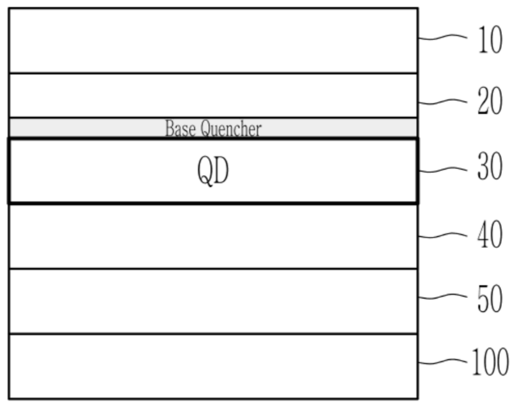

FIG. 3A

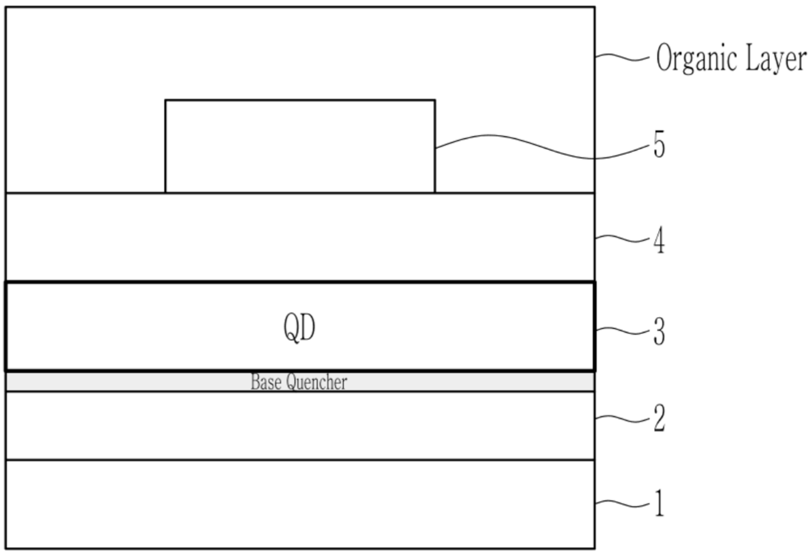

FIG. 3B

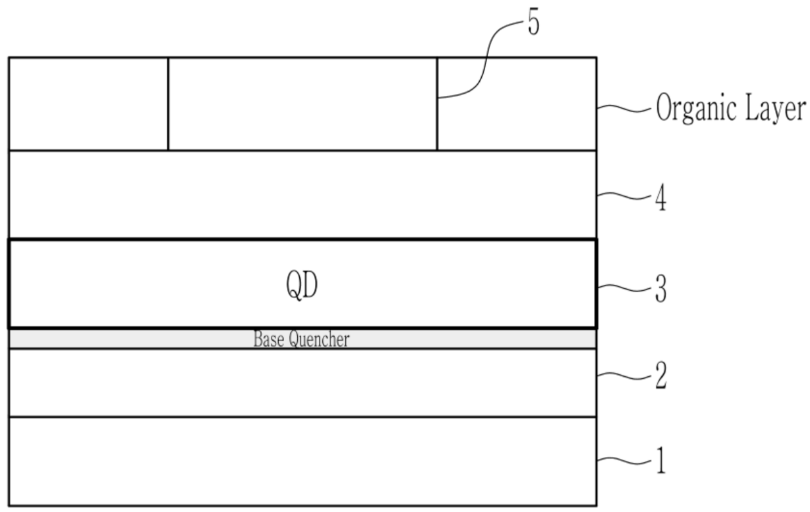

FIG. 4A

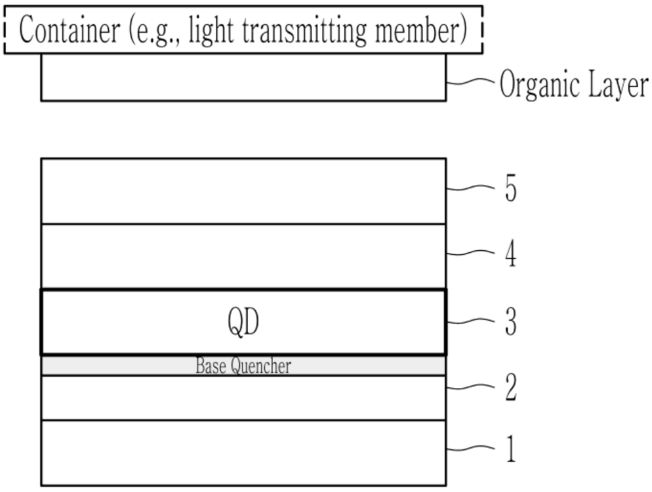
Container (e.g., light transmitting member)
Organic Layer
5
4
QD
3
Base Quencher
2
1

FIG. 4B

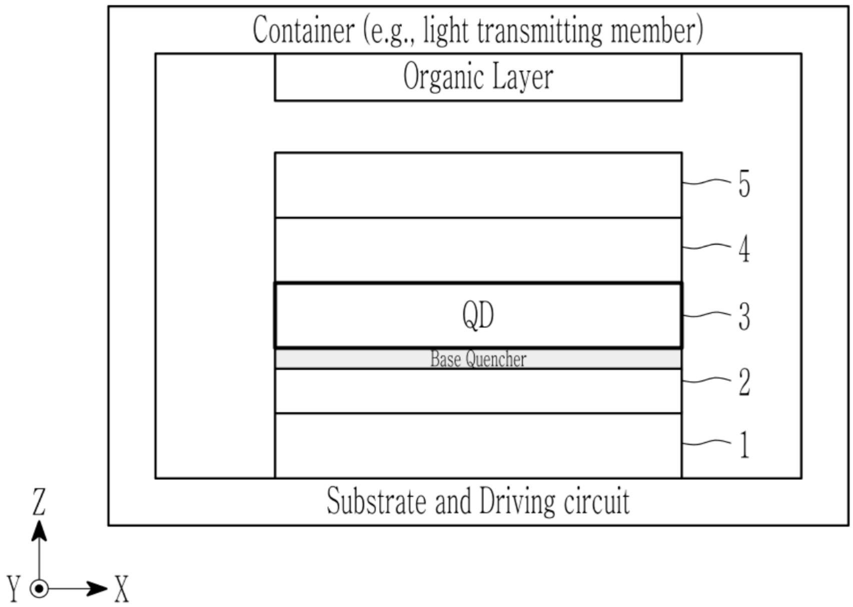
Container (e.g., light transmitting member)
Organic Layer
5
4
QD
3
Base Quencher
2
1
Substrate and Driving circuit
Z
Y
X

FIG. 4C

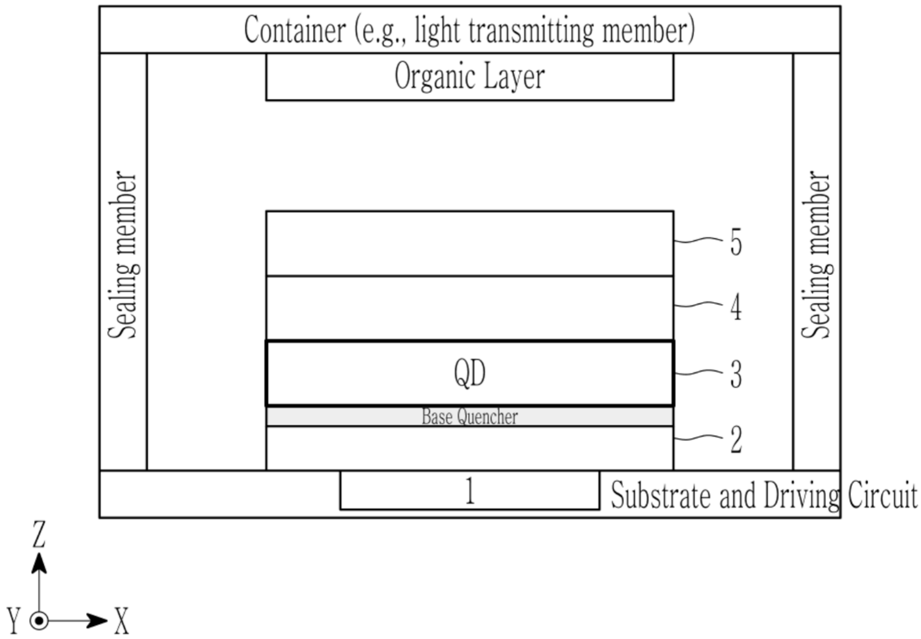
Container (e.g., light transmitting member)
Organic Layer
Sealing member
Sealing member
5
4
QD
3
Base Quencher
2
1
Substrate and Driving Circuit
Z
Y
X

FIG. 5A

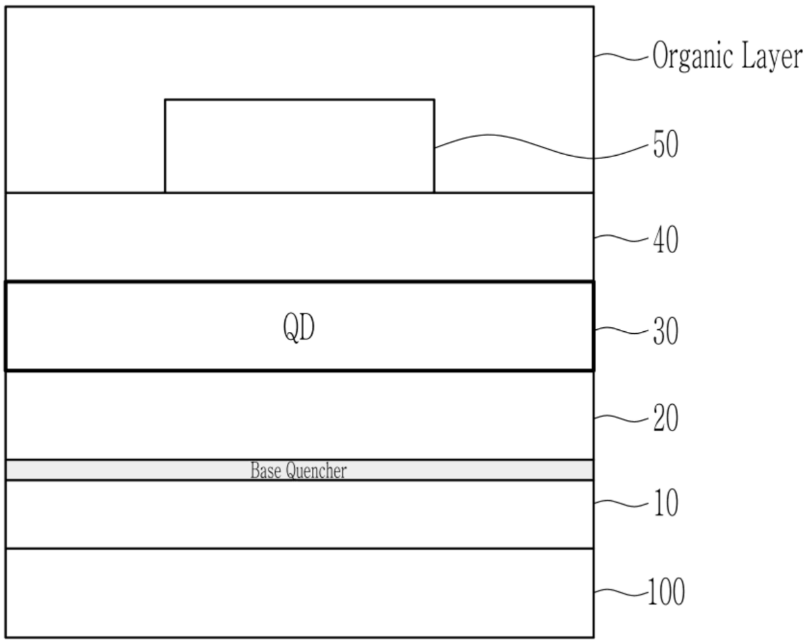

FIG. 5B

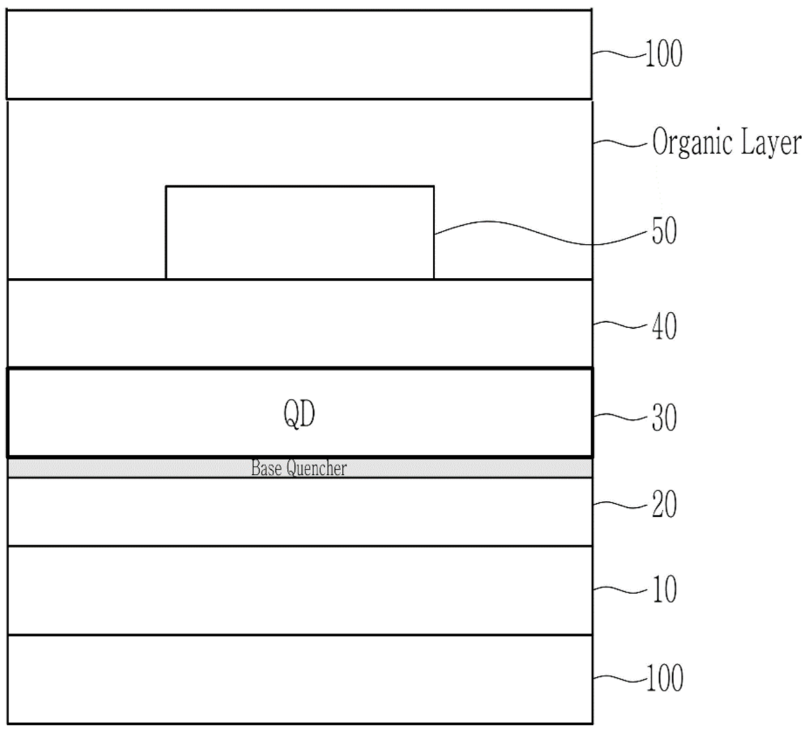

FIG. 5C

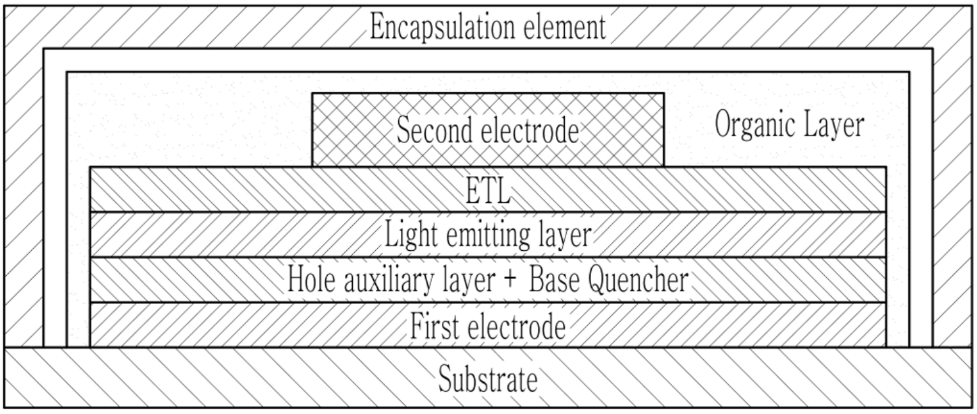
Encapsulation element
Second electrode
Organic Layer
ETL
Light emitting layer
Hole auxiliary layer + Base Quencher
First electrode
Substrate

FIG. 6

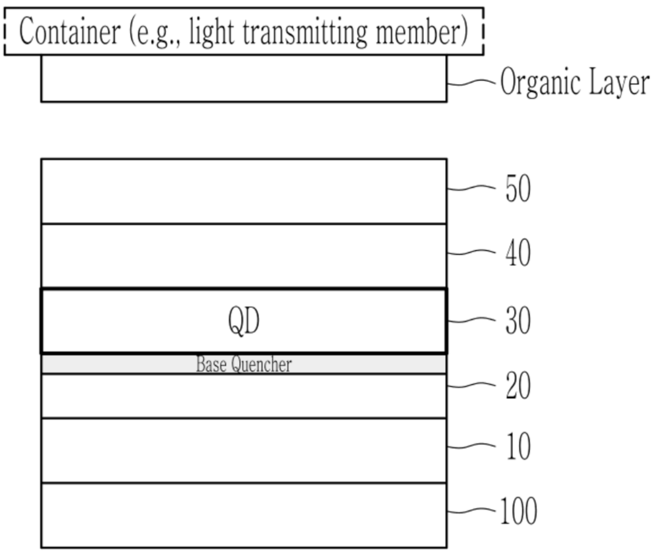
Container (e.g., light transmitting member)
Organic Layer
50
40
QD
30
Base Quencher
20
10
100

FIG. 7A

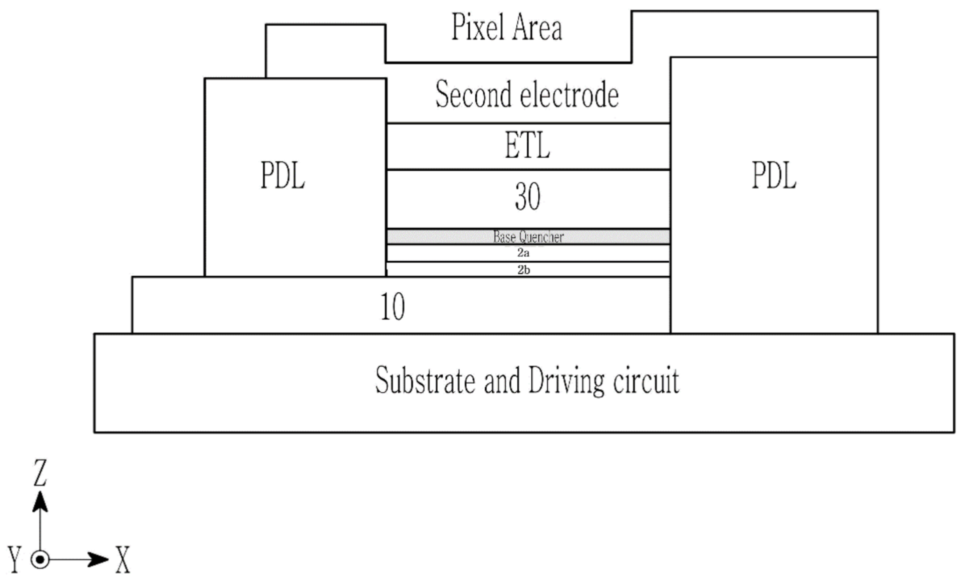
Pixel Area
Second electrode
ETL
PDL
30
PDL
Base Quencher
2a
2b
10
Substrate and Driving circuit
Z
Y
X

FIG. 7B

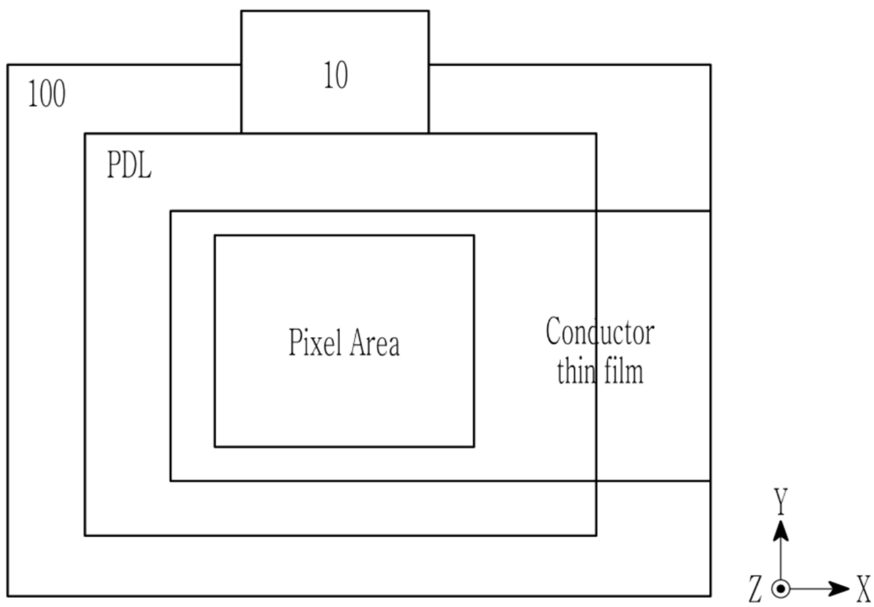

FIG. 7C

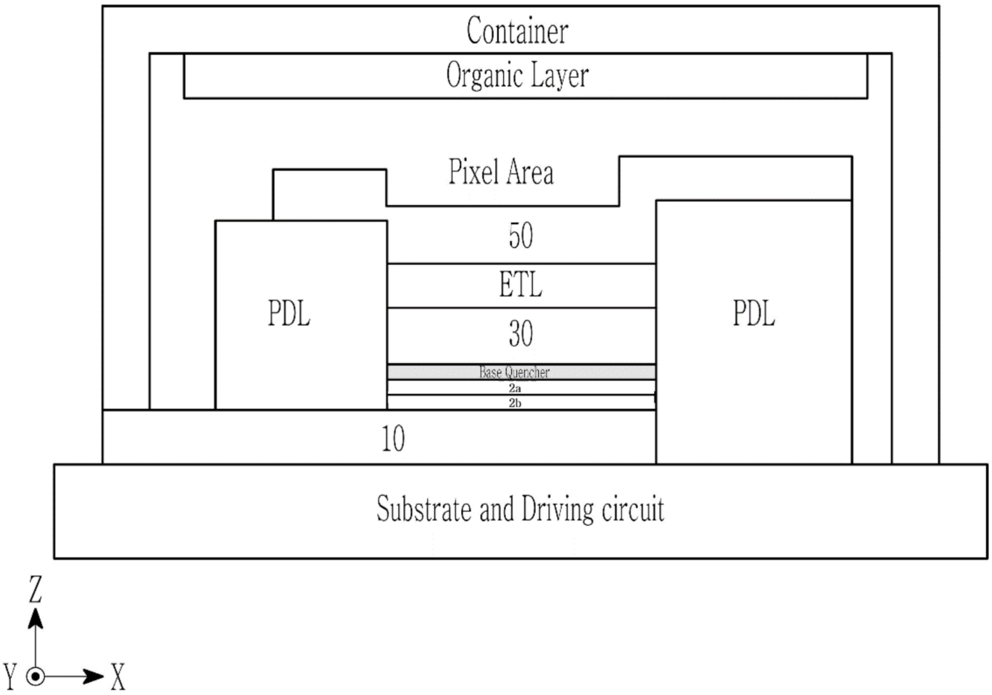
Container
Organic Layer
Pixel Area
50
ETL
PDL
30
PDL
Base Quencher
2a
2b
10
Substrate and Driving circuit
Z
Y
X

FIG. 8A

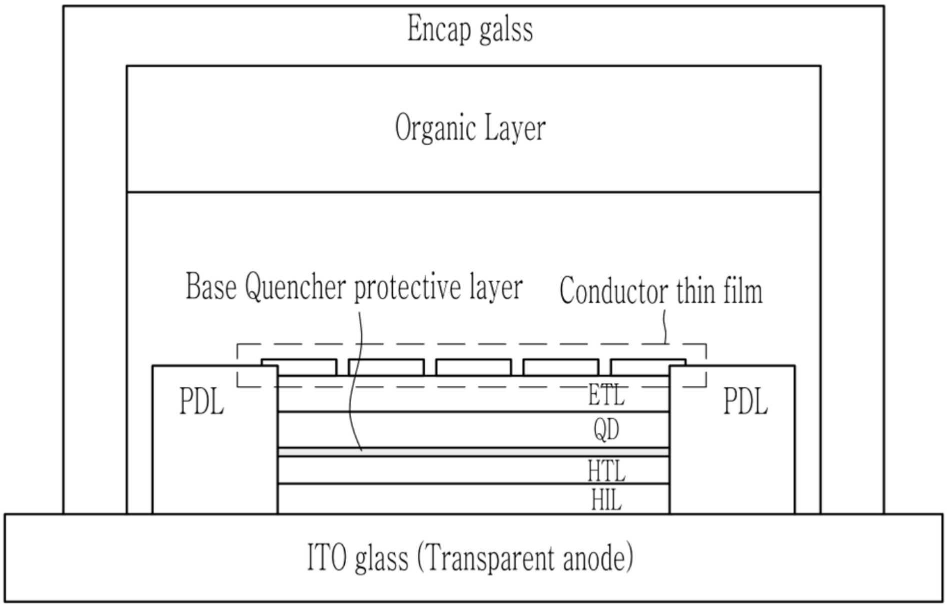
Encap galss
Organic Layer
Base Quencher protective layer
Conductor thin film
PDL
PDL
ETL
QD
HTL
HIL
ITO glass (Transparent anode)

FIG. 8B

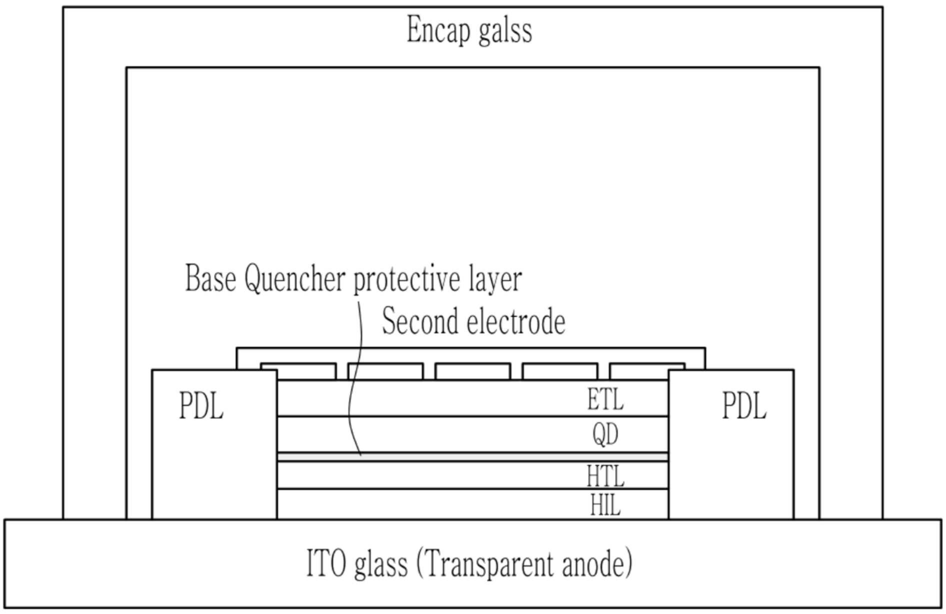
Encap galss
Base Quencher protective layer
Second electrode
PDL
ETL
QD
HTL
HIL
PDL
ITO glass (Transparent anode)

FIG. 9

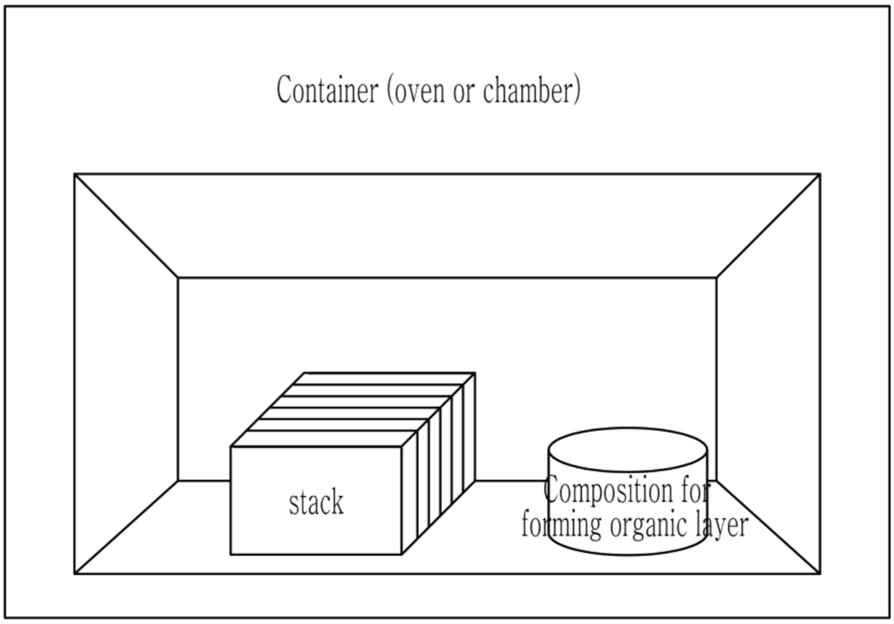
Container (oven or chamber)
stack
Composition for forming organic layer

FIG. 10

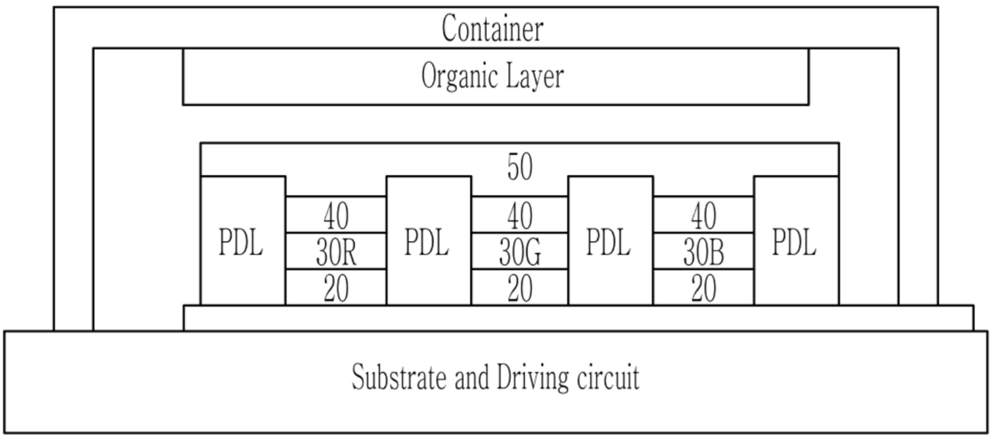
Container
Organic Layer
50
PDL
40
30R
20
PDL
40
30G
20
PDL
40
30B
20
PDL
Substrate and Driving circuit

FIG. 11

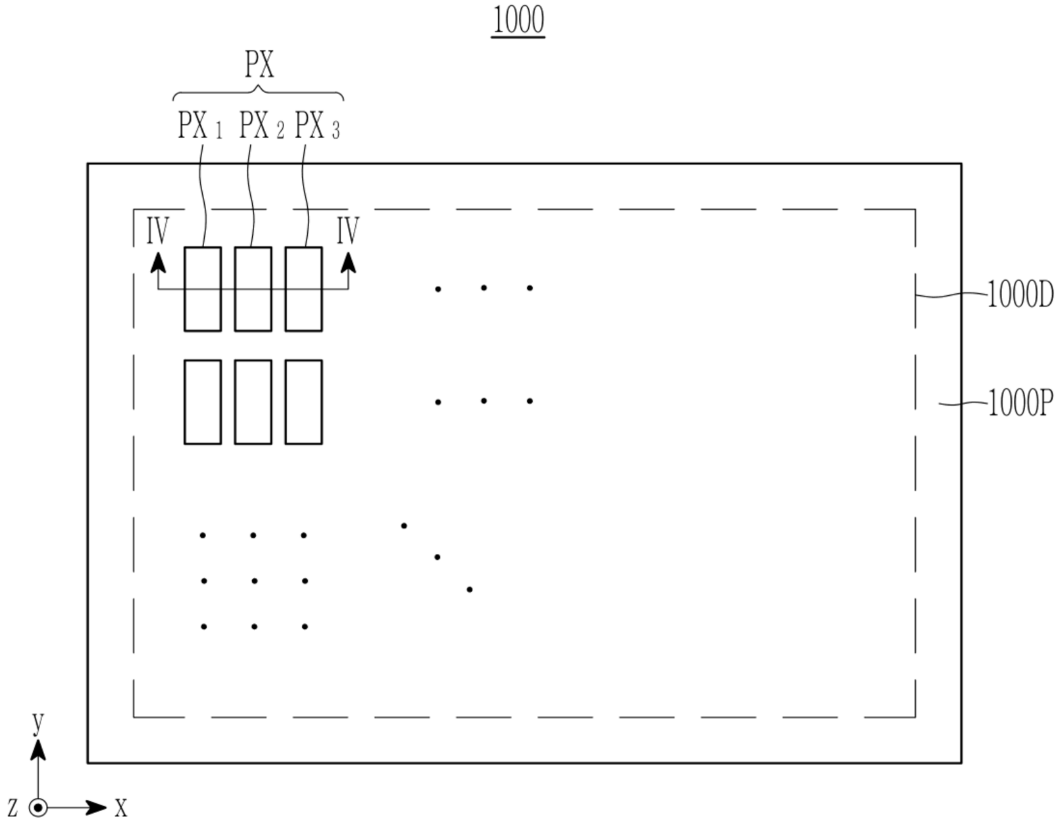

FIG. 12

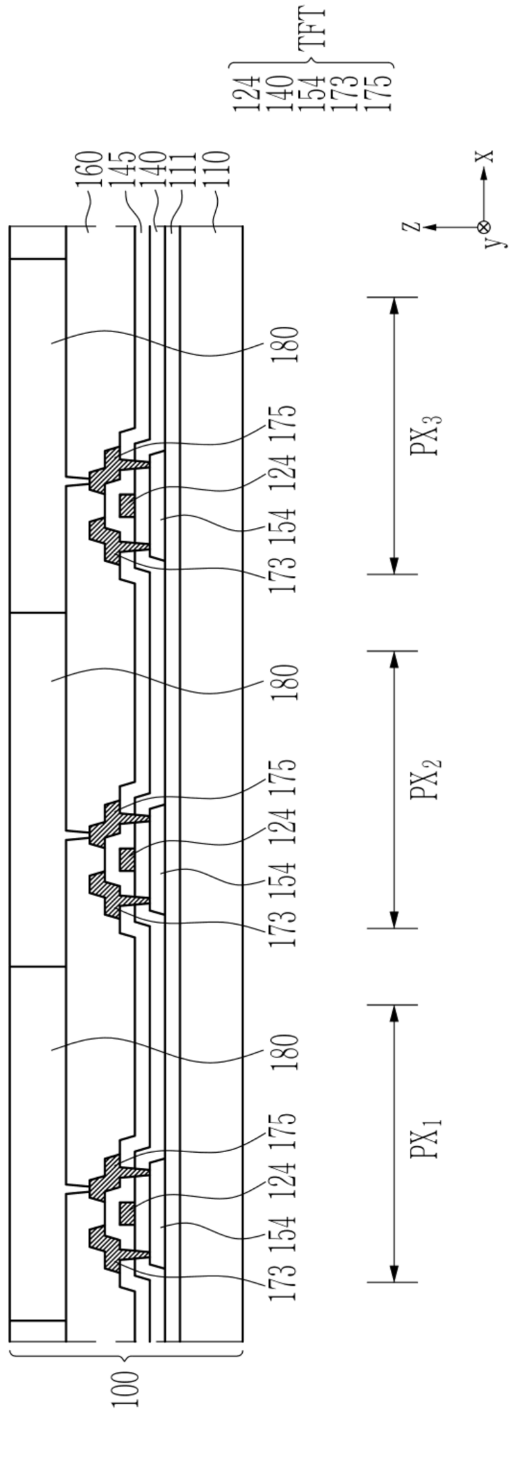
124
140
154
173
175
TFT
160
145
140
111
110
z
x
y
180
175
124
154
173
PX3
180
175
124
154
173
PX2
180
175
124
154
173
PX1
100

FIG. 13

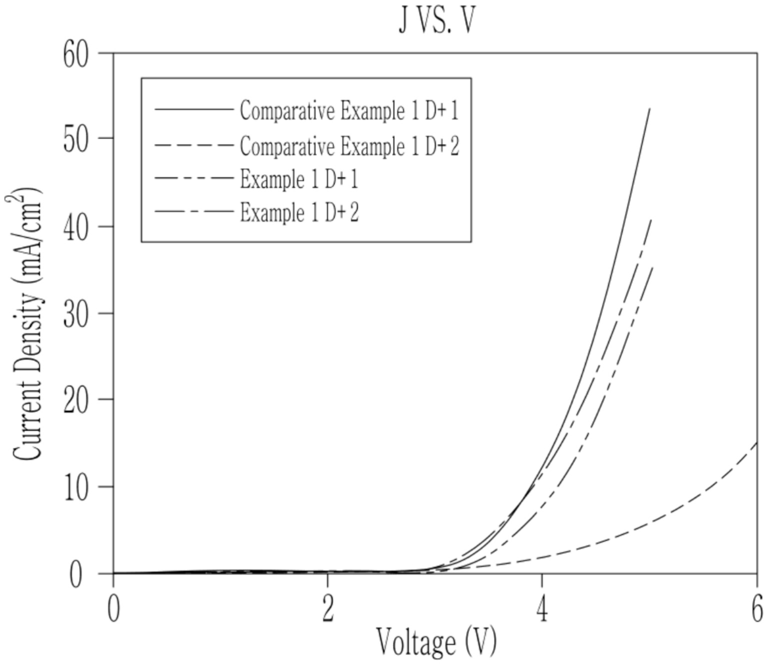
J VS. V
Comparative Example 1 D+1
Comparative Example 1 D+2
Example 1 D+1
Example 1 D+2
Current Density (mA/cm2)
Voltage (V)
0
10
20
30
40
50
60
0
2
4
6

FIG. 14

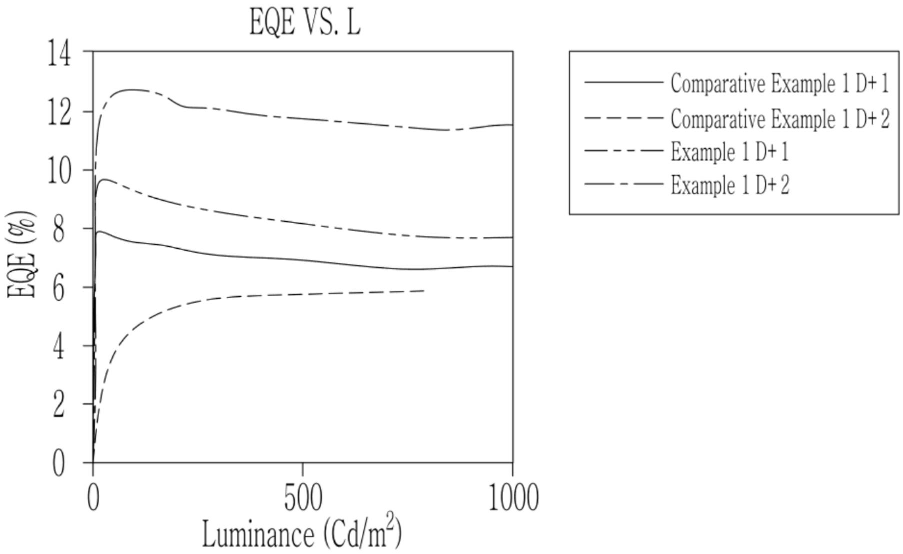
EQE VS. L
14
12
10
8
6
4
2
0
EQE (%)
0
500
1000
Luminance (Cd/m2)
Comparative Example 1 D+1
Comparative Example 1 D+2
Example 1 D+1
Example 1 D+2

FIG. 15

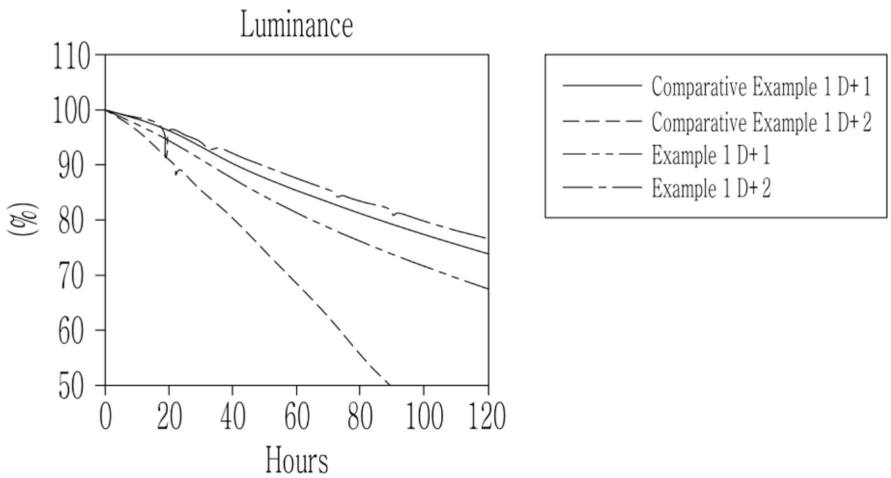
Luminance
110
100
90
80
70
60
50
(%)
0
20
40
60
80
100
120
Hours
Comparative Example 1 D+1
Comparative Example 1 D+2
Example 1 D+1
Example 1 D+2

FIG. 16

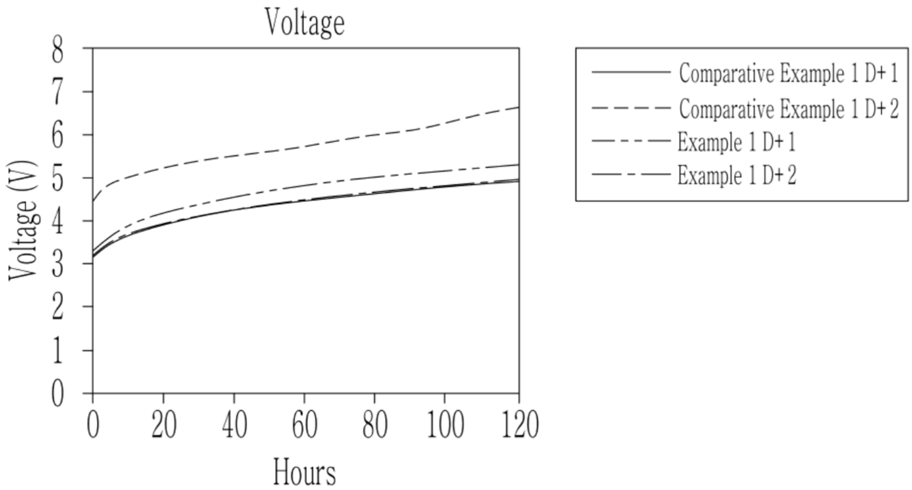
Voltage
8
7
6
5
4
3
2
1
0
Voltage (V)
0
20
40
60
80
100
120
Hours
Comparative Example 1 D+1
Comparative Example 1 D+2
Example 1 D+1
Example 1 D+2